(19) Europäisches Patentamt
European Patent Office
Office européen des brevets

(11) EP 2 340 577 B1

(12) **EUROPÄISCHE PATENTSCHRIFT**

(45) Veröffentlichungstag und Bekanntmachung des Hinweises auf die Patenterteilung:
**26.10.2016 Patentblatt 2016/43**

(21) Anmeldenummer: **09778727.9**

(22) Anmeldetag: **25.09.2009**

(51) Int Cl.:
***H01L 51/54*** *(2006.01)* ***C07F 15/00*** *(2006.01)*
***C09K 11/06*** *(2006.01)*

(86) Internationale Anmeldenummer:
**PCT/EP2009/006940**

(87) Internationale Veröffentlichungsnummer:
**WO 2010/046016 (29.04.2010 Gazette 2010/17)**

(54) **ORGANISCHE ELEKTROLUMINESZENZVORRICHTUNG**
ORGANIC ELECTROLUMINESCENT DEVICE
DISPOSITIF ÉLECTROLUMINESCENT ORGANIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **24.10.2008 DE 102008053121**

(43) Veröffentlichungstag der Anmeldung:
**06.07.2011 Patentblatt 2011/27**

(73) Patentinhaber: **Merck Patent GmbH**
**64293 Darmstadt (DE)**

(72) Erfinder:
- **YERSIN, Hartmut**
  **93161 Sinzing (DE)**
- **MONKOWIUS, Uwe**
  **AT/4020 Linz (AT)**
- **FISCHER, Tobias**
  **93485 Rimbach (DE)**

(56) Entgegenhaltungen:
**EP-A2- 0 277 032** **WO-A-2008/087031**
**US-A1- 2002 042 174** **US-A1- 2008 036 368**

- **BUSS C E ET AL: "Synthesis and Characterization of Pt(CN-p-(C2H5)C6H4)2(CN)2, a Crystalline Vapoluminescent Compound That detects Vapor-Phase Aromatic Hydrocarbons", JOURNAL OF THE AMERICAN CHEMICAL SOCIETY, ACS PUBLICATIONS, US, vol. 124, no. 6, 1 January 2002 (2002-01-01), pages 1031-1039, XP002576029, ISSN: 0002-7863, DOI: 10.1021/JA011986V [retrieved on 2002-01-17]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 340 577 B1

## Beschreibung

Die vorliegende Erfindung betrifft Doppelkomplex-Salze in optoelektronischen Bauelementen und insbesondere aus geladenen Metallkomplexen gebildete Oligomere zur Verwendung in OLEDs.

Zur Zeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So sind z. B. Leuchtflächen als Tapeten mit sehr geringem Energieverbrauch realisierbar. Besonders interessant ist aber, dass Farbbildschirme mit bisher nicht erreichbarer Farbechtheit, Helligkeit und Blickwinkelunabhängigkeit, mit geringem Gewicht sowie sehr niedrigem Stromverbrauch herstellbar sind. Die Bildschirme lassen sich als Mikrodisplays oder Großbildschirme mit mehreren $m^2$ Fläche in starrer Form *oder* flexibel, *aber* auch als Transmissions- oder Reflexions-Displays gestalten. Ferner ist es möglich, *einfache und kostensparende* Herstellungsverfahren wie Siebdruck oder Tintenstrahldruck oder Vakuum-Sublimation einzusetzen. Dadurch wird im Vergleich zu herkömmlichen Flachbildschirmen eine sehr preiswerte Fertigung ermöglicht. Diese neue Technik basiert auf dem Prinzip der **OLEDs,** den Organic Light Emitting Devices.

Derartige Bauteile bestehen vorwiegend aus organischen Schichten, wie in Abb. 1 schematisch und vereinfacht gezeigt ist. Bei einer Spannung von z. B. 5 bis 10 V treten aus einer leitenden Metallschicht, z. B. aus einer Aluminiumkathode, negative Elektronen in eine dünne Elektronenleitungsschicht und wandern in Richtung der positiven Anode. Diese besteht z. B. aus einer durchsichtigen, aber elektrisch leitenden, dünnen Indium-Zinn-Oxid-Schicht (ITO), von der positive Ladungsträger, sog. Löcher, in eine organische Löcher-Leitungsschicht einwandern. Diese Löcher bewegen sich im Vergleich zu den Elektronen in entgegengesetzter Richtung, und zwar auf die negative Kathode zu. In einer mittleren Schicht, der Emitterschicht, die ebenfalls aus einem organischen oder metallorganischen Material besteht, befinden sich zusätzlich besondere Emittermoleküle, an denen oder in deren Nähe die beiden Ladungsträger rekombinieren und dabei zu energetisch angeregten Zuständen der Emittermoleküle führen. Die angeregten Zustände geben dann ihre Energie als Lichtemission ab, z. B. in blauer, grüner oder roter Farbe. Auf die Emitterschicht kann gegebenenfalls auch verzichtet werden, wenn die Emittermoleküle sich in der Loch- oder Elektronenleitungsschicht befinden.

Die OLED-Bauelemente lassen sich großflächig als Beleuchtungskörper oder auch äußerst klein als Pixel für Displays gestalten. Entscheidend für den Bau hoch-effizienter OLEDs sind die verwendeten Leuchtmaterialien (Emittermoleküle). Diese können in verschiedener Weise realisiert werden, und zwar unter Verwendung rein organischer oder metallorganischer Moleküle sowie von Komplexverbindungen. Es lässt sich zeigen, dass die Lichtausbeute der OLEDs mit metallorganischen Substanzen, den so genannten Tripiettemittern, wesentlich größer sein kann als für rein organische Materialien. Aufgrund dieser Eigenschaft kommt der Weiterentwicklung der metallorganischen Materialien ein wesentlicher Stellenwert zu. Die Funktion von OLEDs ist bereits sehr häufig beschrieben worden (C. Adachi, M.A. Baldo, S.R. Forrest, S. Lamansky, M.E. Thompson, R.C. Kwong, Appl. Phys. Lett. 2001, 78, 1622; X. Yang, D.C. Müller, D. Neher, K. Meerholz, Adv. Mater. 2006, 18, 948; J. Shinar (Hrsg.), Organic light-emitting devices - A survey, AIP Press, Springer, New York, 2004; H. Yersin, Top. Curr. Chem. 2004, 241, 1; H. Yersin (Hrsg.), Highly Efficient OLEDs with Phosphorescent Materials, Wiley-VCH, Weinheim 2008; Z. H. Kafafi, Organic Electroluminescence, Taylor & Francis, Boca Raton, 2005). Unter Einsatz von metall-organischen Komplexen (häufig werden "übergangsmetallorganische" Komplexe in Kurzform als "metallorganische" Komplexe bezeichnet) mit hoher Emissionsquantenausbeute (aus den untersten Triplettzuständen zu den Singulettgrundzuständen) lässt sich eine besonders hohe Effizienz des Devices erzielen. Diese Materialien werden häufig als Triplettemitter oder phosphoreszierende Emitter bezeichnet. Diese Erkenntnis ist seit längerem bekannt (C. Adachi, M.A. Baldo, S.R. Forrest, S. Lamansky, M.E. Thompson, R.C. Kwong, Appl. Phys. Lett. 2001, 78, 1622; X. Yang, D.C. Müller, D. Neher, K. Meerholz, Adv. Mater. 2006, 18, 948; J. Shinar (Hrsg.), Organic light-emitting devices - A survey, AIP Press, Springer, New York, 2004; H. Yersin, Top. Curr. Chem. 2004, 241, 1; H. Yersin (Hrsg.), Highly Efficient OLEDs with Phosphorescent Materials, Wiley-VCH, Weinheim 2008). Für TriplettEmitter wurden bereits viele Schutzrechte beantragt bzw. erteilt, siehe z. B.: M. E. Thompson, P. I. Djurovich, J. Li (University of Southern California, Los Angeles, CA), WO 2004/017043 A2, 2004; M. E. Thompson, P. I. Djurovich, R. Kwong (University of Southern California, Los Angeles, CA, Universal Display Corp, Ewing, NY), WO 2004/016711 A1, 2004; A. Tsuboyama, S. Okada, T. Takiguchi, K. Ueno, S. Igawa, J. Kamatani, M. Furugori, H. Iwawaki (Canon KK, Tokyo), WO 03/095587 A1, 2003; C.-M. Che, US 2003/0205707 A1, 2003; C.-M. Che, W. Lu, M. C.-W. Chan, US 2002/0179885 A1, 2002; J. Kamatani, S. Okada, A. Tsuboyama, T. Takiguchi, S. Igawa, US 2003/186080 A1, 2003; P. Stößel, I. Bach, A. Büsing (Covion Organic Semiconductors GmbH), DE 10350606 A1, 2005; M. Bold, C. Lennartz, M. Egen, H.-W. Schmidt, M. Thelakkat, M. Bäte, C. Neuber, W. Kowalsky, C. Schildknecht (BASF AG), DE 10338550 A1, 2005; C. Lennartz, A. Vogler, V. Pawlowski (BASF AG), DE 10358665 A1, 2005; B. Hsieh, T. P. S. Thoms, J. P. Chen (Canon KK, Tokyo), US 2006/989273 B2, 2006; N. Schulte, S. Heun, I. Bach, P. Stoessel, K. Treacher (Covion Organic Semiconductors), WO 2006/003000 A1, 2006; A. Vogler, V. Pawlowski, H.-W. Schmidt, M. Thelakkat (BASF AG), WO 2006/032449 A1, 2006; T. K. Hatwar, J. P. Spindler, R. H. Young (Eastman Kodak Co), WO 2006/028546 A1, 2006.

Außerdem werden in US 2002 0042174 A1 elektronische Vorrichtungen des Typs molekularer lichtemittierender Dioden offenbart, die auf dünnen Schichten bestimmter Platinkomplexe basieren.

Bei den bisher bekannten Triplettemittern gibt es jedoch noch Verbesserungsbedarf, und zwar insbesondere im Bereich der Langzeitstabilität der Emitter in OLED-Devices hinsichtlich der thermischen Stabilität, hinsichtlich der chemischen Stabilität gegenüber Wasser und Sauerstoff, hinsichtlich der chemischen Variabilität, hinsichtlich der Verfügbarkeit wichtiger Emissionsfarben in geeigneter Farbreinheit, hinsichtlich fertigungstechnischer Reproduzierbarkeit, hinsichtlich geeigneter Energien der für den Loch- bzw. Elektroneneinfang wichtigen HOMOs bzw. LUMOs, hinsichtlich der Erreichbarkeit einer hohen Effizienz bei hohen Stromdichten oder/und hinsichtlich der Erreichbarkeit sehr hoher Leuchtdichten. Die Erfindung zum Einsatz in OLEDs betrifft deshalb ein Oligomer umfassend wenigstens einen positiv geladene Metallkomplexe und wenigstens einen negativ geladene Metallkomplexe, wobei die Metallkomplexe die

Formel (I):

$$K_1 = [L1L2L3L4M1]^{n+}$$

und die

Formel (II):

$$K_2 = [L5L6L7L8M2]^{n-}$$

aufweisen, wobei M1 und M2 Metallzentrum darstellen, und wobei es sich bei dem Oligomer um ein Doppelkomplex-Salz handelt, wobei SSS

$K_1$= $[L1L2L3L4Pt(II)]^+$ und $K_2$ = $[L5L6L7L8Pt(II)]^-$; oder
$K_1$= $[L1L2L3L4Pd(II)]^+$ und $K_2$ = $[L5L6L7L8Pd(II)]^-$; oder
$K_1$= $[L1L2L3L4Pt(II)]^{2+}$ und $K_2$ = $[L5L6L7L8Pt(II)]^{2-}$; oder
$K_1$= $[L1L2L3L4Pd(II)]^{2+}$ und $K_2$ = $[L5L6L7L8Pd(II)]^{2-}$;

wobei

$K_1$= $[L1L2L3L4Pt(II)]^+$ eine der folgenden Formeln aufweist:

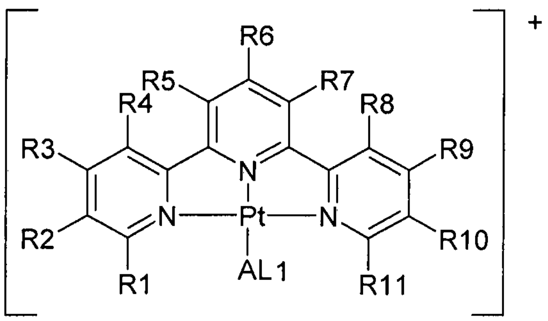

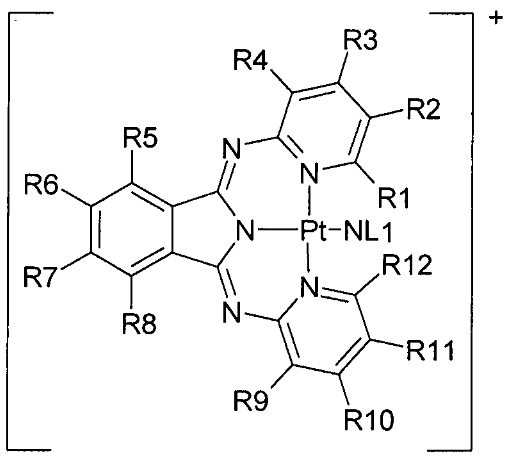

7 8

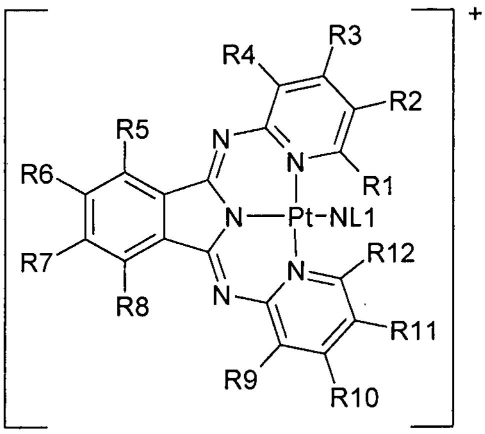

**9**

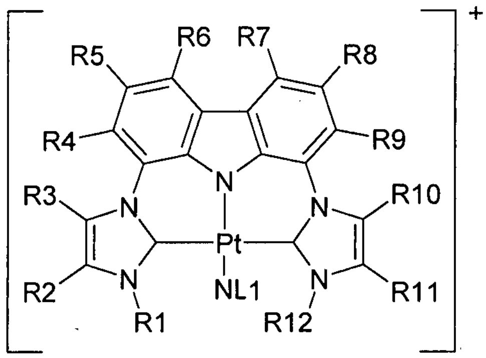

**10**

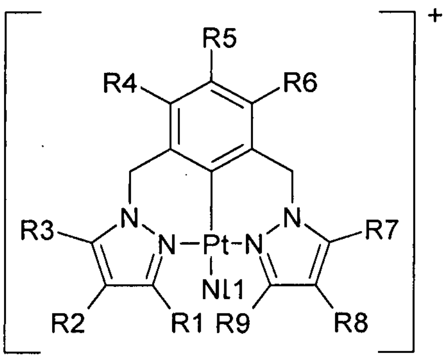

**11**

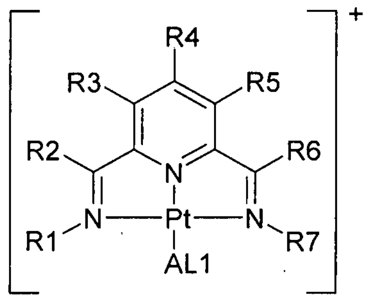

**12**

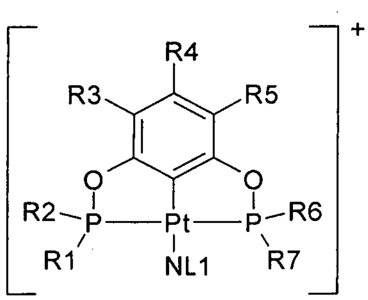

**18**

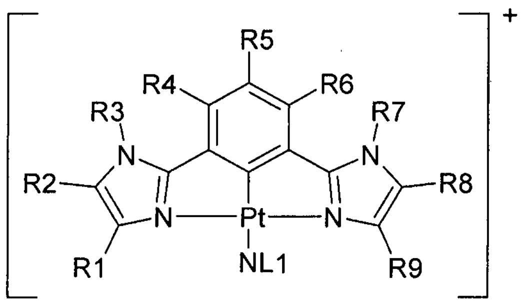

**22**

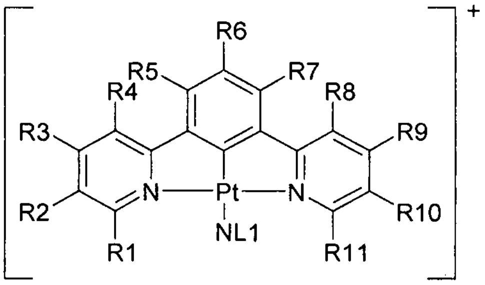

23

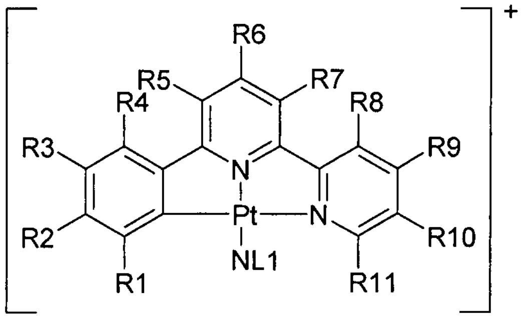

24

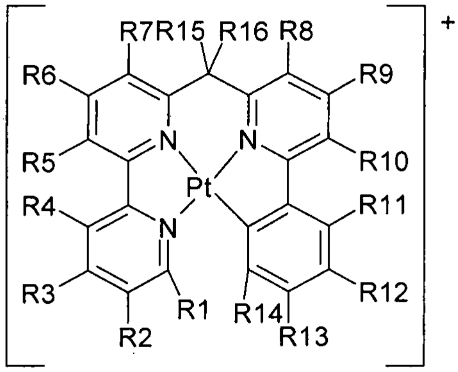

26

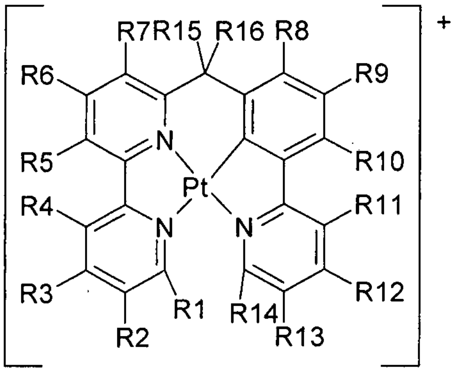

27

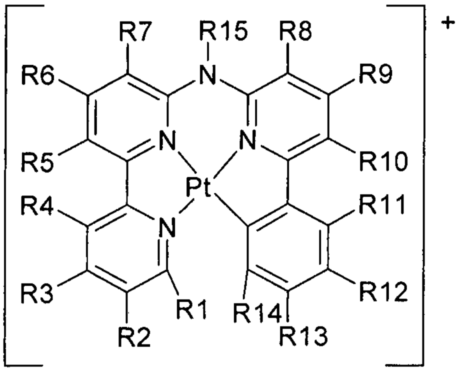

28

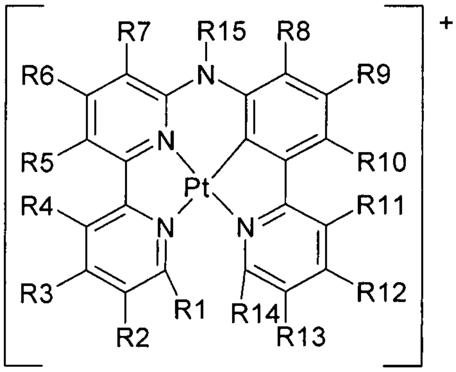

29

$K_1$= $[L1L2L3L4Pd(II)]^+$ eine der folgenden Formeln aufweist:

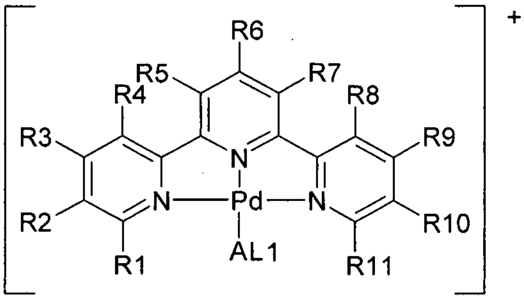

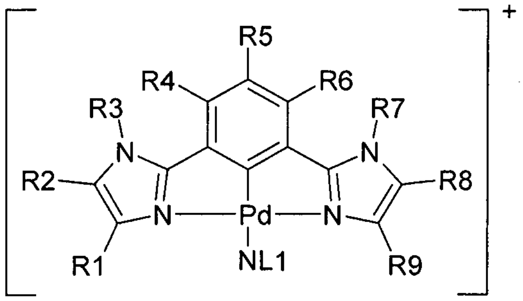

**50** **51**

$K_1$= [L1L2L3L4Pt(II)]$^{2+}$ eine der folgenden Formeln aufweist:

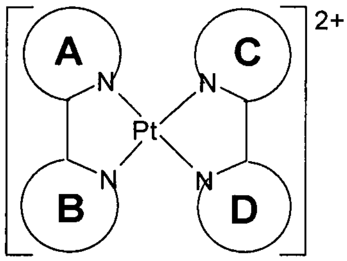

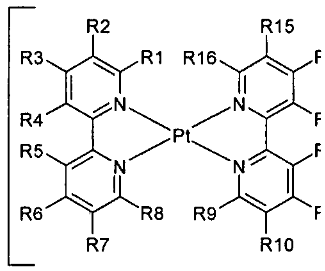

**83** **85**

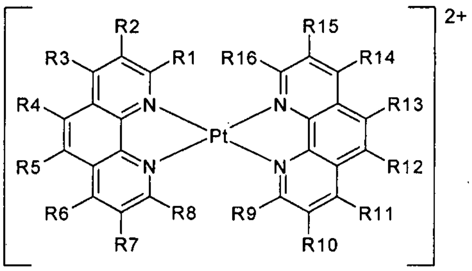

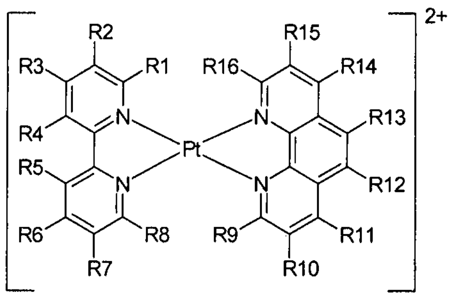

**86** **87**

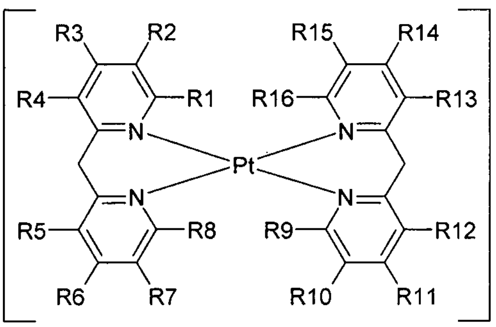
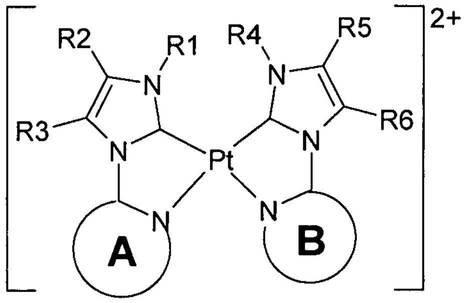

**90** **92**

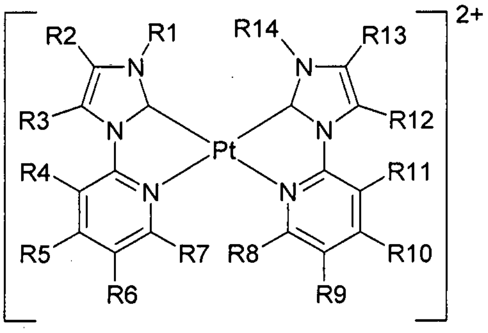
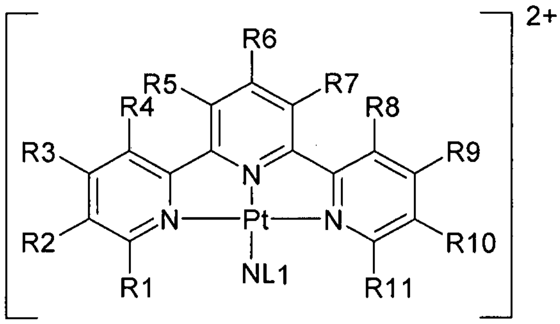

**94** **96**

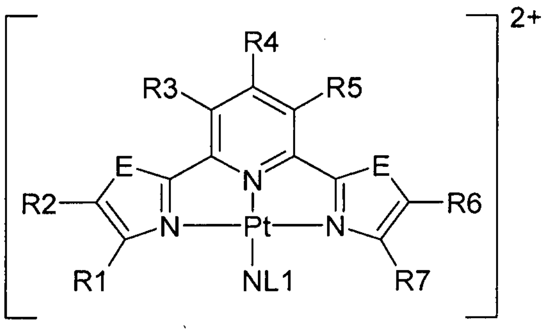

**97** (E = O. S. NR. wobei R wie R1 bis R20 definiert ist)

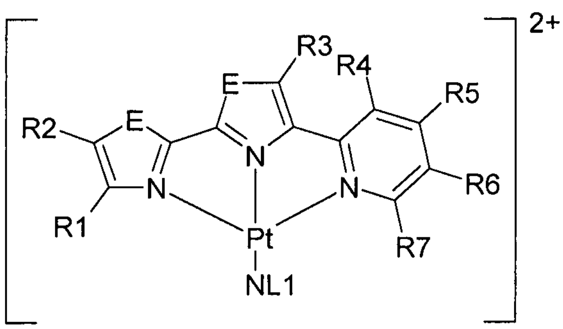

**98** (E = O, S, NR, wobei R wie R1 bis R20 definiert ist)

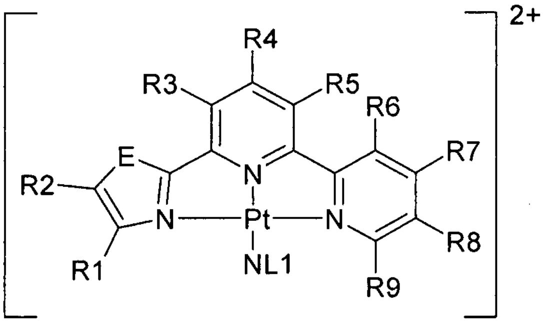

**99** (E = O, S, NR, wobei R wie R1 bis R20 definiert ist)

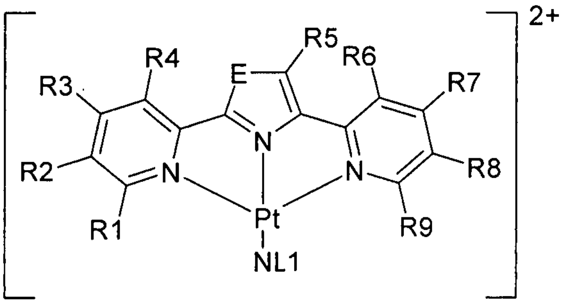

**100** (E = O, S, NR, wobei R wie R1 bis R20 definiert ist)

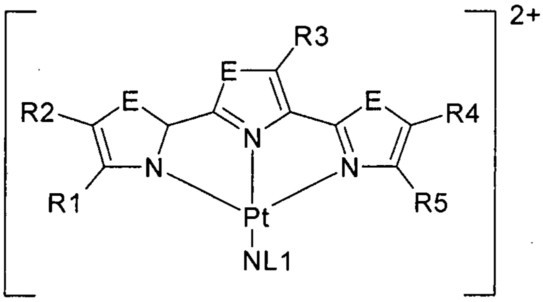

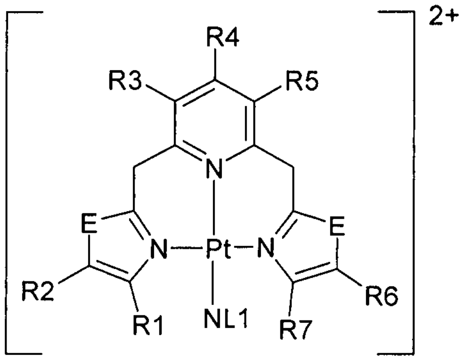

**101** **102**

(E = O, S, NR, wobei R wie R1 bis R20 definiert ist)

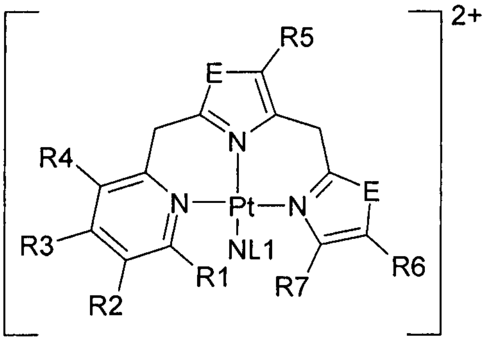

**103** (E = O, S, NR, wobei R wie R1 bis R20 definiert ist)

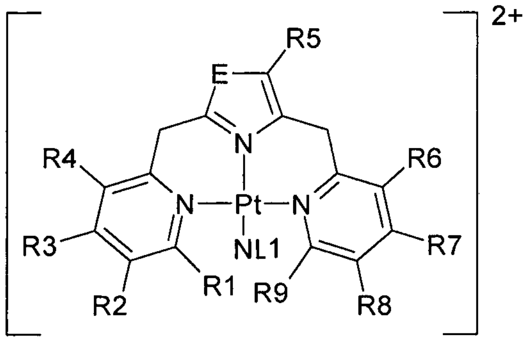

**104** (E = O, S, NR, wobei R wie R1 bis R20 definiert ist)

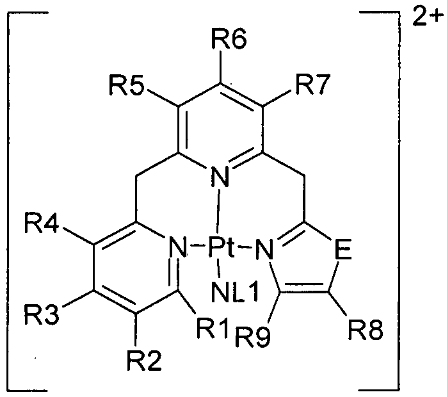

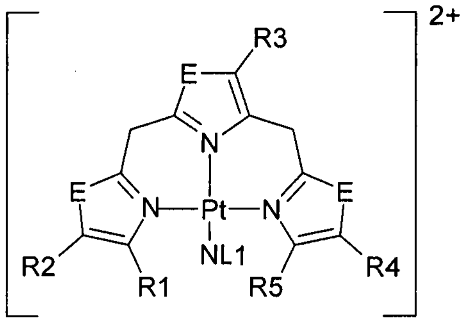

**105** **106**

(E = O, S, NR, wobei R wie R1 bis R20 definiert ist)

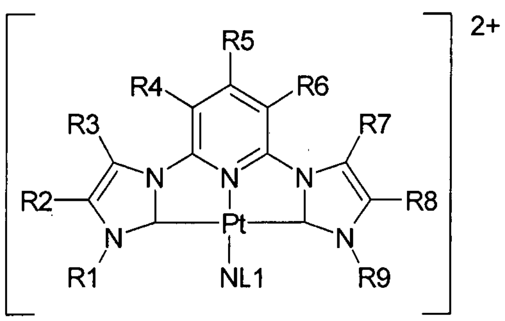

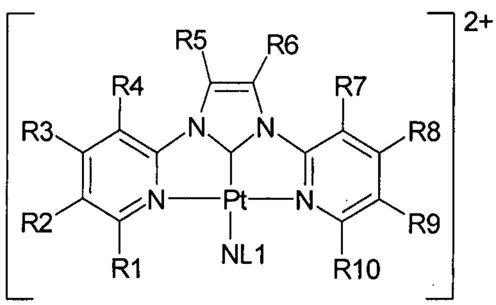

**107** **108**

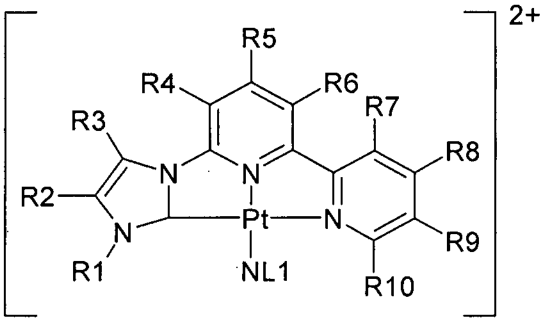

**109**

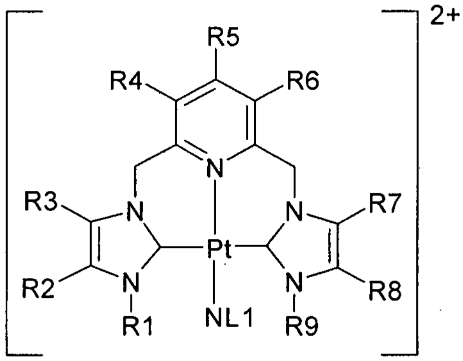

**110**

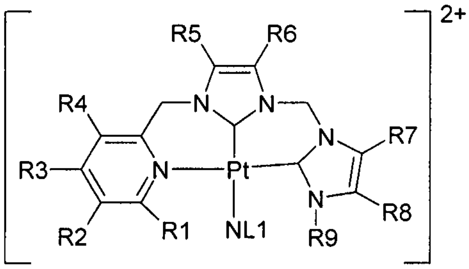

**111**

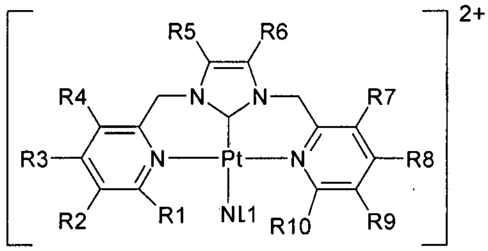

**112**

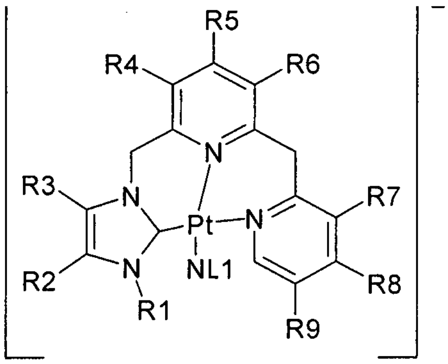

**113**

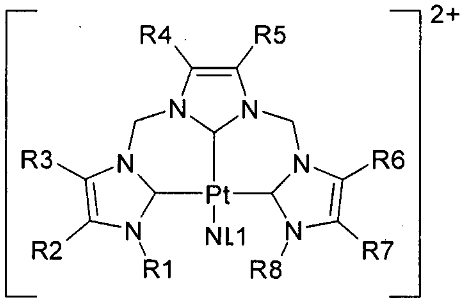

**114**

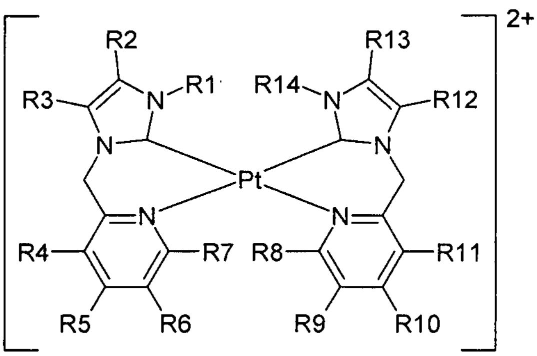

**122**

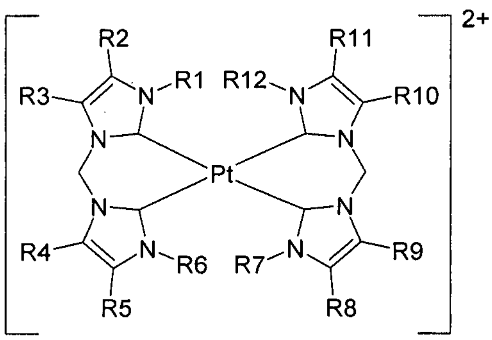

**124**

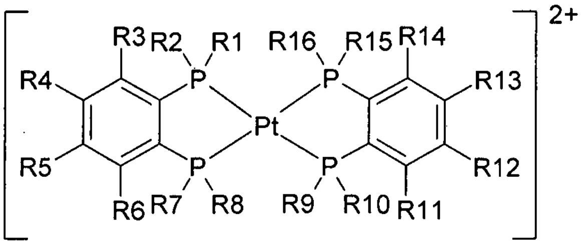
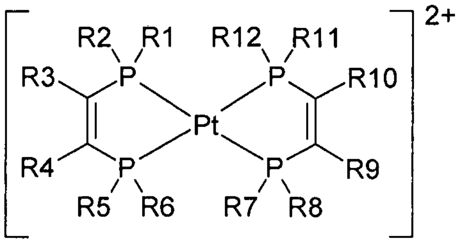

**126** **128**

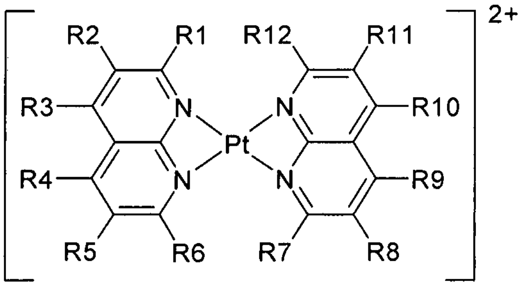
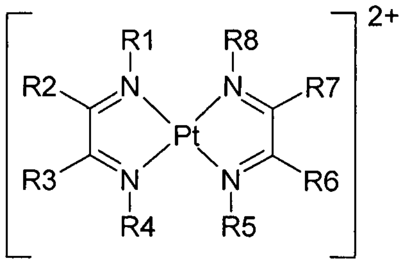

**130** **132**

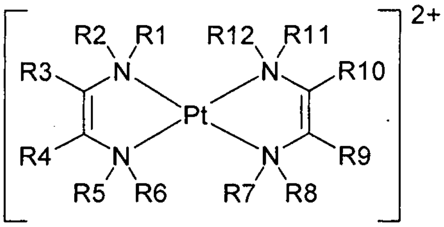
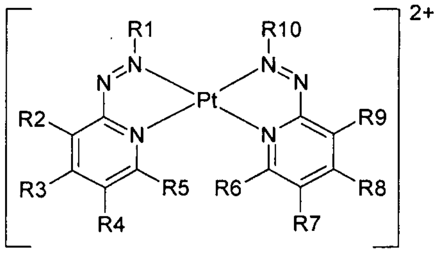

**134** **136**

und $K_1$= $[L1L2L3L4Pd(II)]^{2+}$ die gleiche Formeln wie die oben aufgeführten Formeln für $K_1$ = $[L1L2L3L4Pt(II)]^{2+}$ aufweist, jedoch muss Pt(II) durch Pd(II) ersetzt werden;

und

$K_2$ = $[L5L6L7L8Pt(II)]^-$ ausgewählt ist aus:

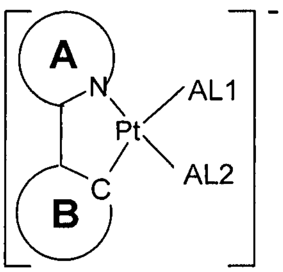
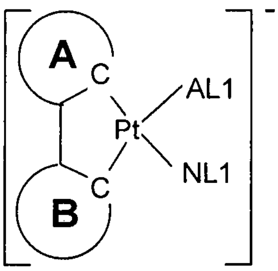

**30** **31**

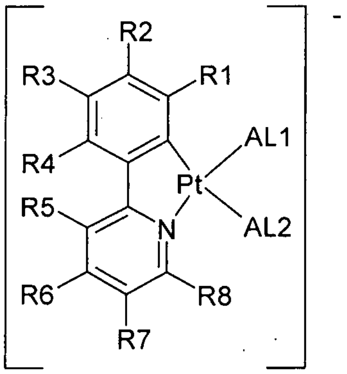

32

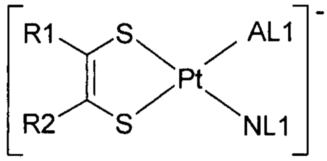

33

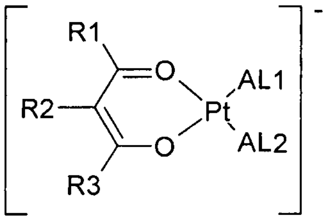

34

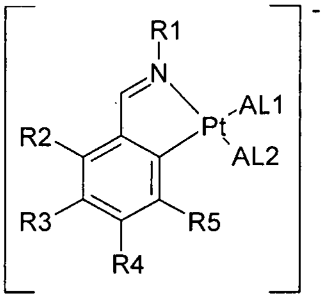

35

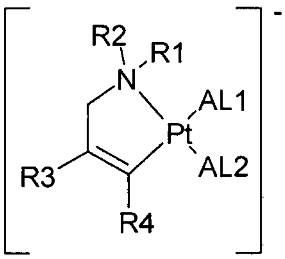

36

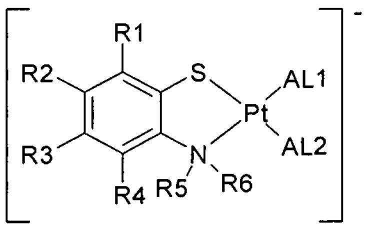

37

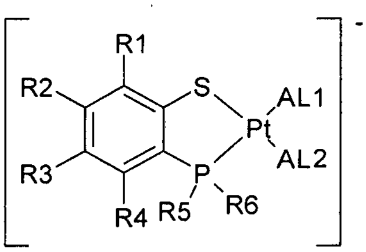

38

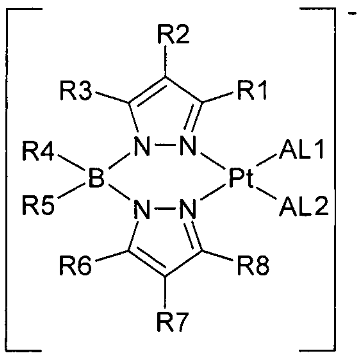

39

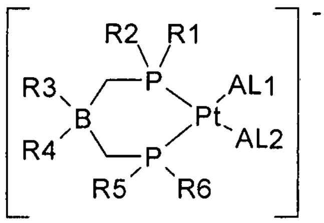

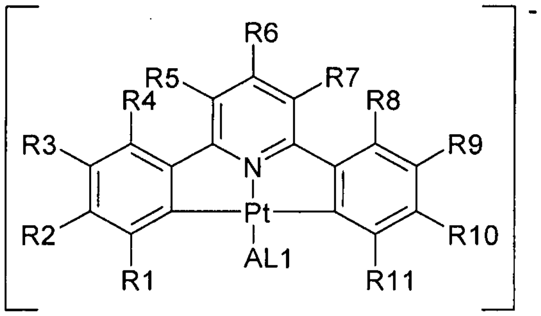

**40** **41**

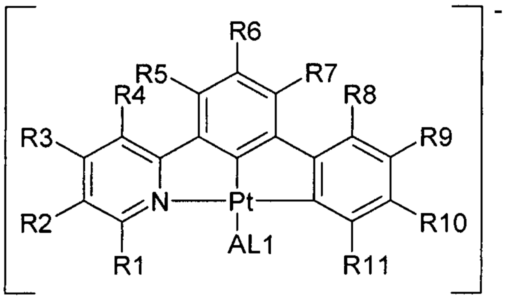

**42**

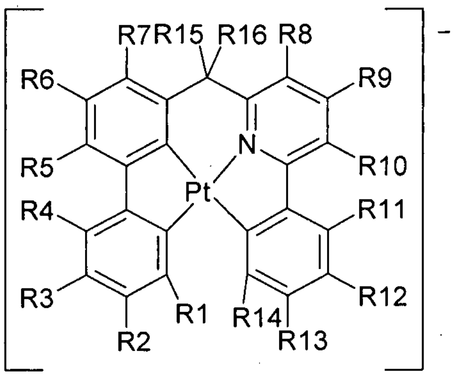

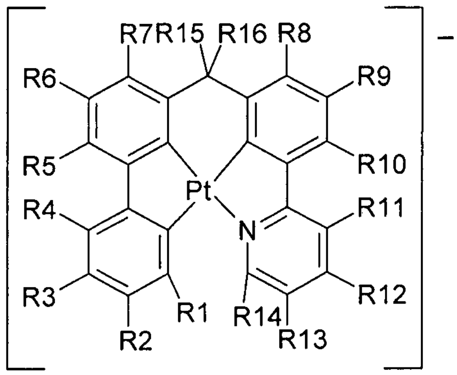

**43** **44**

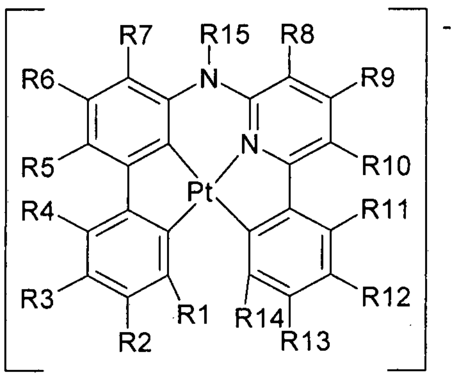

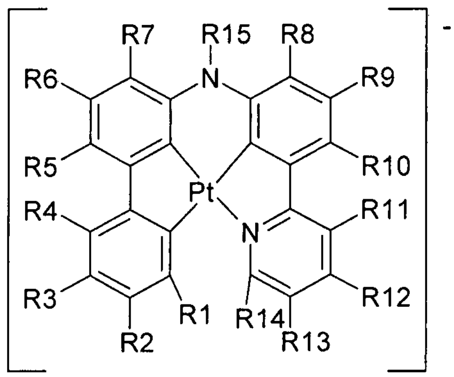

**45** **46**

$K_2$ = [L5L6L7L8Pd(II)]$^-$ ausgewählt ist aus:

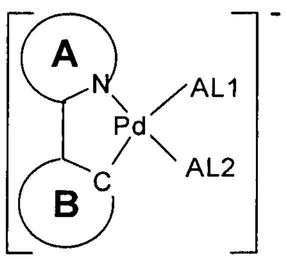

**52**

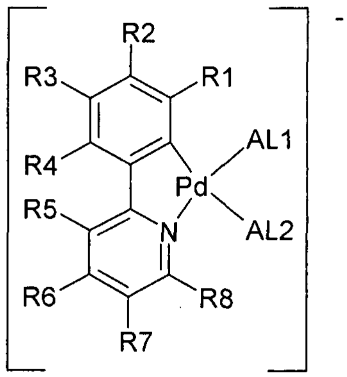

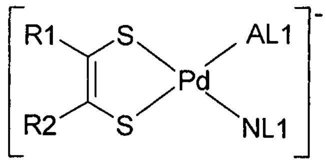

**53** **54**

$K_2$ =[L5L6L7L8Pt(II)]$^{2-}$ ausgewählt ist aus:

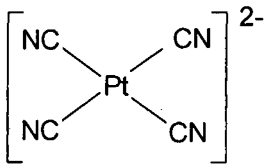

**138**

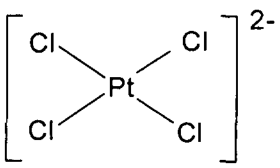

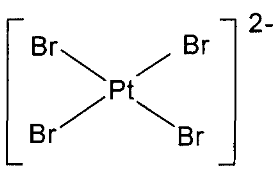

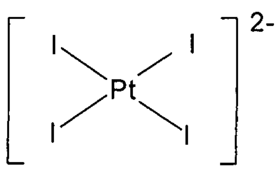

**139** **140** **141**

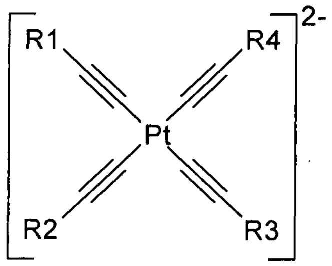
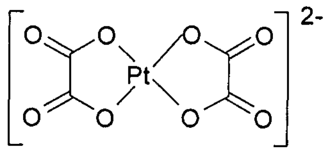

**142** **143**

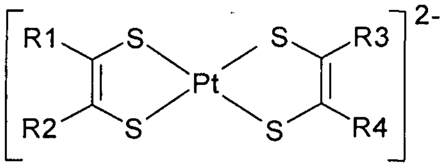
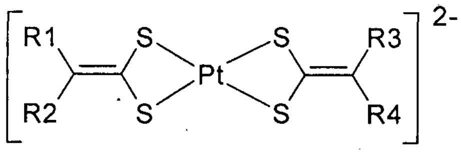

**144** **145**

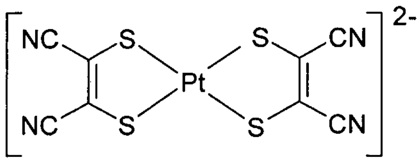
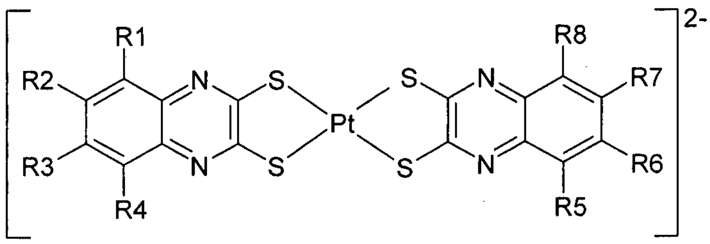

**146** **147**

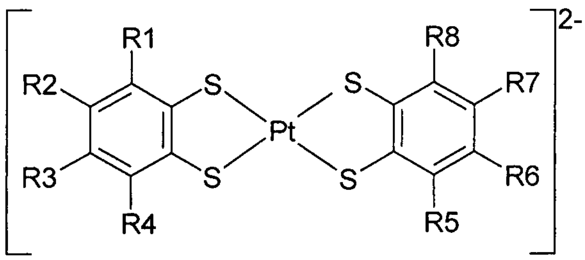

**148**

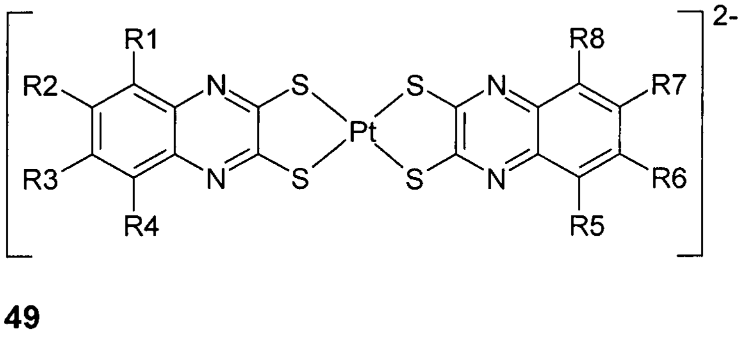

**149**

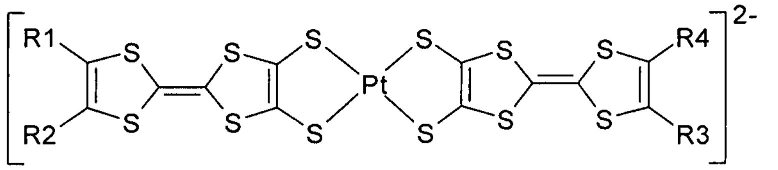

**150**

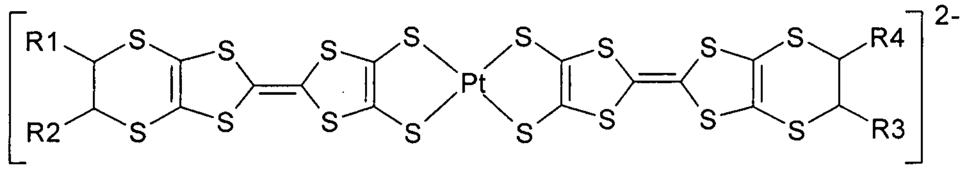

**151**

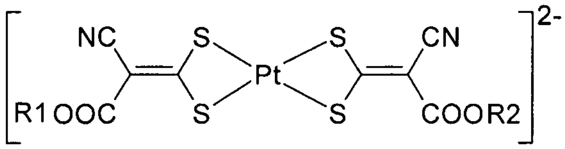

**152**

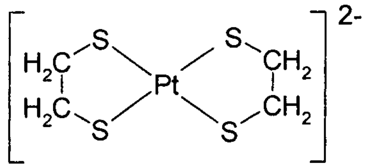

**153**

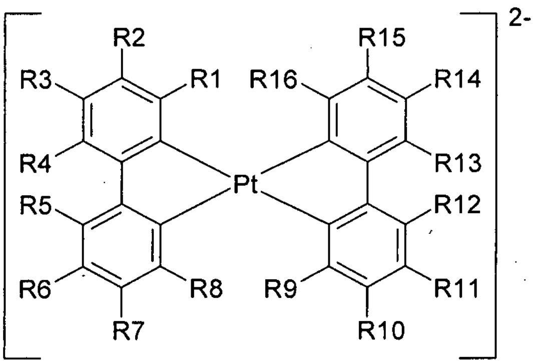

**154**

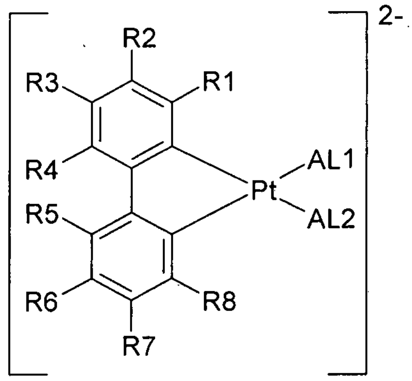

**155**

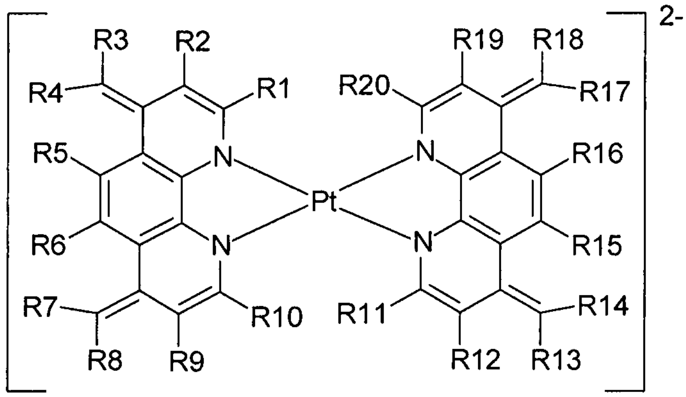

**156**

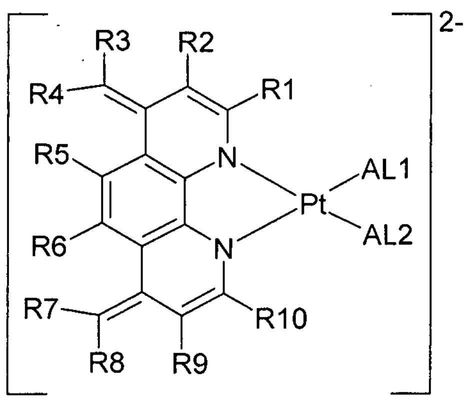

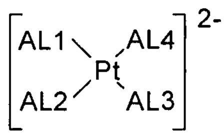

**157** **158**

und $K_2$ = $[L5L6L7L8Pd(II)]^{2-}$ ist aus der gleichen Formeln wie die oben aufgeführten Formeln für $K_1$ = $[L1L2L3L4Pt(II)]^{2+}$ ausgewählt, jedoch muss Pt(II) durch Pd(II) ersetzt werden;
wobei gilt:

R1 bis R20 ist gleich oder verschieden bei jedem Auftreten eine der folgenden Gruppen: H, Deuterium, F, Cl, Br, I, $N(R^{21})_2$, CN, $NO_2$, $Si(R^{21})_3$, $B(OR^{21})_2$, $C(=O)R^{21}$, $P(=O)(R^{21})_2$, $S(=O)R^{21}$, $S(=O)_2R^{21}$, $OSO_2R^{21}$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^{21}$ substituiert sein kann, wobei eine oder mehrere nicht benachbarte $CH_2$-Gruppen durch $R^{21}C=CR^{21}$, C≡C, $Si(R^{21})_2$, $Ge(R^{21})_2$, $Sn(R^{21})_2$, C=O, C=S, C=Se, $C=NR^{21}$, $P(=O)(R^{21})$, SO, $SO_2$, $NR^{21}$, O, S oder $CONR^{21}$ ersetzt sein können und wobei ein oder mehrere H-Atome durch F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^{21}$ substituiert sein kann, oder eine Aryloxy- oder Heteroaryloxygruppe mit 5 bis 60 aromatischen Ringatomen, die durch einen oder mehrere Reste $R^{21}$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^{21}$ substituiert sein kann, oder eine Kombination dieser Systeme; dabei können zwei oder mehrere dieser Substituenten auch miteinander ein mono- oder polycyclisches, aliphatisches, aromatisches und/oder benzoannelliertes Ringsystem bilden;

$R^{21}$ ist bei jedem Auftreten gleich oder verschieden H, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten $R^{21}$ auch miteinander ein mono- oder polycyclisches,

aliphatisches oder aromatisches Ringsystem bilden;

NL1 ist ein neutraler Ligand, insbesondere ausgewählt aus Kohlenmonoxid, Isonitrilen, Aminen, Phosphinen, Phosphiten, Arsinen, Stibinen und stickstoffhaltigen Heterocyclen;

AL1, AL2, AL3, AL4 ist jeweils gleich oder verschieden bei jedem Auftreten ein anionischer Ligand, insbesondere ausgewählt aus Hydrid, Deuterid, den Halogeniden F, Cl, Br und I, Alkylacetyliden, Arylacetyliden, Arylgruppe, Alkylgruppen, Alkenygruppen, Boraten, Cyanid, Cyanat, Isocyanat, Thiocyanat, Isothiocyanat, aliphatischen oder aromatischen Alkoholaten, aliphatischen oder aromatischen Thioalkoholaten, Amiden, Carboxylaten und anionischen, stickstoffhaltigen Heterocyclen,

Dabei ist es auch möglich, dass das Oligomer mehr als einen positiv geladenen Komplex, z. B. mindestens zwei unterschiedliche positiv geladene Komplexe, und mehr als einen negativ geladenen Komplex, z. B. mindestens zwei unterschiedliche negativ geladene Komplexe, enthält.

Die oben genannten Oligomere werden in elektronischen Vorrichtungen eingesetzt. Dabei wird unter einer elektronischen Vorrichtung eine Vorrichtung verstanden, welche mindestens eine Schicht enthält, die mindestens eine organische oder metallorganische Verbindung bzw. mindestens eine Koordinationsverbindung mit organischen Liganden enthält. Das Bauteil kann dabei aber auch anorganische Materialien enthalten oder auch Schichten, welche vollständig aus anorganischen Materialien aufgebaut sind.

Die elektronische Vorrichtung ist bevorzugt ausgewählt aus der Gruppe bestehend aus organischen Elektrolumineszenzvorrichtungen (OLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs), organischen Laserdioden (O-Laser) und "organic plasmon emitting devices" (D. M. Koller et al., Nature Photonics 2008, 1-4), bevorzugt aber organischen Elektrolumineszenzvorrichtungen (OLEDs), besonders bevorzugt phosphoreszierenden OLEDs.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten und/oder Ladungserzeugungsschichten (Charge-Generation Layers). Ebenso können zwischen zwei emittierende Schichten Interlayer eingebracht sein, welche beispielsweise eine exzitonenblockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 05/011013).

Das gemeinsame Strukturmerkmal sämtlicher in den Doppelkomplexsalzen verwendeten Komplexe besteht darin, dass die Zentralionen M quadratisch-planar oder näherungsweise quadratisch-planar vierfach koordiniert sind, wobei die Koordinationen symmetrisch oder unsymmetrisch sein können, wobei unsymmetrische Anordnungen bevorzugt sind.

Diese Erfindung betrifft die Verwendung einer Substanzklasse, bei der eine intensive Emission (hohe Emissionsquantenausbeute) erst durch eine ausgeprägte Metall-Metall-Wechselwirkung zwischen quadratischplanaren, entgegengesetzt geladenen Metall-Komplexen entstehen kann. Die Übergänge, die zur Emission führen, basieren somit bei dieser Verbindungsklasse auf Metall-Metall-Wechselwirkungen der einzelnen Komplexe im Oligomer. Dies stellt einen großen Unterschied zu bisherigen Systemen dar, bei denen die Lichtemission auf der Basis isolierter, neutraler Moleküle beruht.

Quadratisch-planar oder näherungsweise quadratisch-planar koordinierte, entgegengesetzt geladene Pt(II)-Komplexe sowie strukturell verwandte Komplexe der zweiten und dritten Periode der Übergangsmetalle mit einer $d^8$-Elektronenkonfiguration (Pd(II), Ir(I), Rh(I) und eingeschränkt Au(III)) zeigen eine Neigung zur Ausbildung von Metall-Metall-Wechselwirkungen und bilden Trimere, Tetramere, etc. oder allgemein Oligomere bzw. Kolumnarstrukturen aus (die Begriffe Kolumnarstrukturen, Stapelanordnung, Oligomere und Aggregate werden hier synonym verwendet). Derartige Verbindungen zeigen als Festkörper intensive Emissionen, die möglicherweise aus Zuständen resultieren, die erst aus den Metall-Metall-Wechselwirkungen hervorgehen.

Die Erfindung basiert auf dem Einsatz unterschiedlich geladener Metallkomplexe, d. h. Doppelkomplexsalzen, die Trimere, Tetramere, etc. oder allgemein Oligomere bilden, in optoelektronischen Bauelementen, die nach außen hermetisch abgeschirmt sind. Die Durchlässigkeit der Einhausung beträgt bevorzugt für Wasser-Dampf $< 10^{-6}\ g{*}m^{-2}{*}d^{-1}$

und bevorzugt für Sauerstoff < $10^{-6}$ $cm^3{*}m^{-2}{*}d^{-1}{*}bar^{-1}$, so dass kein Gasaustausch mit der Umgebung erfolgt.

Der Begriff Oligomer umfasst im Allgemeinen Einheiten mit mindestens 3, bevorzugt mindestens 4, noch mehr bevorzugt mindestens 5, insbesondere mindestens 10 und insbesondere bis zu 100, bevorzugt bis zu 50 Metallkomplexe. Im Sinne der vorliegenden Erfindung werden alle Verbindungen, die mindestens eine Metallkomplex der Formel (I) und mindestens einen Metallkomplex der Formel (II) enthalten, als Oligomere angesehen.

Die weitere erfindungsgemäß einzusetzenden Oligomere werden aus Metallkomplexen der

Formel (I):

$$K_1 = [L1L2L3L4M1]^{n+}$$

der Formel (II):

$$K_2 = [L5L6L7L8M2]^{n-}$$

(n = 1, 2)

gebildet. Die Metallzentren M1 und M2 der Metall-Komplexe werden unabhängig ausgewählt aus Ir(I), Rh(I), Pt(II), Pd(II) oder Au(III), bevorzugt aus Pt(II) und Pd(II)., wobei M1 ≠ M2 ist.

Auch beliebige Kombinationen sind möglich, wobei die Ladungen der einzelnen Komplex-Bausteine sich insgesamt zu Null addieren müssen.

L1, L2, L3 und L4 sowie L5, L6, L7 und L8 stehen jeweils unabhängig für einen neutralen oder geladenen Liganden, insbesondere für einen einzähnigen oder mehrzähnigen Liganden. In den folgenden Ausführungen bezeichnet NL neutrale einzähnige Liganden und AL anionische einzähnige Liganden (für eine ausführlichere Definition der Liganden siehe unten). Zur Erläuterung sei angemerkt, saß die Liganden L1, L2, L3 und L4 in der allgemein angegebenen Formel $[L1L2L3L4M1]^{n+}$ nicht zwingend identisch sind mit den ebenfalls mit L1 bis L4 bezeichneten Liganden einer anderen allgemein angegebenen Formel $[L1L2L3L4M1]^{n+}$. Da erfindungsgemäß die zur Emission führenden Zustände im Wesentlichen aus M-M-Wechselwirkungen resultieren, müssen die Liganden selbst keine chromophoren π-Systeme aufweisen.

Bevorzugte Strukturen der erfindungsgemäß einzusetzenden Oligomere werden im Folgenden näher erläutert.

Kolumnarstrukturen, die aus einfach positiv und einfach negativ geladenen quadratisch-planaren Komplexen aufgebaut sind:

$-K_1-K_2-K_1-K_2-K_1-K_2-K_1-$

$K_1$: quadratisch-planarer, einfach positiv geladener Komplex
$K_2$: quadratisch-planarer, einfach negativ geladener Komplex

$$K_1 = [L1L2L3L4M1(I)]^+$$
$$[L1'L2'L3'L4'M1(II)]^+$$

(Die Liganden der zweiten Formel sind mit einem Strich markiert und können/müssen andere Liganden sein als die Liganden ohne Strich, um den Ladungsausgleich zu erreichen.)

$$K_2 = [L5L6L7L8M2(I)]^-$$
$$[L5'L6'L7'L8'M2(II)]^-$$

mit

$$M1(I) / M2(I) = Ir(I), Rh(I)$$

$$M1(II) / M2(II) = Pt(II), Pd(II)$$

Die Strukturen der Komplexe und der Liganden L1, L2, L3, L4, L5, L6, L7 und L8 sowie L1', L2', L3', L4', L5', L6', L7' und L8' werden im Folgenden anhand von allgemeinen Formeln und anhand von Beispielen erläutert.

Beispiele zu Doppelkomplex-Salzen mit

$$K_1 = [L1L2L3L4Pt(II)]^+$$

$$K_2 = [L5L6L7L8Pt(II)]^-$$

Beispiele für die Komponente

$$K_1 = [L1L2L3L4Pt(II)]^+:$$

Allgemeine Formel für α-Diimin-Komplexe

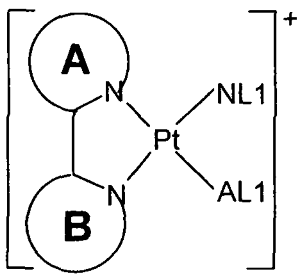

1

Allgemeine Formel für cyclometallierte Carben-Pt-Komplexe

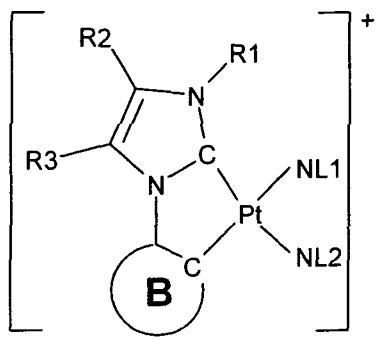

2

Allgemeine Formel für cyclometallierte Imin-Komplexe

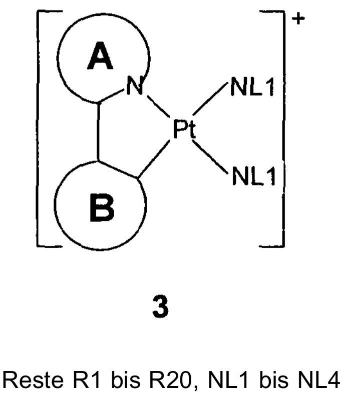

3

wobei die Diimin- und Carbenliganden, die Reste R1 bis R20, NL1 bis NL4 sowie AL1 bis AL4 im Kapitel: "Definition der Liganden und Reste" definiert sind.

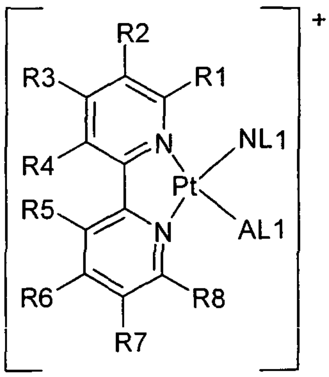
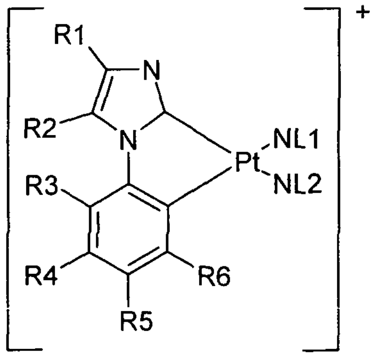
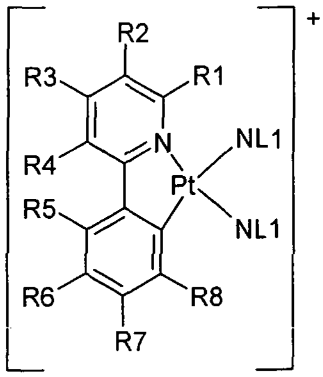

**4** **5** **6**

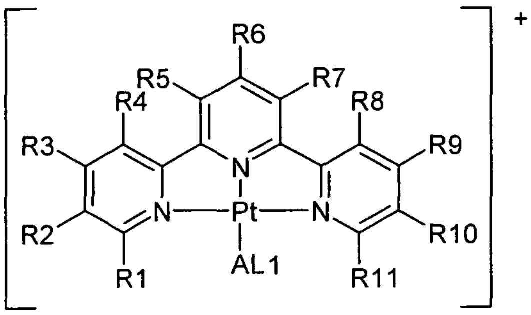
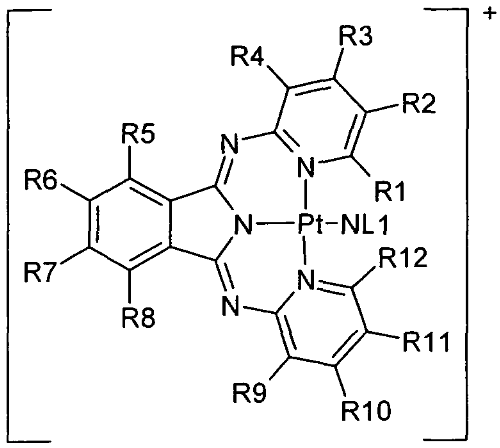

**7** **8**

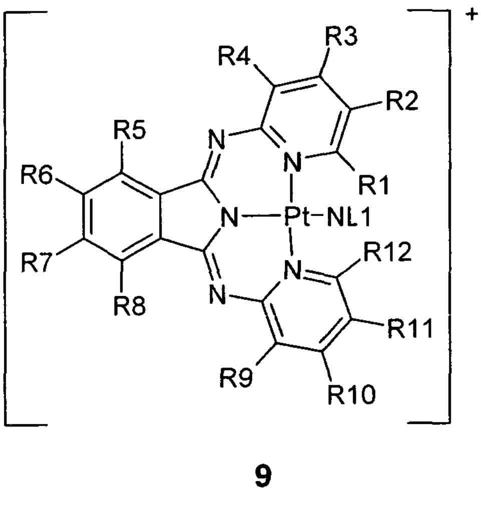
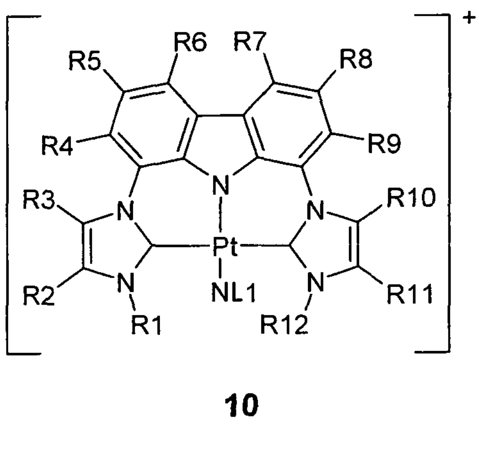

**9** **10**

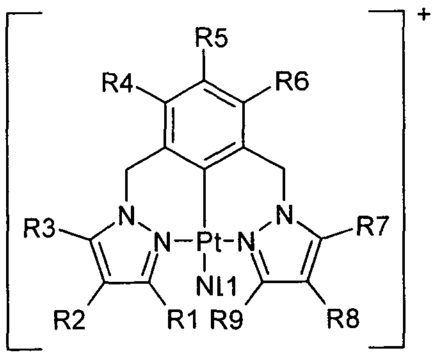

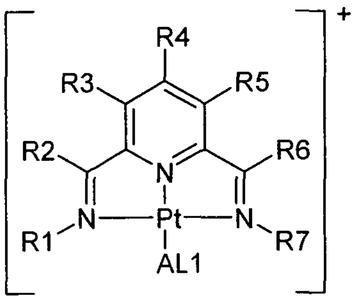

**11** **12**

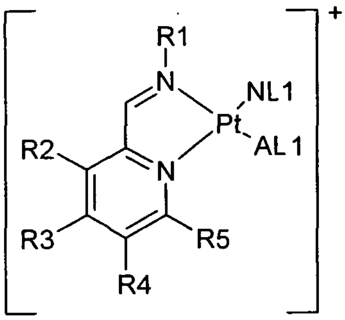

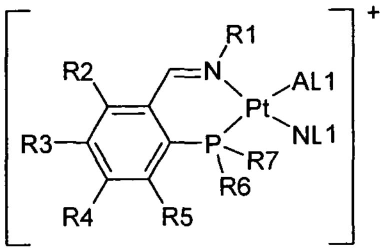

**13** **14**

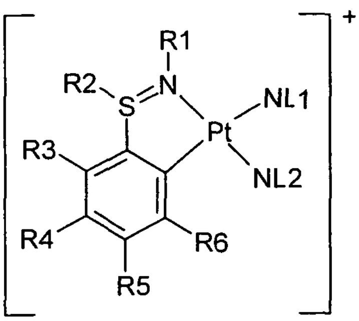

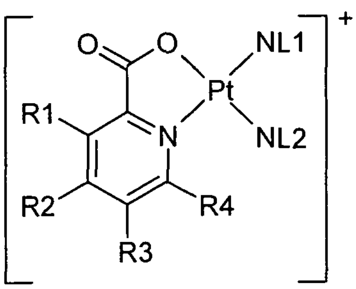

**15** **16**

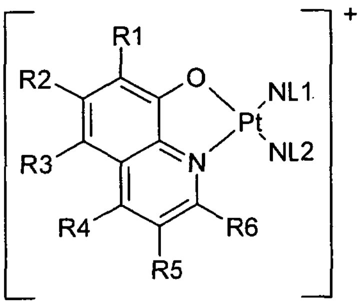

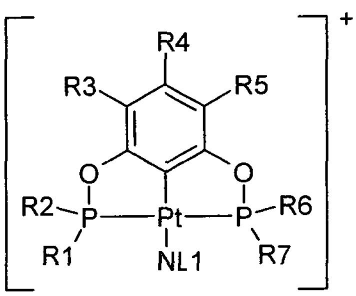

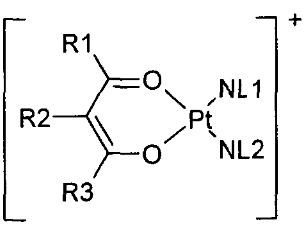

**17** **18** **19**

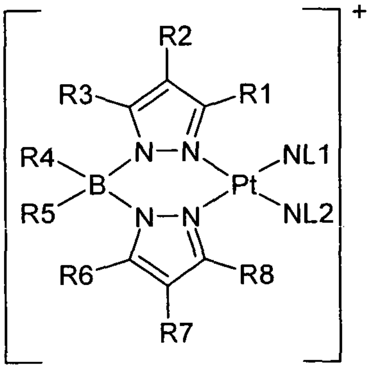

20

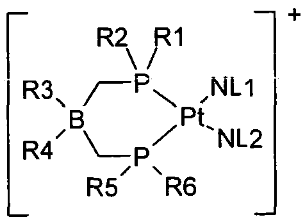

21

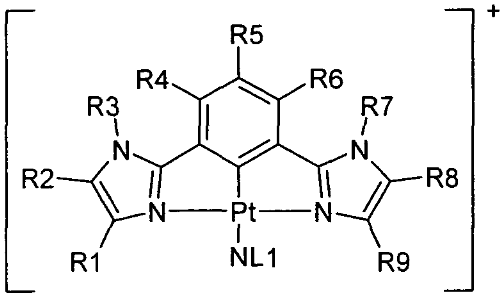

22

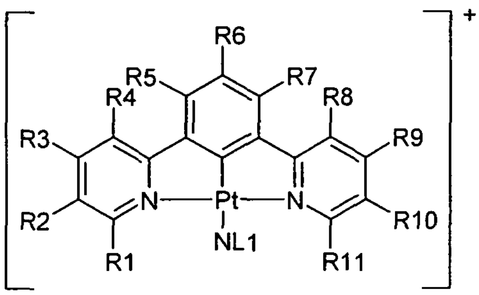

23

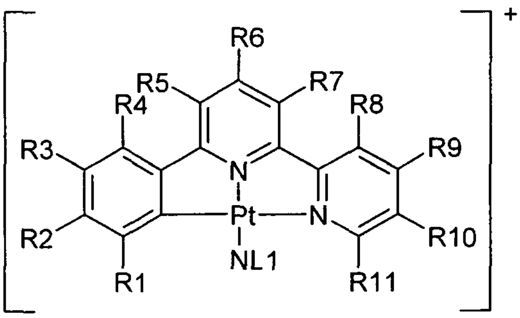

24

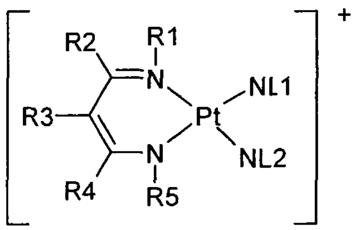

25

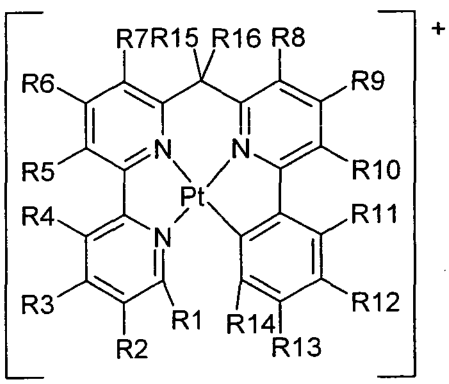

26

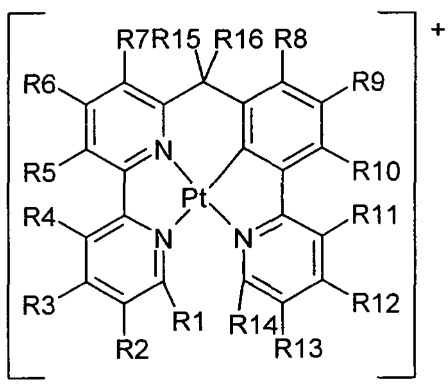

27

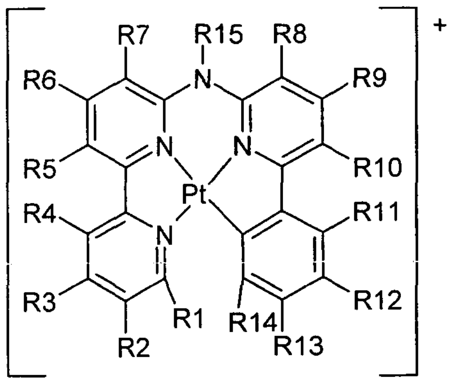

**28**

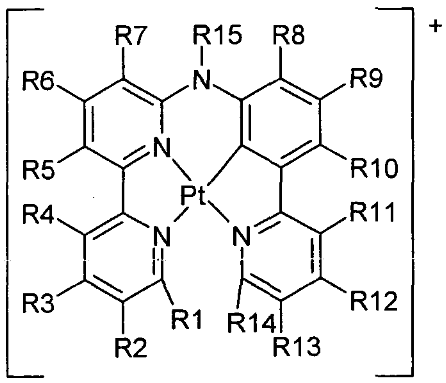

**29**

Beispiele für die Komponente

$$K_2 = [L5L6L7L8Pt(II)]^-:$$

Allgemeine Formeln:

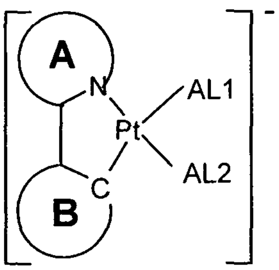

**30**

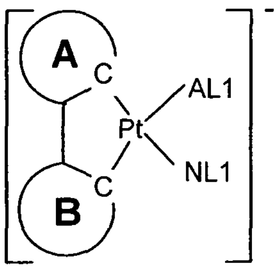

**31**

Diese Formel wird weiter unten genauer definiert (siehe Kapitel: Definition der Liganden und Reste).

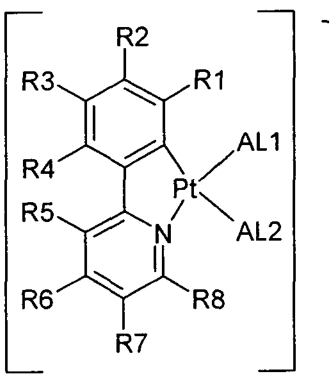

**32**

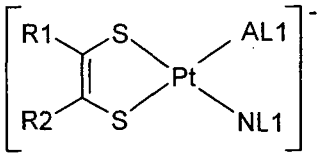

**33**

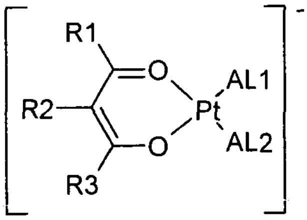

**34**

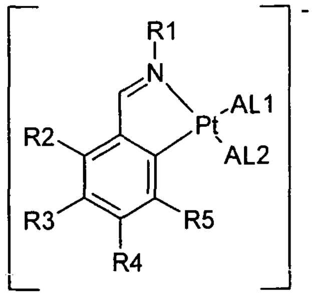

**35**

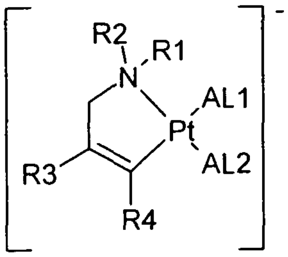

**36**

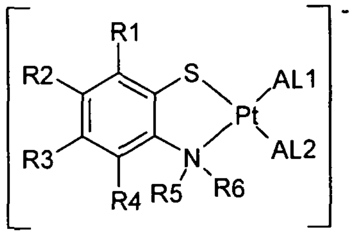

**37**

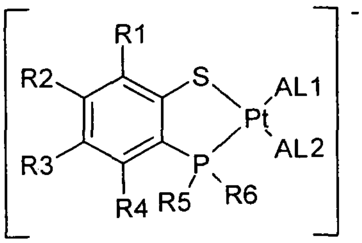

**38**

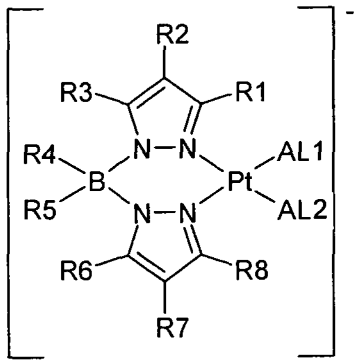

**39**

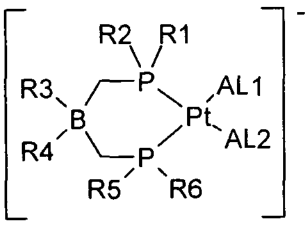

**40**

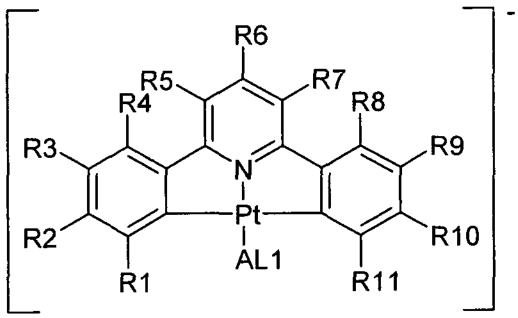

**41**

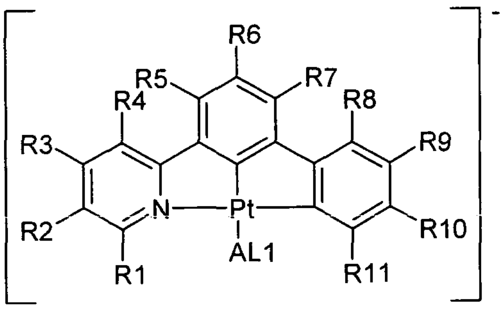

**42**

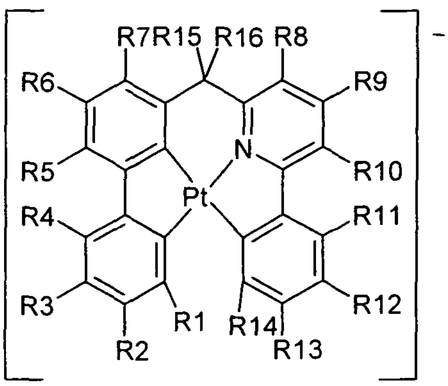

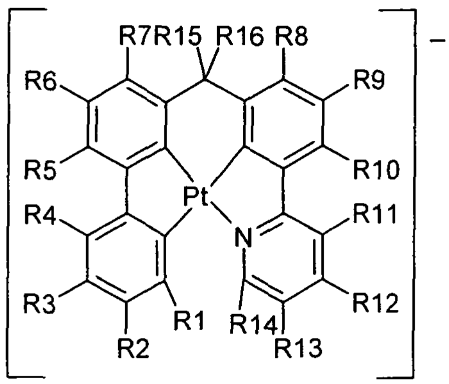

**43** **44**

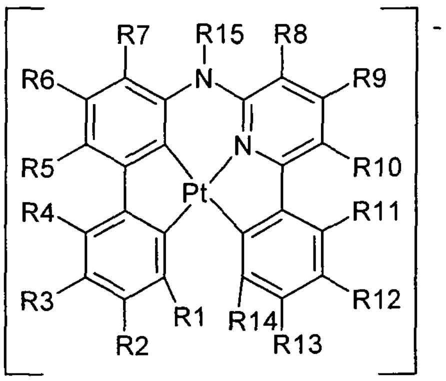

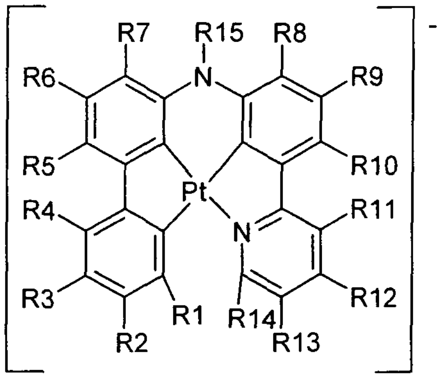

**45** **46**

Beispiele zu Doppelkomplex-Salzen mit

$$K_1 = [L1L2L3L4Pd(II)]^+$$

$$K_2 = [L5L6L7L8Pd(II)]^-$$

Beispiele für die Komponente

$$K_1 = [L1L2L3L4Pd(II)]^+:$$

Allgemeine Formel für α-Diimin-Komplexe

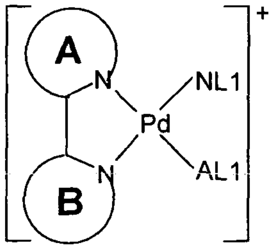

47

Allgmeine Formel für cyclometallierte Carben-Pd-Komplexe

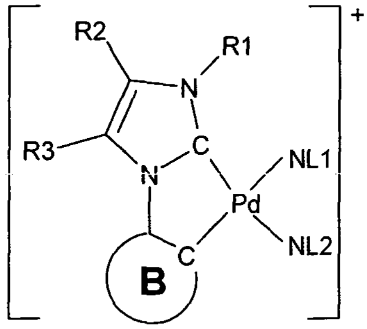

48

wobei die Diimin- und Carben-Liganden, die Reste R1 bis R20, NL1 bis NL4 sowie AL1 bis AL4 wie hierin definiert sind (siehe Kapitel: Definition der Liganden und Reste).

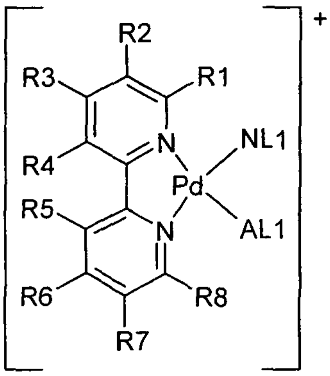

49

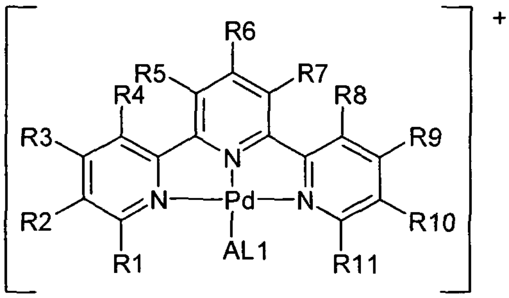

50

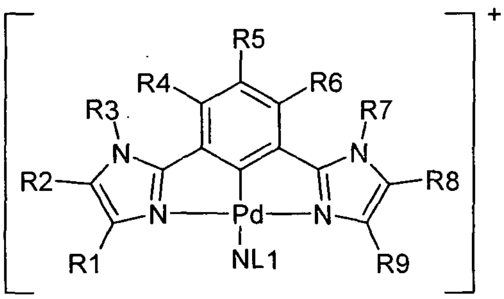

51

Beispiele für die Komponente

$$K_2 = [L5L6L7L8Pd(II)]^-$$

Allgemeine Formel:

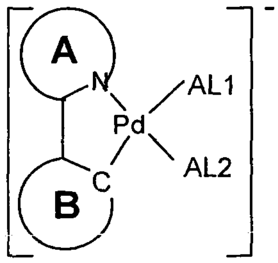

**52**

Diese Formel wird weiter unten genauer definiert (siehe Kapitel: Definition der Liganden und Reste).

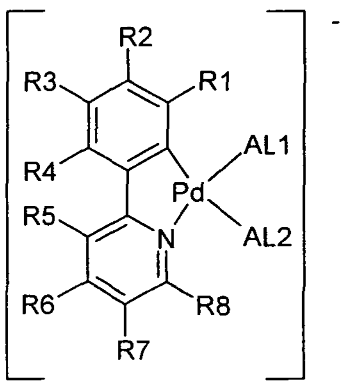

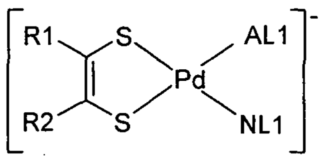

**53** **54**

Zusätzlich zu den hier aufgeführten Beispielen für $K_1 = [L1L2L3L4Pd(II)]^+$ und $K_2 = [L5L6L7L8Pd(II)]^-$ können auch alle oben aufgeführten einfach positiv bzw. negativ geladenen Pt-Komplexe herangezogen werden, jedoch muss Pt durch Pd ersetzt werden.

Beispiele zu Doppelkomplex-Salzen mit

$$K_1 = [L1L2L3L4Ir(I)]^+$$

$$K_2 = [L5L6L7L8Ir(I)]^-$$

Beispiele für die Komponente

$$K_1 = [L1L2L3L4Ir(I)]^+:$$

Allgemeine Formeln:

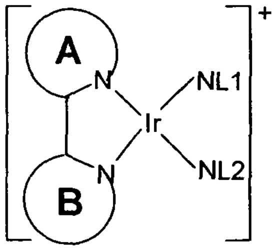

55

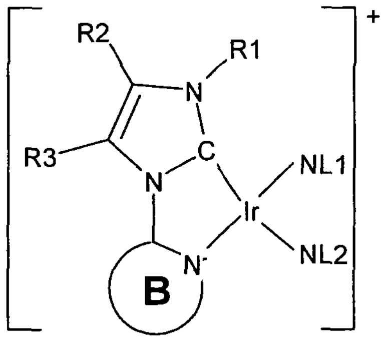

56

wobei die Diimin- und Carben-Liganden, die Reste R1 bis R20, NL1 bis NL4 sowie AL1 bis AL4 wie hierin definiert sind (siehe Kapitel: Definition der Liganden und Reste).

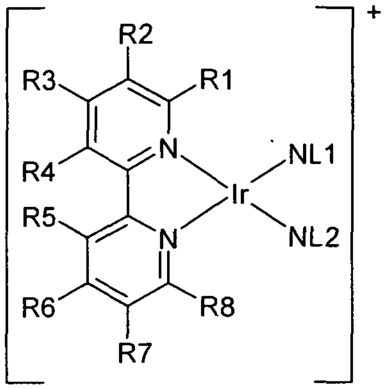

57

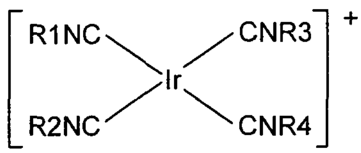

58

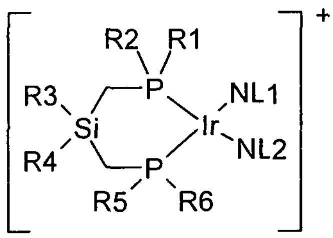

59

Beispiele für die Komponente

$$K_2 = [L5L6L7L8Ir(I)]^-:$$

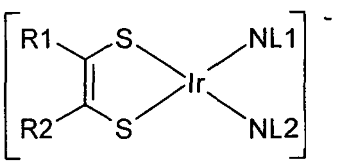

60

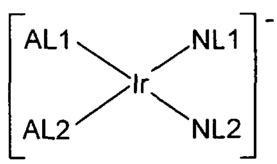

61

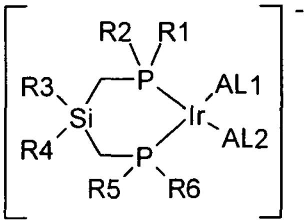

62

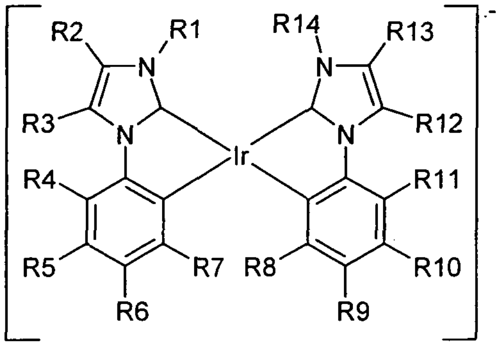

63

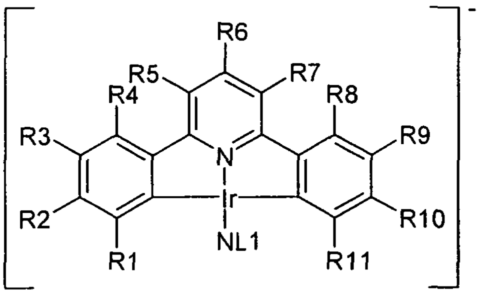

64

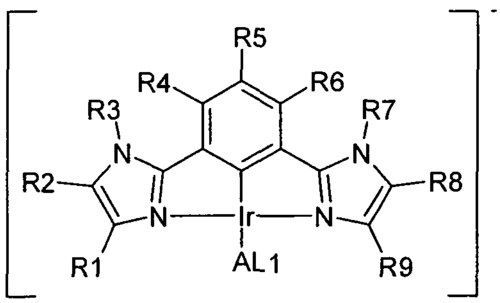

65

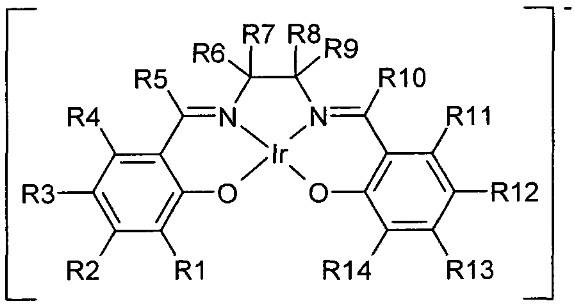

66

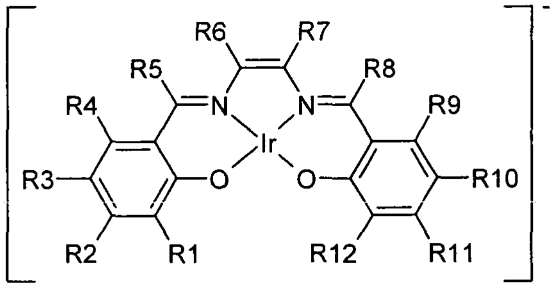

67

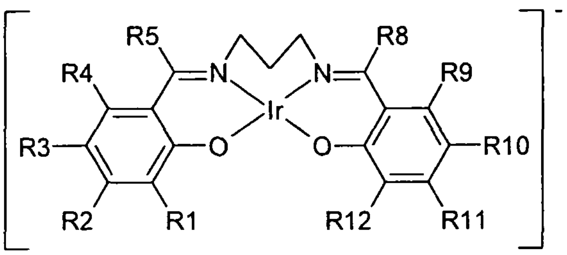

**68**

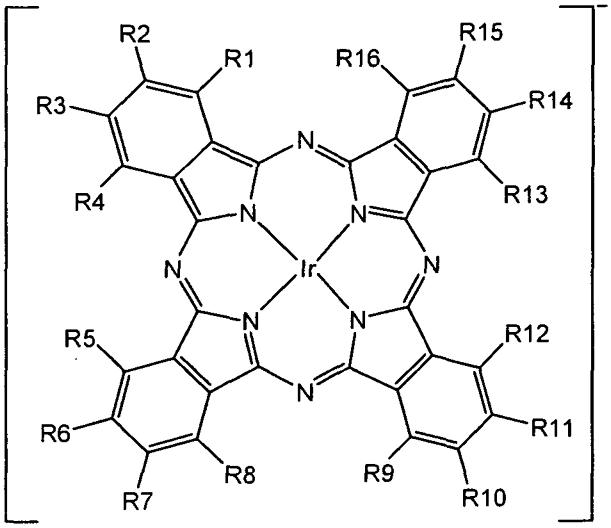

**69**

Beispiele zu Doppelkomplex-Salzen mit

$$K_1 = [L1L2L3L4Rh(I)]^+$$

$$K_2 = [L5L6L7L8Rh(I)]^-$$

Beispiele für die Komponente

$$K_1 = [L1L2L3L4Rh(I)]^+:$$

Allgemeine Formeln:

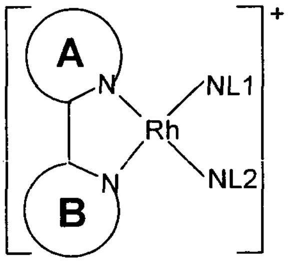

70

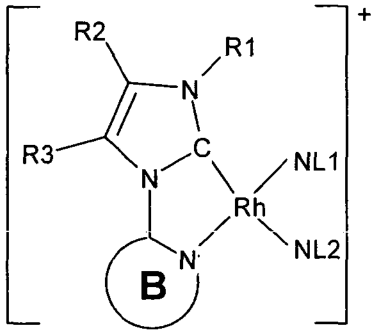

71

wobei die Diimin- und Carben-Liganden, die Reste R1 bis R20, NL1 bis NL4 sowie AL1 bis AL4 wie hierin definiert sind (siehe Kapitel: Definition der Liganden und Reste).

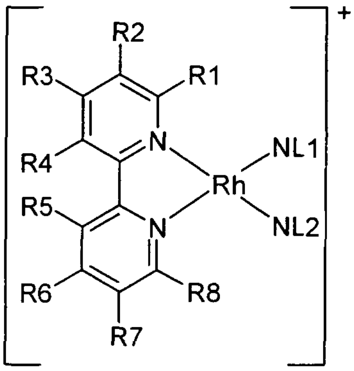

72

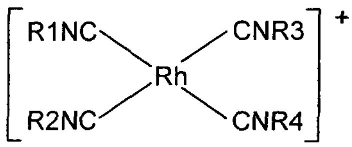

73

Beispiele für die Komponente

$$K_2 = [L5L6L7L8Rh(I)]^-:$$

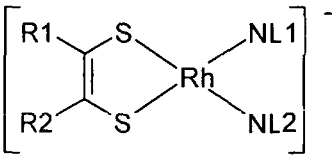

74

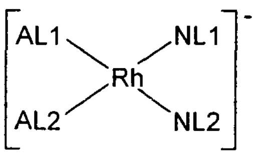

75

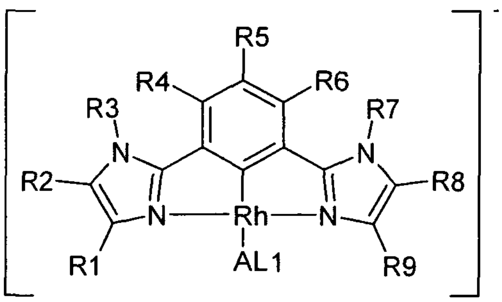

76

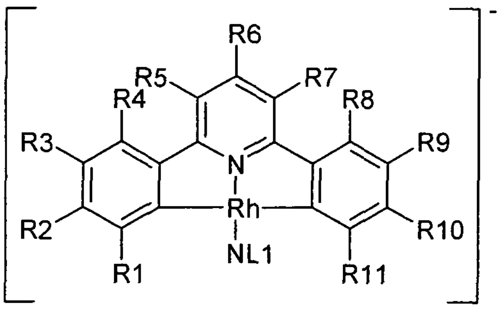

77

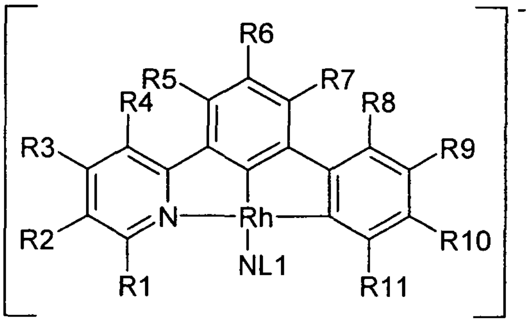

78

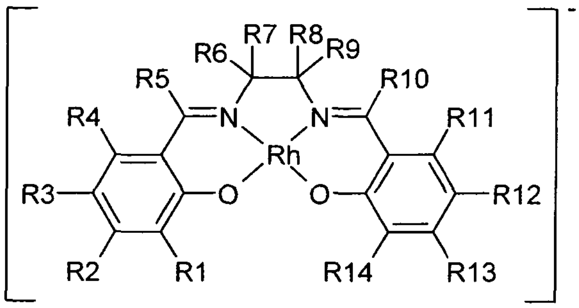

79

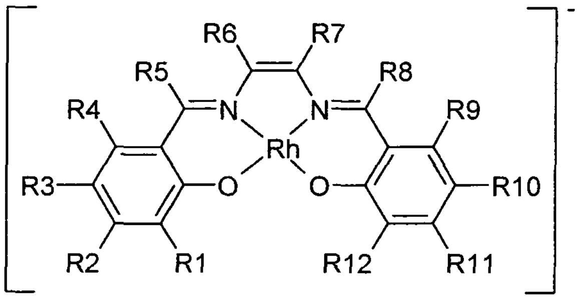

80

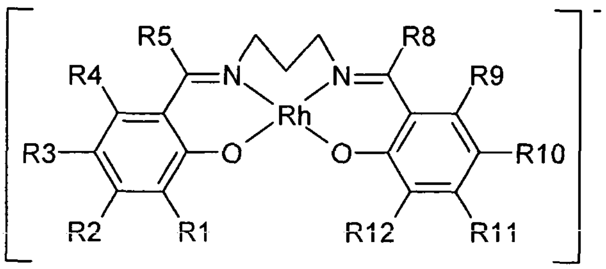

**81**

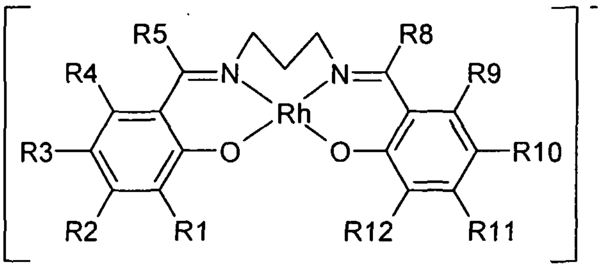

**82**

Kolumnarstrukturen, die aus zweifach positiv bzw. zweifach negativ geladenen quadratisch-planaren Komplexen aufgebaut sind:

$-K_1-K_2-K_1-K_2-K_1-K_2-K_1-$

$K_1$: quadratisch-planarer, zweifach positiv geladener Komplex
$K_2$: quadratisch-planarer, zweifach negativ geladener Komplex

$$K_1 = [L1L2L3L4M1(II)]^{2+}$$

$$K_2 = [L5L6L7L8M2(II)]^{2-}$$

mit M1(II), M2(II) = Pt(II), Pd(II)

Beispiele zu Doppelkomplex-Salzen mit

$$K_1 = [L1L2L3L4Pt(II)]^{2+}$$

$$K_2 = [L5L6L7L8Pt(II)]^{2-}$$

Beispiele für die Komponente

$$K_1 = [L1L2L3L4Pt(II)]^{2+}:$$

Als kationische Komplexe können z.B. α-Diimin-Komplexe, Carben-Komplexe und Pinzer-Komplexe wie die oben aufgeführten Komplexe sowie allgemein quadratisch-planare Platin-Komplexe mit neutralen Liganden NL1-NL4 zum Einsatz kommen.

Allgemeine Formeln (Ringe C und D sind analog zu A und B definiert (s. u.))

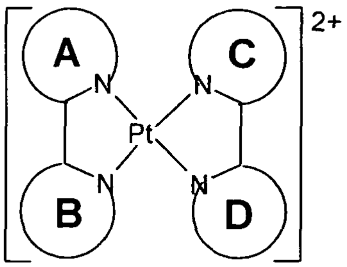

83

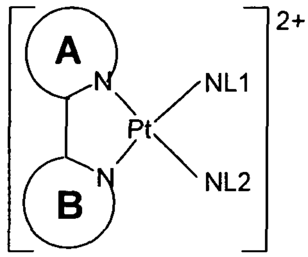

84

wobei die Diimin-Liganden, die Reste R1 bis R20, NL1 bis NL4 sowie AL1 bis AL4 wie hierin definiert sind (siehe Kapitel: Definition der Liganden und Reste).

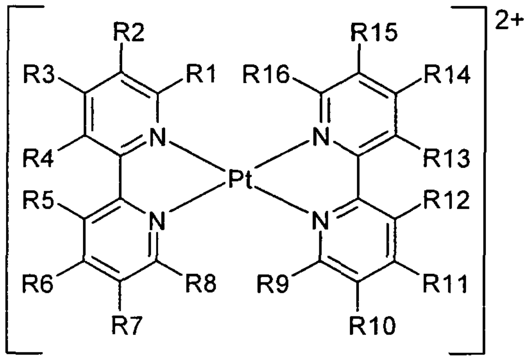

85

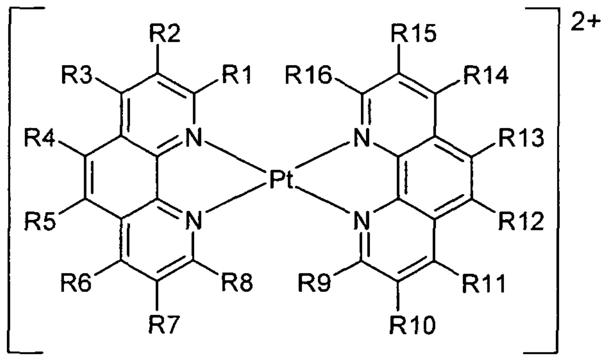

86

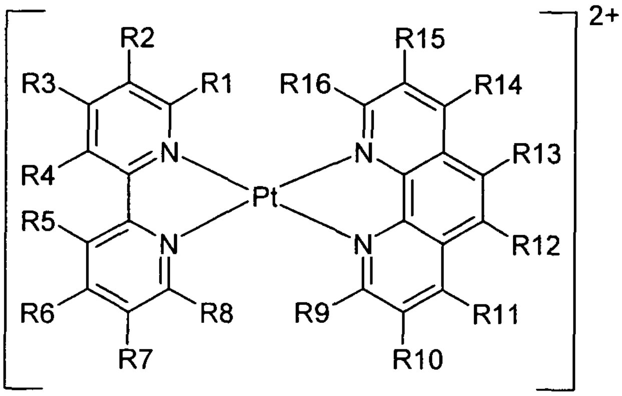

**87**

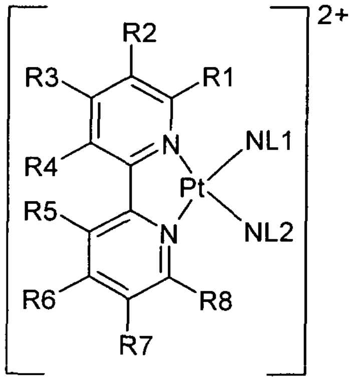

**88**

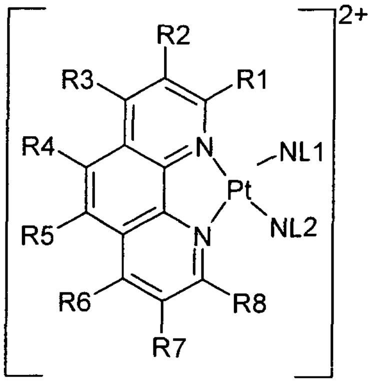

**89**

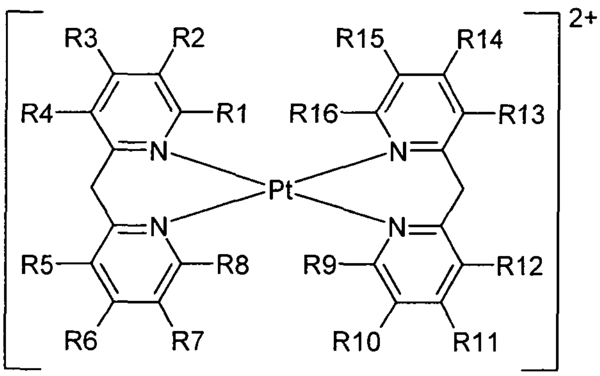

**90**

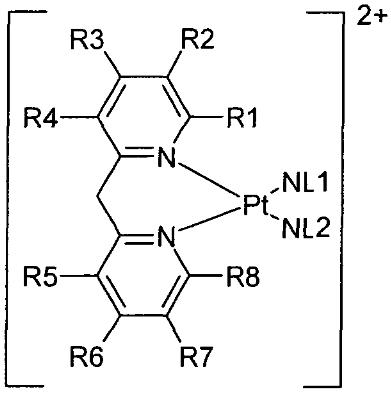

**91**

Allgemeine Formeln:

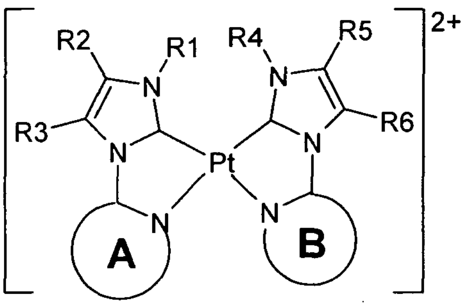

92

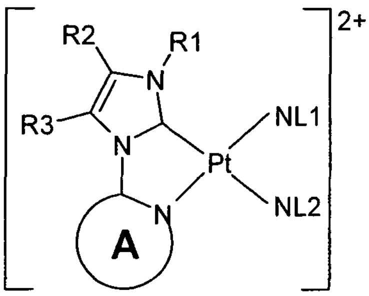

93

wobei Carben-Liganden, die Reste R1 bis R20, NL1 bis NL4 sowie AL1 bis AL4 wie hierin definiert sind (siehe Kapitel: Definition der Liganden und Reste).

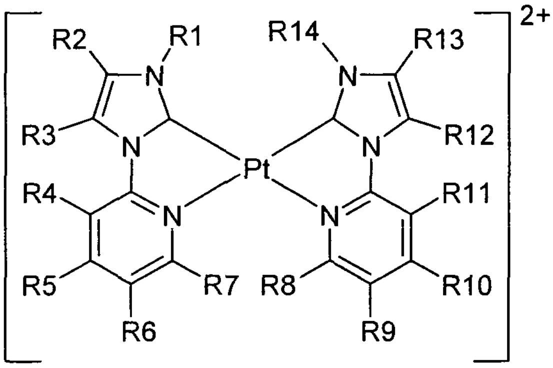

94

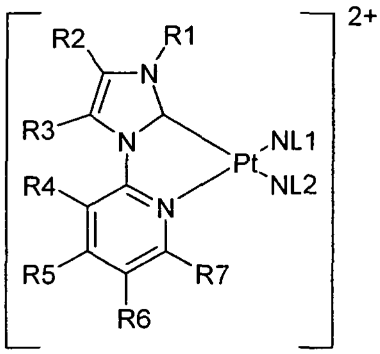

95

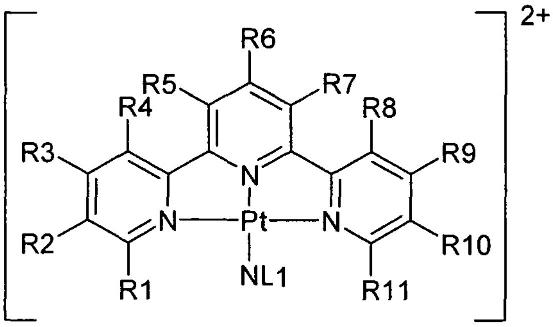

96

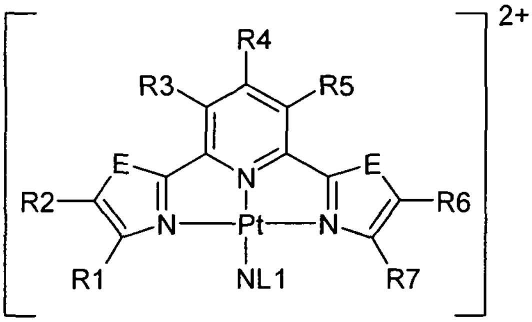

**97** (E = O, S, NR, wobei R wie R1 bis R20 definiert ist)

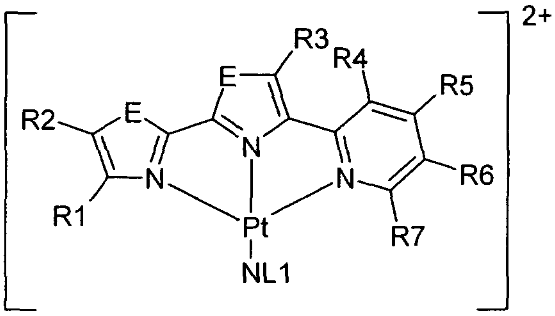

**98** (E = O, S, NR, wobei R wie R1 bis R20 definiert ist)

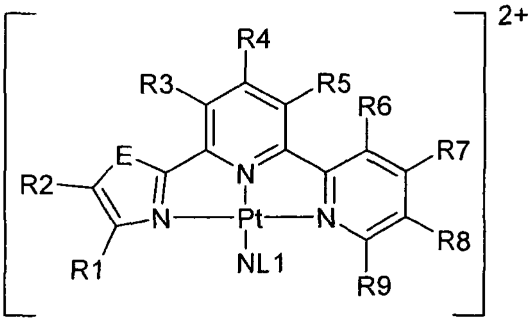

**99** (E = O, S, NR, wobei R wie R1 bis R20 definiert ist)

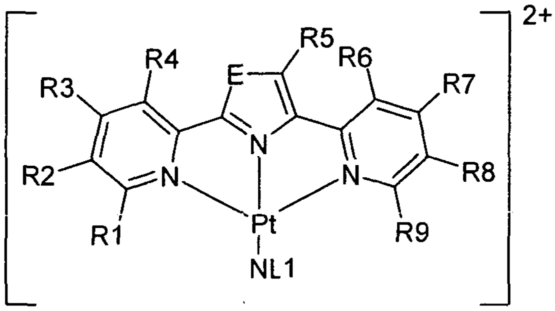

**100** (E = O, S, NR, wobei R wie R1 bis R20 definiert ist)

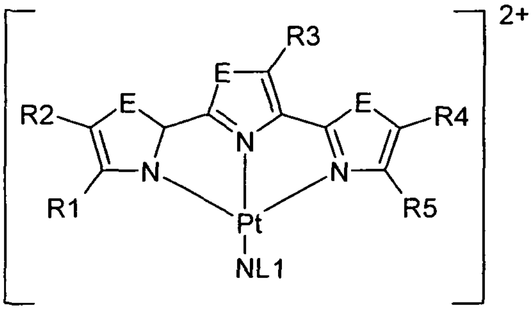

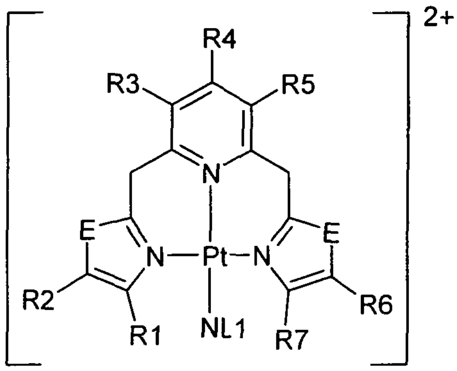

**101** **102**

(E = O, S, NR, wobei R wie R1 bis R20 definiert ist)

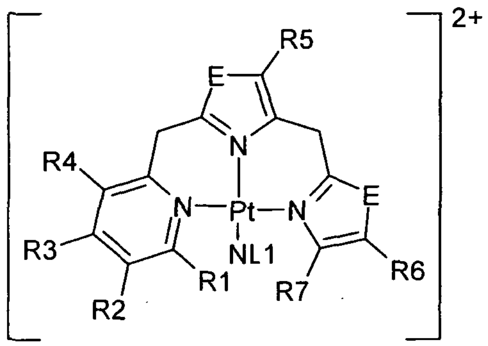

**103** (E = O, S, NR, wobei R wie R1 bis R20 definiert ist)

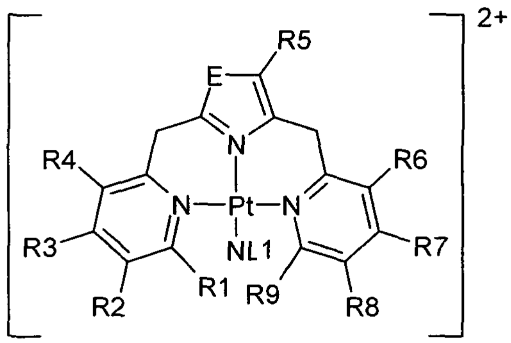

**104** (E = O, S, NR, wobei R wie R1 bis R20 definiert ist)

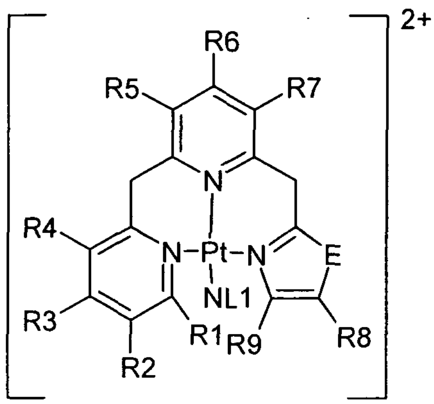

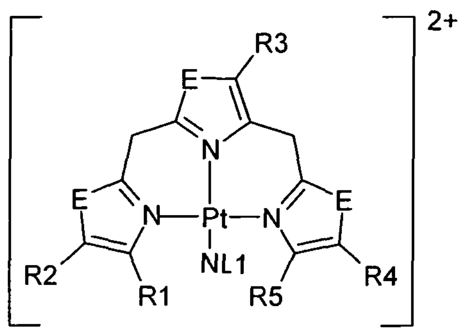

**105** **106**

(E = O, S, NR, wobei R wie R1 bis R20 definiert ist)

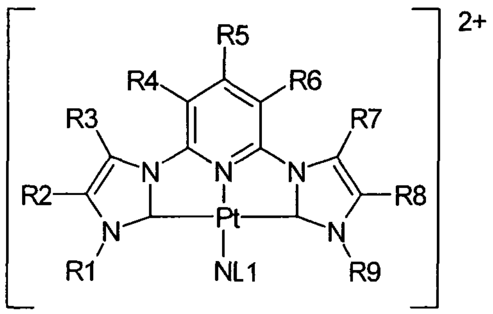

107

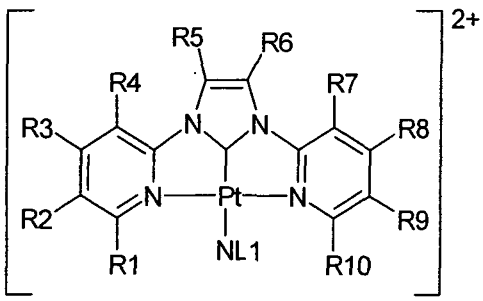

108

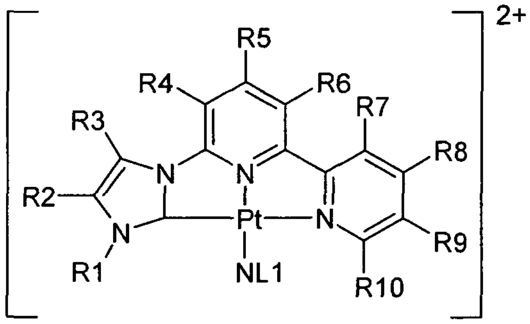

109

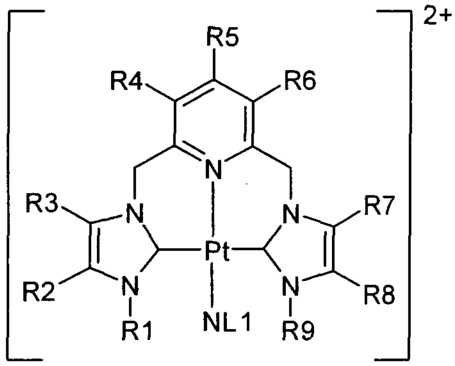

110

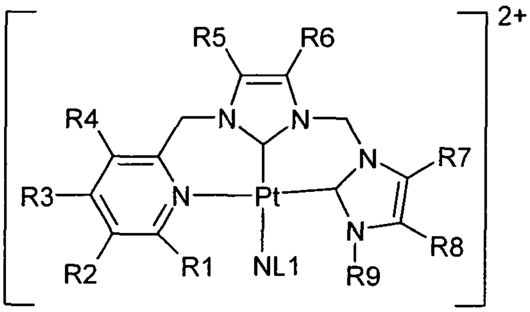

111

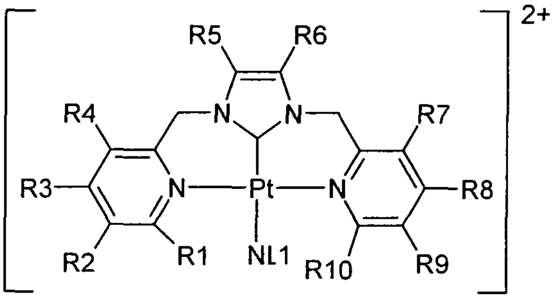

112

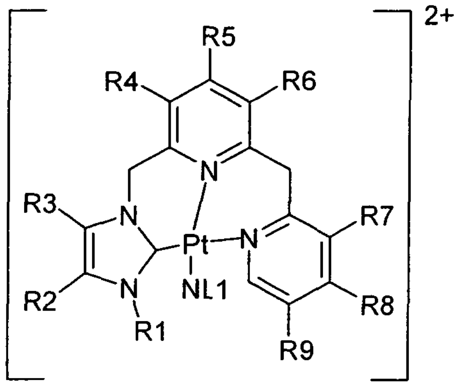

113

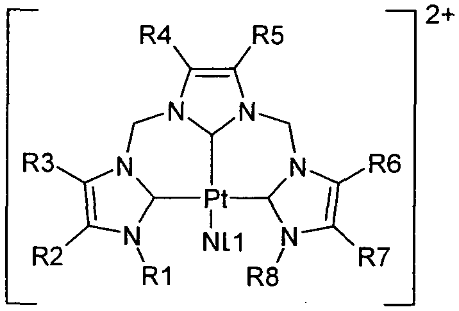

114

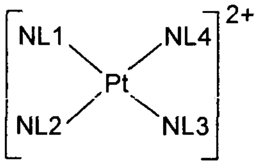

115

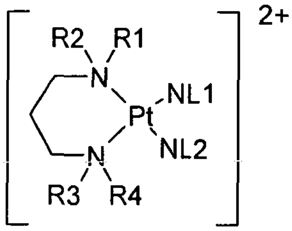

116

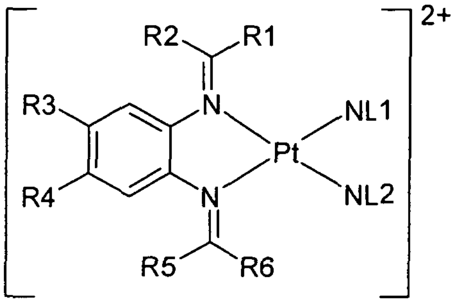

117

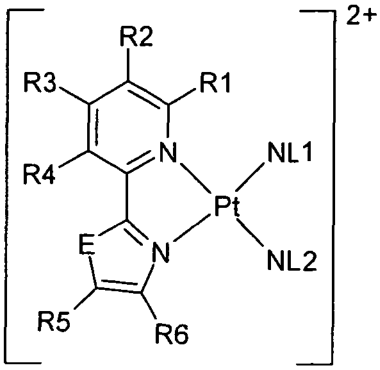

118

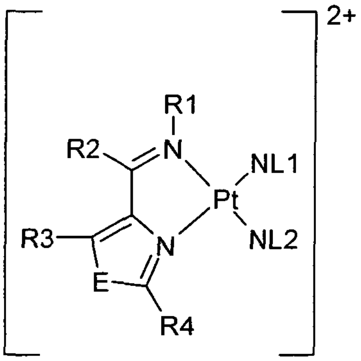

119

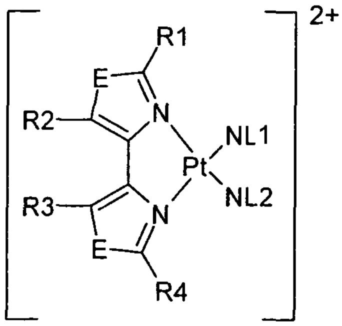

120

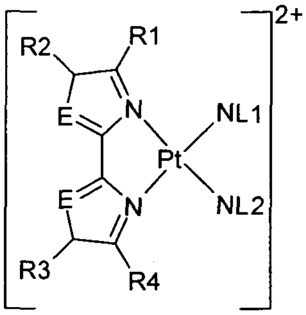

121

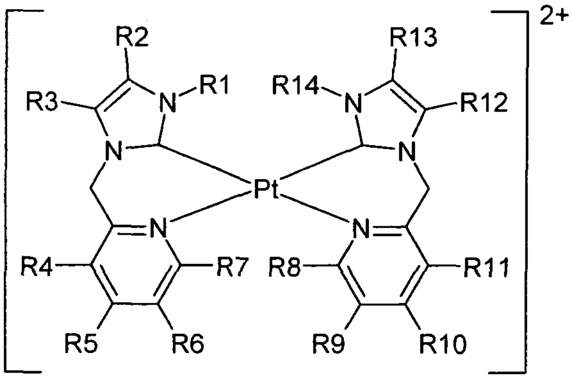

122

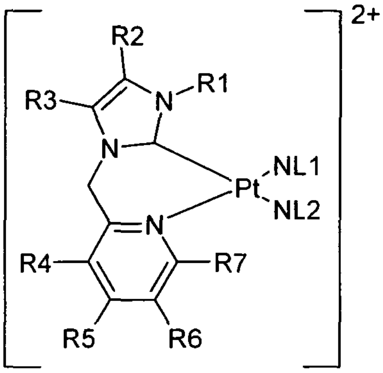

123

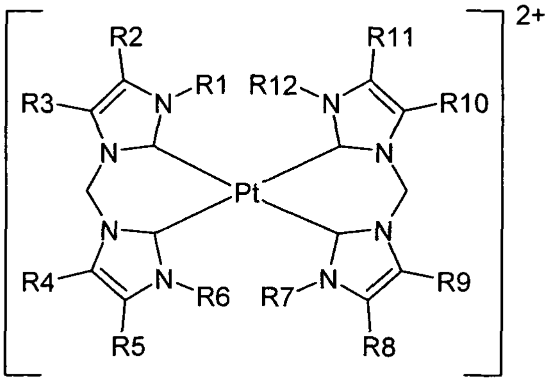

124

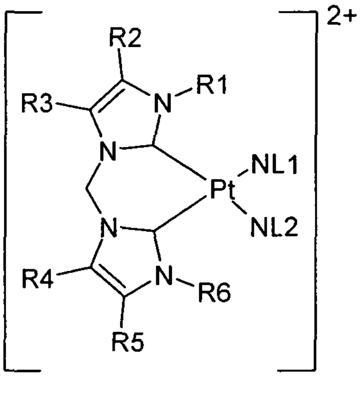

125

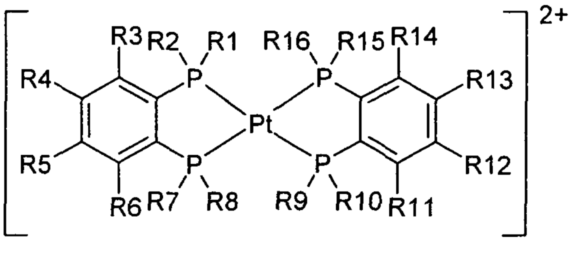

126

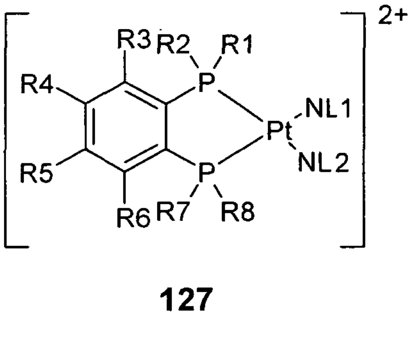

127

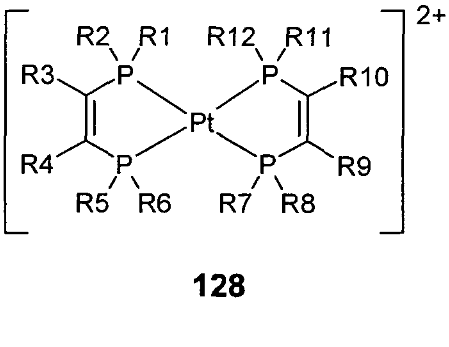

128

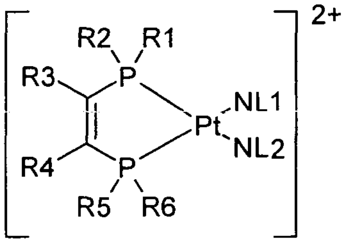

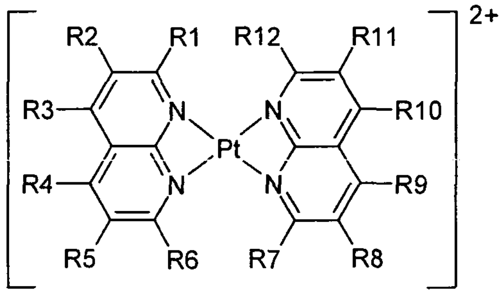

129

130

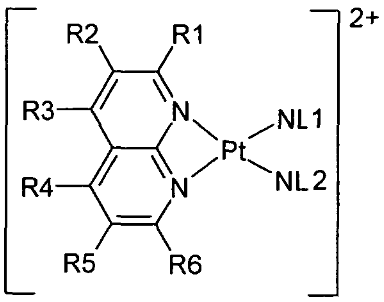

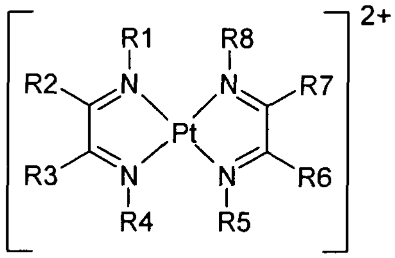

131

132

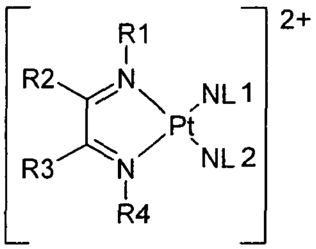

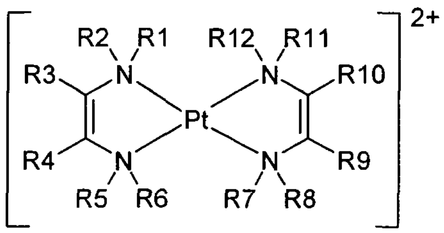

133

134

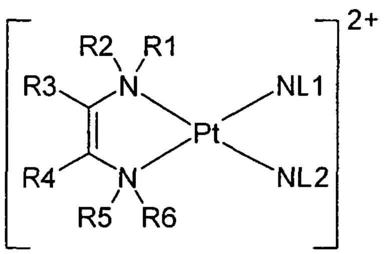

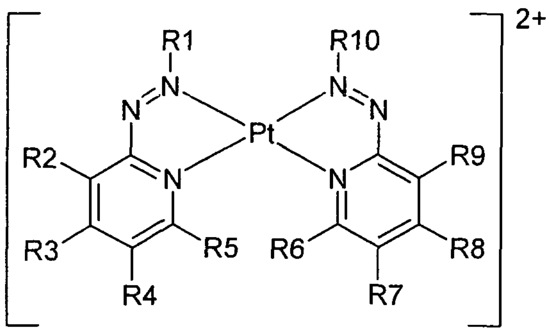

135

136

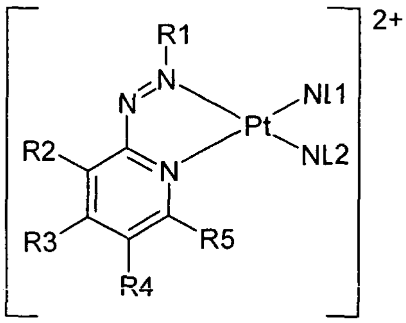

**137**

Beispiele für die Komponente

$$K_2 = [L5L6L7L8Pt(II)]^{2-}:$$

Als Komplex-Anion kann bevorzugt $[Pt(CN)_4]^{2-}$ verwendet werden. Aber auch andere Komplex-Anionen wie z. B. $[PtCl_4]^{2-}$, $[PtBr_4]^{2-}$, $[PtI_4]^{2-}$, $[Pt(C{\equiv}CR)_4]^{2-}$, $[Pt(ox)_2]^{2-}$, $[Pt(1,2\text{-Dithiolat-Ligand})_2]^{2-}$ oder $[Pt(1,1\text{-Dithiolat-Ligand})_2]^{2-}$, die eine M-M-Wechselwirkung ermöglichen, können eingesetzt werden.

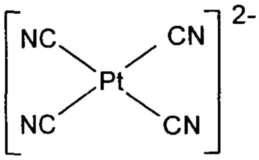

**138**

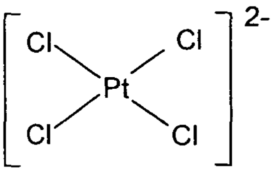

**139**

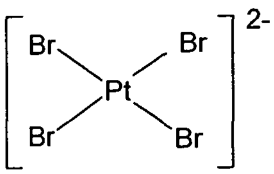

**140**

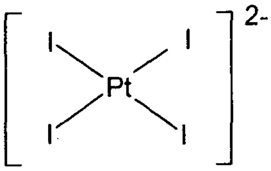

**141**.

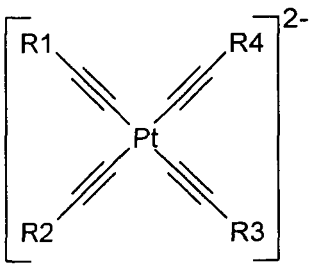

**142**

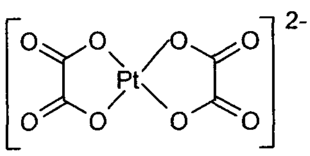

**143**

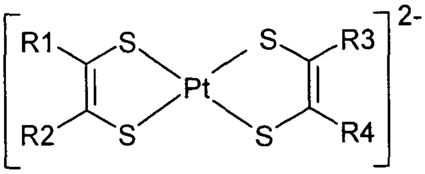

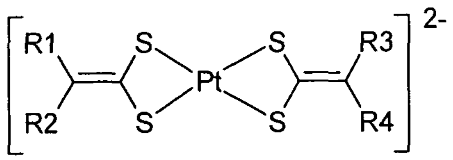

**144** **145**

146-152 stellt eine Reihe von Komplex-Anionen der allgemeinen Form (144) und (145) exemplarisch dar:

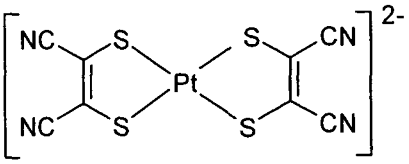

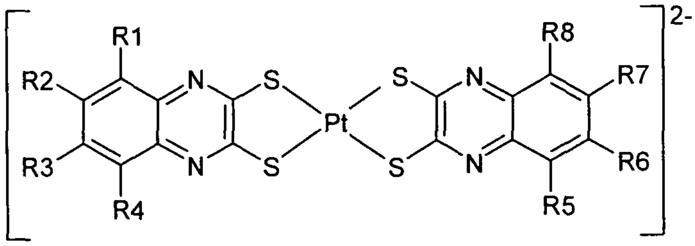

**146** **147**

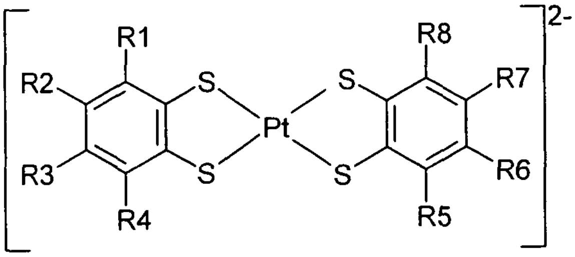

**148**

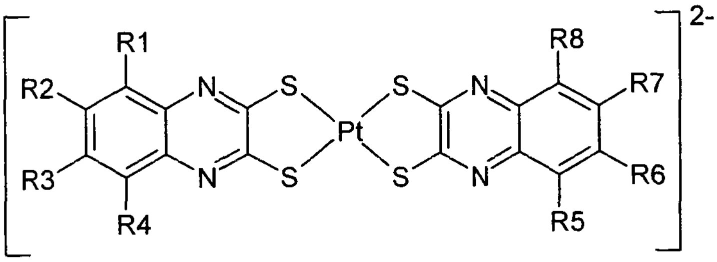

**149**

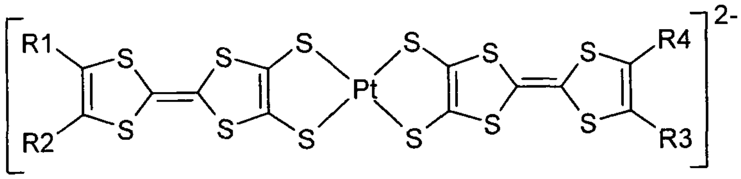

**150**

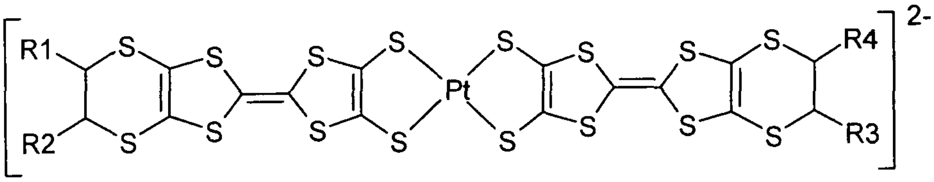

**151**

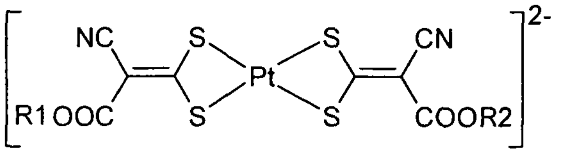

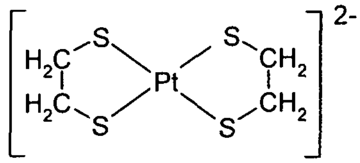

**152** **153**

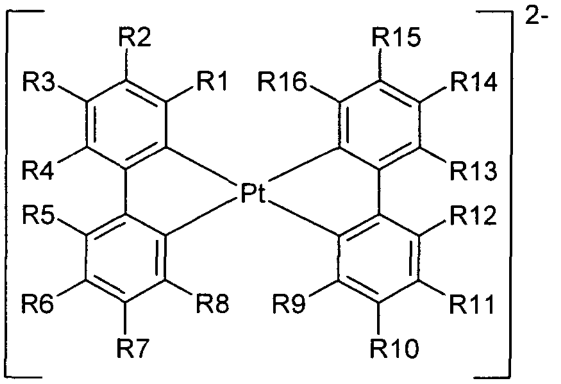

**154**

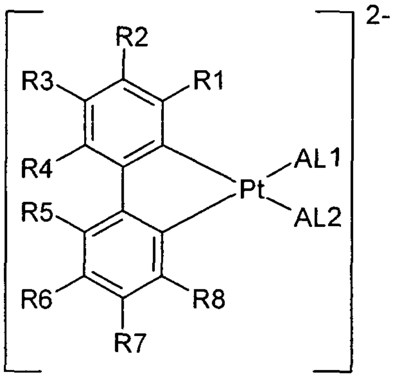

**155**

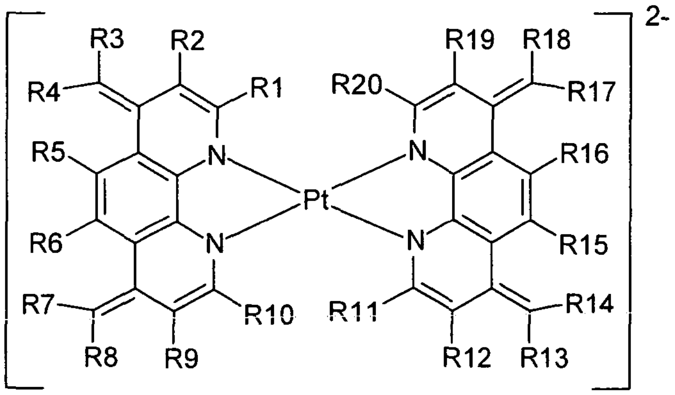

**156**

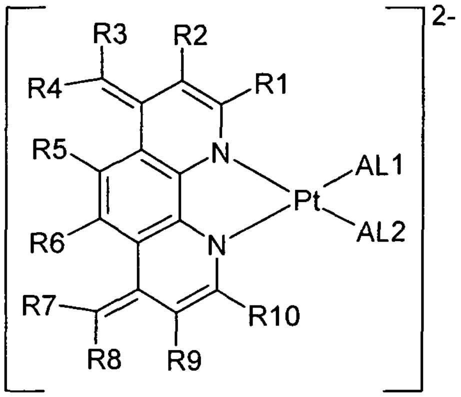

**157**

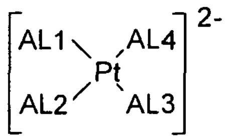

**158**

Beispiele zu Doppelkomplex-Salzen mit

$$K_1 = [L1L2L3L4Pd(II)]^{2+}$$

$$K_2 = [L5L6L7L8Pd(II)]^{2-}$$

Beispiele für die Komponente

$$K_1 = [L1L2L3L4Pd(II)]^{2+}:$$

Als Beispiele für zweifach positiv geladene quadratisch-planare Pd(II)-Komplexe können die oben aufgeführten Beispiele für $K_1 = [L1L2L3L4Pt(II)]^{2+}$ verwendet werden, jedoch muss Pt(II) durch Pd(II) ersetzt werden.

Beispiele für die Komponente

$$K_2 = [L5L6L7L8Pd(II)]^{2-}:$$

Als Beispiele für zweifach negativ geladene quadratisch-planare Pd(II)-Komplexe können die oben aufgeführten Beispiele für $K_2 = [L5L6L7L8Pt(II)]^{2-}$ verwendet werden, jedoch muss Pt(II) durch Pd(II) ersetzt werden.

Doppelkomplex-Salze bestehend aus unterschiedlich geladenen Komplexen mit verschiedenen Zentralmetallen

**Dotierte Kolumnarstrukturen**

$-K_1-K_2-K_1-K_2-D_1-K_2-K_1-K_2-K_1-$ oder
$-K_2-K_1-K_2-K_1-K_2-K_1-K_2-K_1-K_2-$

Bevorzugt wird auch eine Dotierung von geladenen, quadratisch-planaren Pt-Komplexen **(D),** die in geringer Konzentration in eine Kette von geladenen, quadratisch-planaren Pd-Komplexen **($K_1$, $K_2$)** eingebaut werden. Dadurch lässt sich der Emissionsbereich der Pt-Verbindung verschieben. Dabei wirkt der Pd-Komplex-Stapel wie eine mit dem dotierten Pt-Komplex wechselwirkende Matrix. Aufgrund dieses Prinzips kommt es zu einer Verschiebung der Emissionsmaxima. Die Dotierung kann dabei an Kolumnarstrukturen vorgenommen werden, die aus einfach oder zweifach geladenen Komplexen **($K_1$, $K_2$)** aufgebaut sind.

**Beispiele:**

a)

**$K_1$:** quadratisch-planarer, einfach positiv geladener Pd-Komplex
**$K_2$:** quadratisch-planarer, einfach negativ geladener Pd-Komplex
**$D_1$:** quadratisch-planarer, einfach positiv geladener Pt-Komplex
**$D_2$:** quadratisch-planarer, einfach negativ geladener Pt-Komplex

b)

**$K_1$:** quadratisch-planarer, zweifach positiv geladener Pd-Komplex
**$K_2$:** quadratisch-planarer, zweifach negativ geladener Pd-Komplex
**$D_1$:** quadratisch-planarer, zweifach positiv geladener Pt-Komplex
**$D_2$:** quadratisch-planarer, zweifach negativ geladener Pt-Komplex

Es ist aber auch möglich, in Kolumnarstrukturen, aufgebaut aus einfach bzw. zweifach geladenen Pt-Komplexen, einfach bzw. zweifach geladene Pd-Komplexe einzubauen. Dadurch kann die Größe der für die Lichtemission verantwortlichen Oligomere und somit die Emissionswellenlänge variiert werden.

Erfindungsgemäß kann das Konzept der Dotierung auch auf Kolumnarstrukturen angewandt werden, die aus geladenen Komplexen der Elemente Ir(I) und Rh(I) aufgebaut sind. In die jeweilige Kolumnarstruktur kann dabei jeder quadratisch-planare Komplex mit der passenden Ladung eindotiert werden.

Der zur Dotierung eingesetzte Komplex liegt in der Oligomermatrix bevorzugt in einem Mol-Verhältnis von höchstens 1 : 3, bevorzugt höchstens 1 : 10, bevorzugt höchstens 1 : 50 und insbesondere höchstens 1 : 100, bezogen auf die Oligomermatrix bildenden Komplexe, vor. Vorzugsweise liegt der zur Dotierung eingesetzte Komplex in der Oligomermatrix in einem Mol-Verhältnis von mindestens 1 : 100 000, bevorzugt mindestens 1 : 10 000, mehr bevorzugt mindestens 1 : 1000, bezogen auf die Oligomermatrix bildenden Komplexe, vor.

Das erläuterte Konzept der Dotierung von Kolumnarstrukturen kann vorwiegend zur Steuerung der Emissionsfarbe verwendet werden und ist aus diesem Grund von großer Bedeutung für OLED-Anwendungen. Das gilt besonders, weil mit diesem Erfindungskonzept blaues bzw. weißes Emissionslicht erzeugt werden kann. Dieses Erfindungskonzept zeichnet sich besonders dadurch aus, dass aufgrund der definierten Ladung der dotierten Komplexe, $D_1$ oder $D_2$, in dem erfindungsgemäßen Bauprinzip keine $-D_1-D_1-$ oder $-D_2-D_2-$ Nachbaranordnungen auftreten können. Damit lässt sich z. B. die bevorzugte Farbe blau erzielen.

**Kolumnarstrukturen, die aus einfach positiv/negativ bzw. zweifach positiv/negativ geladenen quadratisch-planaren Komplexen mit verschiedenen Metallzentren aufgebaut sind:**

Zusätzlich zu den bereits oben aufgeführten Doppelkomplex-Salzen, können auch Doppelkomplex-Salze mit unterschiedlichen Metallzentren in stöchiometrischer Zusammensetzung (nicht dotiert) auftreten. In einer weiteren bevorzugten Form wird eine weitere Komponente dotiert.

$-K_1-K_2-K_1-K_2-K_1-K_2-K_1-$

**Beispiele:**

**$K_1$:** quadratisch-planarer, einfach positiv (negativ) geladener Komplex
**$K_2$:** quadratisch-planarer, einfach negativ (positiv) geladener Komplex

$$K_1 = [L1L2L3L4M1(I)]^+$$
$$[L1'L2'L3'L4'M1(II)]^+$$

$$K_2 = [L5L6L7L8M2(I)]^-$$
$$[L5'L6'L7'L8'M2(II)]^-$$

mit

M1 (I) / M2(I) = Ir(I), Rh(I)
M1(II) / M2(II) = Pt(II), Pd(II)

Daraus ergeben sich beispielsweise folgende Kolumnarstrukturen:

$$K_1 = [L1L2L3L4Pt(II)]^+$$

$$K_2 = [L5L6L7L8Pd(II)]^-$$

$$K_1 = [L1L2L3L4Pd(II)]^+$$

$$K_2 = [L5L6L7L8Pd(II)]^-$$

$$K_1 = [L1L2L3L4Pt(II)]^+$$

$$K_2 = [L5L6L7L8Ir(I)]^-$$

$$K_1 = [L1L2L3L4Ir(I)]^+$$

$$K_2 = [L5L6L7L8Pt(II)]^-$$

$$K_1 = [L1L2L3L4Pt(II)]^+$$

$$K_2 = [L5L6L7L8Rh(I)]^-$$

$$K_1 = [L1L2L3L4Rh(I)]^+$$

$$K_2 = [L5L6L7L8Pt(II)]^-$$

$$K_1 = [L1L2L3L4Pd(II)]^+$$

$$K_2 = [L5L6L7L8Ir(I)]^-$$

$$K_1 = [L1L2L3L4Ir(I)]^+$$

$$K_2 = [L5L6L7L8Pd(II)]^-$$

$$K_1 = [L1L2L3L4Pd(II)]^+$$

$$K_2 = [L5L6L7L8Rh(I)]^-$$

$$K_1 = [L1L2L3L4Rh(I)]^+$$

$$K_2 = [L5L6L7L8Pd(II)]^-$$

$$K_1 = [L1L2L3L4Ir(I)]^+$$

$$K_2 = [L5L6L7L8Rh(I)]^-$$

$$K_1 = [L1L2L3L4Rh(I)]^+$$

$$K_2 = [L5L6L7L8Ir(I)]^-$$

$K_1$: quadratisch-planarer, zweifach positiv (negativ) geladener Komplex
$K_2$: quadratisch-planarer, zweifach negativ (positiv) geladener Komplex

$$K_1 = \quad [L1L2L3L4M1(II)]^{2+}$$

$$K_2 = \quad [L5L6L7L8M2(I)]^{2-}$$
$$[L5'L6'L7'L8'M2(II)]^{2-}$$

mit

M2(I) = Ir(I), Rh(I)
M1 (II) / M2(II) = Pt(II), Pd(II)

Daraus ergeben sich folgende Doppelkomplex-Salz-Kolumnarstrukturen:

$$K_1 = [L1L2L3L4Pt(II)]^{2+}$$

$$K_2 = [L5L6L7L8Pd(II)]^{2-}$$

$$K_1 = [L1L2L3L4Pd(II)]^{2+}$$

$$K_2 = [L5L6L7L8Pt(II)]^{2-}$$

$$K_1 = [L1L2L3L4Pt(II)]^{2+}$$

$$K_2 = [L5L6L7L8Ir(I)]^{2-}$$

$$K_1 = [L1L2L3L4Pt(II)]^{2+}$$

$$K_2 = [L5L6L7L8Rh(I)]^{2-}$$

$$K_1 = [L1L2L3L4Pd(II)]^{2+}$$

$$K_2 = [L5L6L7L8Ir(I)]^{2-}$$

$$K_1 = [L1L2L3L4Pd(II)]^{2+}$$

$$K_2 = [L5L6L7L8Rh(I)]^{2-}$$

Die in einer Metall-Komplex-Kombination mit L1 bis L8 sowie L1' bis L8' bezeichneten Liganden sind nicht zwingend identisch mit den in einer anderen Kombination ebenfalls mit L1 bis L8 sowie L1' bis L8' benannten Liganden.

Weitere Kombinationen:

Auch folgende Arten von Kolumnarstrukturen sind möglich (Beispiele): Komplex-Salz-Oligomer bestehend aus drei oder mehr unterschiedlichen Komplexen:

Beispiele für eine Dreier-Kombination:

$-K_1-K_2-K_3-K_1-K_2-K_3-K_1-$

$$K_1 = [L1L2L3L4M1(II)]^{2+}$$

$$K_2 = [L5L6L7L8M2(II)]^{-}$$

$$K_3 = [L5L6L7L8M2(II)]^-$$

$$K_1 = [L5L6L7L8M2(II)]^{2-}$$

$$K_2 = [L1L2L3L4M1(II)]^+$$

$$K_3 = [L1L2L3L4M1(II)]^+$$

$$K_1 = [L1L2L3L4M1(II)]^{2+}$$

$$K_2 = [L5L6L7L8M2(I)]^-$$

$$K_3 = [L5L6L7L8M2(I)]^-$$

$$K_1 = [L5L6L7L8M2(II)]^{2-}$$

$$K_2 = [L1L2L3L4M1(I)]^+$$

$$K_3 = [L1L2L3L4M1(I)]^+$$

L1 - L4 und L5 - L8 steht jeweils unabhängig für einen neutralen oder geladenen Liganden, insbesondere für einen einzähnigen oder mehrzähnigen Liganden. Die Liganden L1 - L8 müssen dabei so gewählt werden, dass die jeweils erforderliche Gesamtladung des Komplexes erhalten bleibt. Die in einer Metall-Komplex-Kombination mit L1 bis L8 sowie L1' bis L8' bezeichneten Liganden sind nicht zwingend identisch mit den in einer anderen Kombination ebenfalls mit L1 bis L8 sowie L1' bis L8' benannten Liganden.

**Definition der Liganden und Reste**

L1 bis L4, L5 bis L8, L9 bis L12 sowie L1' bis L12' steht jeweils unabhängig für einen neutralen oder geladenen Liganden, insbesondere für einen einzähnigen oder mehrzähnigen Liganden. Die Liganden L1 bis L12 müssen dabei so gewählt werden, dass die jeweils erforderliche Gesamtladung des Komplexes erhalten bleibt. Für alle hierin beschriebenen Ausführungsformen ist eine Solubilisierung der Doppelkomplexsalze besonders bevorzugt. Besonders bevorzugt weist deshalb wenigstens einer der Liganden zur Erhöhung der Solubilisierbarkeit eine große organische Gruppe auf, insbesondere eine oder mehrere Alkylgruppen mit 1 bis 40 C-Atomen, vorzugsweise mit 1 bis 20 C-Atomen, oder/und eine oder mehrere Polysiloxangruppen $(-OSiR_2)_n-OSiR'_3$ mit n = 1-200, insbesondere n = 5-30 oder/und eine oder mehrere Polyethergruppen, insbesondere $(-OCH_2)_n-OR$ oder $(-OCH_2CH_2)_n-OR$ mit n = 1-200, insbesondere n = 2-30, wobei R wie hierin definiert ist und R' die für R angegebenen Bedeutungen haben kann, es sich bei R und R' aber bevorzugt um $C_1$-$C_6$ Alkylgruppen handelt.

Soweit hierin verwendet, handelt es sich bei den Liganden NL1-NL4 um neutrale einzähnige Liganden. Bevorzugte neutrale Liganden sind ausgewählt aus Kohlenmonoxid, Isonitrilen, wie z. B. *tert*-Butyl-isonitril, Cyclohexylisonitril, Adamantylisonitril, Phenylisonitril, Mesitylisonitril, 2,6-Dimethylphenylisonitril, 2,6-Di-iso-propylphenylisonitril, 2,6-Di-tert-butylphenylisonitril, Aminen, wie z. B. Trimethylamin, Triethylamin, Morpholin, Phosphinen, wie z. B. Trifluorphosphin, Trimethylphosphin, Tricyclohexylphosphin, Tri-*tert*-butylphosphin, Triphenylphosphin, Tris(pentafluorphenyl)phosphin, Phosphiten, wie z. B. Trimethylphosphit, Triethylphosphit, Arsinen, wie z. B. Trifluorarsin, Trimethylarsin, Tricyclohexylarsin, Tri-*tert*-butylarsin, Triphenylarsinin, Tris(pentafluorphenyl)arsin, Stibinen, wie z. B. Trifluorstibin, Trimethylstibin, Tricyclohexylstibin, Tri-*tert*-butylstibin, Triphenylstibin, Tris(pentafluorphenyl)stibin, und stickstoffhaltigen Heterocyclen, wie z. B. Pyridin, Pyridazin, Pyrazin, Pyrimidin, Triazin. Beispielsweise können auch Nitrile oder Isonitrile verwendet

werden, die mit einer großen organischen Gruppe R' bzw. R" (R' und R" definiert wie R1-R20) substituiert sind. Als neutrale Liganden kommen aber auch Verbindungen in Frage, die über N, P, S, O, As oder Se koordinieren.

Soweit hierin verwendet stellen die Liganden AL1-AL4 anionische einzähnige Liganden. Bevorzugte anionische Liganden sind ausgewählt aus Hydrid, Deuterid, den Halogeniden F, Cl, Br und I, Alkylacetyliden, wie z. B. Methyl-$C{\equiv}C^-$, tert-Butyl-$C{\equiv}C^-$, Arylacetyliden, wie z. B. Phenyl-$C{\equiv}C^-$, Cyanid, Cyanat, Isocyanat, Thiocyanat, Isothiocyanat, aliphatischen oder aromatischen Alkoholaten, wie z. B. Methanolat, Ethanolat, Propanolat, *iso*-Propanolat, *tert*-Butylat, Phenolat, aliphatischen oder aromatischen Thioalkoholaten, wie z. B. Methanthiolat, Ethanthiolat, Propanthiolat, *iso*-Propanthiolat, *tert*-Thiobutylat, Thiophenolat, Amiden, wie z. B. Dimethylamid, Diethylamid, Di-*iso*-propylamid, Morpholid, Carboxylaten, wie z. B. Acetat, Trifluoracetat, Propionat, Benzoat, und anionischen, stickstoffhaltigen Heterocyclen, wie Pyrrolid, Imidazolid, Pyrazolid. Dabei sind die Alkylgruppen in diesen Gruppen bevorzugt $C_1$-$C_{20}$-Alkylgruppen, besonders bevorzugt $C_1$-$C_{10}$-Alkylgruppen, ganz besonders bevorzugt $C_1$-$C_4$-Alkylgruppen. Unter einer Arylgruppe werden auch Heteroarylgruppen verstanden. Weiterhin möglich sind Arylgruppen, Alkenylgruppen oder borate.

α-Diimin-Liganden, wie hierin verwendet, können sowohl aus Fünf- oder Sechsringen bestehen, deren Bestandteile Z1-Z12 entweder die Fragmente CR(X) (R(X) = siehe Definition von R1-R20) oder N sind, E kann entweder NR, O oder S sein. Diese Definition beinhaltet auch die Möglichkeit, dass die Einheiten **A** und **B** keinen Zyklus bilden, sondern offenkettig sind. ("#" kennzeichnet das Atom, das mit der zweiten Einheit verbunden ist):

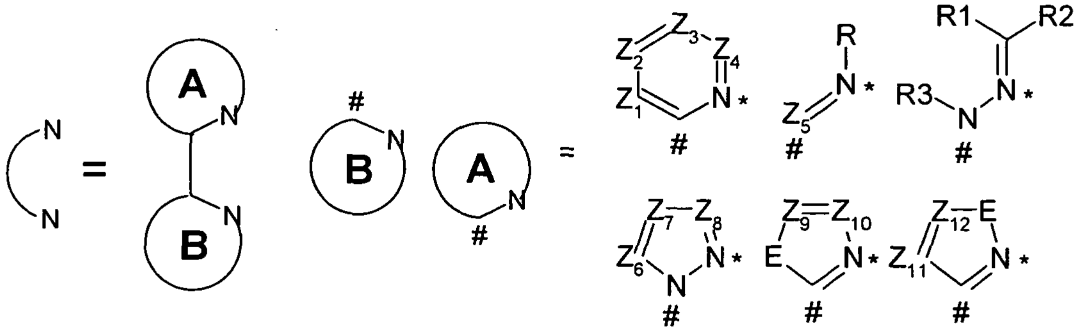

Soweit hierin verwendet, bedeutet der Begriff des Carben-Liganden insbesondere:

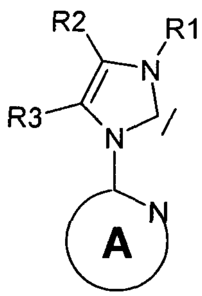

Cyclometallierende Liganden, soweit hierin verwendet, sind zweizähnige, einfach negativ geladene Liganden, die

1) einerseits über ein $sp^2$-Kohlenstoff- und andererseits über ein Stickstoffatom binden. Die Einheiten **A** und **B** können sowohl aus Fünf- oder Sechsringen bestehen, als auch offenkettig sein. Die Bestandteile Z1-Z26 bestehen entweder aus dem Fragment CR(X) (R(X) = organischer Rest definiert wie R1-R20) oder N, E kann entweder NR, O oder S sein. ("*" kennzeichnet das Atom, das die Komplexbindung eingeht, "#" das Atom, das mit der zweiten Einheit verbunden ist):

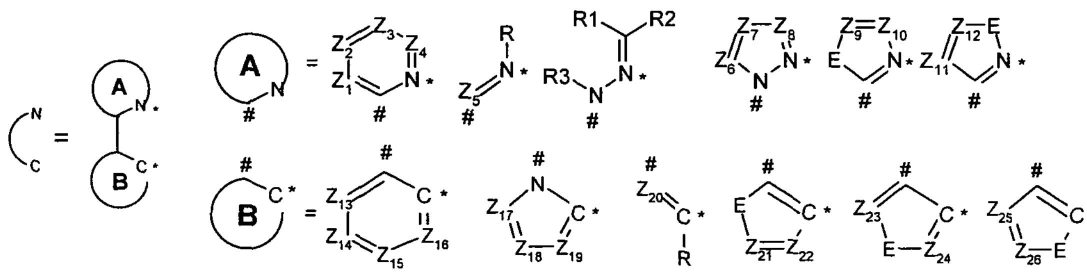

2) einerseits über ein $sp^2$- und andererseits über ein Carben-Kohlenstoffatom bindet. Die Einheit **B** kann aus einem Fünf- oder Sechsring bestehen, aber auch offenkettig sein. Die Bestandteile Z13-Z26 bestehen entweder aus dem Fragment CR(X) (R(X) = organischer Rest wie R1-R20, s.u.) oder N, E kann NR, O oder S sein. ("*" kennzeichnet das Atom, das die Komplexbindung eingeht, "#" das Atom, das mit dem zweiten Ring verbunden ist):

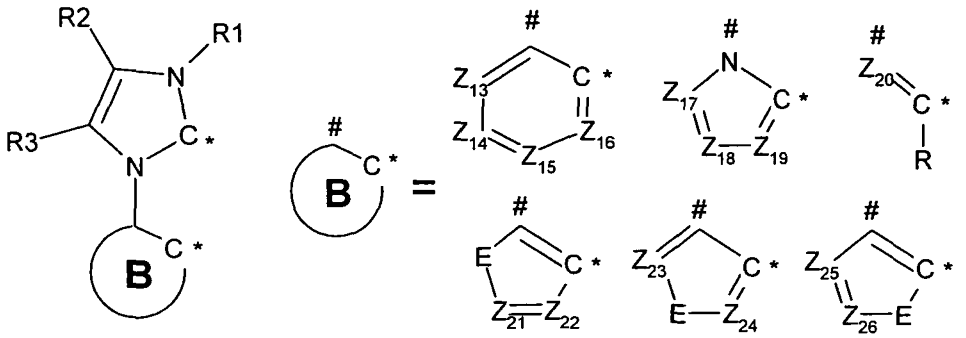

In den hierin angegebenen Formeln handelt es sich bei R1-R20, R, R' und R" um Gruppen, die identisch oder voneinander unabhängig sein können. Diese Gruppen sind insbesondere ausgewählt aus: H, Deuterium, F, Cl, Br, I, $N(R^{21})_2$, CN, $NO_2$, $Si(R^{21})_3$, $B(OR^{21})_2$, $C(=O)R^{21}$, $P(=O)(R^{21})_2$, $S(=O)R^{21}$, $S(=O)_2R^{21}$, $OSO_2R^{21}$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^{21}$ substituiert sein kann, wobei eine oder mehrere nicht benachbarte $CH_2$-Gruppen durch $R^{21}C=CR^{21}$, C=C, $Si(R^{21})_2$, $Ge(R^{21})_2$, $Sn(R^{21})_2$, C=O, C=S, C=Se, $C=NR^{21}$, $P(=O)(R^{21})$, SO, $SO_2$, $NR^{21}$, O, S oder $CONR^{21}$ ersetzt sein können und wobei ein oder mehrere H-Atome durch F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^{21}$ substituiert sein kann, oder eine Aryloxy- oder Heteroaryloxygruppe mit 5 bis 60 aromatischen Ringatomen, die durch einen oder mehrere Reste $R^{21}$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^{21}$ substituiert sein kann, oder eine Kombination dieser Systeme; dabei können zwei oder mehrere dieser Substituenten auch miteinander ein mono- oder polycyclisches, aliphatisches, aromatische und/oder benzoannelliertes Ringsystem bilden;

$R^{21}$ ist bei jedem Auftreten gleich oder verschieden H, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten $R^{21}$ auch miteinander ein mono- oder polycyclisches, aliphatisches oder aromatisches Ringsystem bilden.

Um die Löslichkeit zu gewährleisten, sind bevorzugt langkettige, auch verzweigte Alkylketten ($C_1$-$C_{30}$) und kurzkettige Polyether [z.B. Polymere $(-OCH_2CH_2O-)_n$, n < 500]. Die Alkylketten können auch mit polaren Gruppen modifiziert werden, z. B. mit Alkoholen, Aldehylden, Aminen, Carbonsäuren, Ethern, Phosphorsäureestern, Phosphonsäuren, die eine weitere Erhöhung der Löslichkeit ermöglichen.

R(X) steht hierin für organische Gruppen (analog zu der Definition von R1-R20), die identisch oder voneinander unabhängig sein können. X ist eine laufende Ziffer und dient zur Nummerierung des Restes R (z.B. R(1), R(2), ...) . Die organischen Gruppen können insbesondere ausgewählt werden aus den Gruppen wie oben für R1 bis R20 beschrieben.

Alkylreste, wie hierin beschrieben, bedeuten insbesondere $C_1$-$C_{30}$, bevorzugt $C_1$-$C_{20}$-Alkylreste, besonders bevorzugt $C_1$-$C_6$. Alkylreste können auch einen Zyklus bilden.

Alkenyl- und Alkinylreste weisen vorzugsweise 2 bis 30, insbesondere 2 bis 20 C-Atome auf, besonders bevorzugt 2 bis 8.

Arylgruppen sind vorzugsweise Systeme mit 5 bis 30, insbesondere 5 bis 10 Ringatomen, wobei bevorzugt 0 bis 4 Heteroatome, ausgewählt aus O, N, P oder/und S enthalten sind.

Die oben allgemein definierten Liganden-Einheiten A und/oder B der $\alpha$-Diimin-Liganden, Carben-Liganden und cyclometallierenden Liganden können auch mit NL und / oder AL verbrückt sein.

**Tabelle 1**

| Einige Beispiele von erfindungsgemäß in OLEDs einsetzbaren Doppelkomplex-Salzen | | |
|---|---|---|
| Verbindung | Absorption [nm] | Emission [nm] |
| $[Pt(bpy)_2][Pt(CN)_4]$ rot-oranqe | 330, 520 (dr) | 620 |
| $[Pt(bpy)_2][Pt(CN)_4]$ x 2 $H_20$ gelb-orange | 485 (dr) | 570 |
| $[Pt(phen)_2][Pt(CN)_4]$ violett | 310, 380, 550 (dr) | 650 |
| $[Pt(phen)_2][Pt(CN)_4]$ x $H_2O$ violett | bis in den gelben Spektralbereich | 628 |
| $[Pt(bpy)(en)][Pt(CN)_4]$ hell-gelb | 330, 450 (dr) | 560 |
| $[Pt(phen)(en)][Pt(CN)_4]$ hell-qelb | 310, 430 (dr) | 560 |
| [Pt(4,4'-Dimethyl-2,2'-dipyridyl)$_2$][Pt(CN)$_4$] | 354, 418, 474 | 544 |
| (dr) diffuse-reflectance | | |

**Tabelle 2**

| Einige konkrete Beispiele neuer Doppelkomplex-Salze, -Kombinationen, -Dotierunqen |
|---|
| Verbindung |
| $[Pd(bpy)_2][Pt(CN)]_4$ |
| $[Pt(bpy)_2][Pd(CN)]_4$ |
| $[Pd(bpy)_2][Pd(CN)]_4$ |
| $[Pd(phen)_2][Pt(CN)_4]$ |
| $[Pt(phen)_2][Pd(CN)_4]$ |
| $[Pd(phen)_2][Pd(CN)_4]$ |
| $\{[Pd(bpy)_2][Pd(CN)_4]_{1-x}[Pt(CN)_4]_x\}$; $0.00001 \leq x \leq 0.99999$ |
| $\{[Pd(bpy)_2][Pt(CN)_4]_{1-x}[Pd(CN)_4]_x\}$; $0.00001 \leq x \leq 0.99999$ |
| $\{[Pt(bpy)_2][Pd(CN)_4]_{1-x}[Pt(CN)_4]_x\}$; $0.00001 \leq x \leq 0.99999$ |
| $\{[Pt(bpy)_2][Pt(CN)_4]_{1-x}[Pd(CN)_4]_x\}$; $0.00001 \leq x \leq 0.99999$ |
| $\{[Pd(CNR)_4][Pd(CN)_4]_{1-x}[Pt(CN)_4]_x\}$; $0.00001 \leq x \leq 0.99999$ |
| $\{[Pd(CNR)_4][Pt(CN)_4]_{1-x}[Pd(CN)_4]_x\}$; $0.00001 \leq x \leq 0.99999$ |
| $\{[Pt(CNR)_4][Pd(CN)_4]_{1-x}[Pt(CN)_4]_x\}$; $0.00001 \leq x \leq 0.99999$ |
| $\{[Pt(CNR)_4][Pt(CN)_4]_{1-x}[Pd(CN)_4]_x\}$; $0.00001 \leq x \leq 0.99999$ |
| $[Pd(CNR)_4][Pt(CN)_4]$ |
| $[Pt(CNR)_4][Pd(CN)_4]$ |
| $[Pt(CNR)_4][Pt(CN)_4]$ |
| $[Pd(CNR)_4][Pd(CN)_4]$ |
| $[Pt(bpy)(en)][Pd(CN)_4]$ |
| $[Pd(bpy)(en)][Pt(CN)_4]$ |

(fortgesetzt)

| Einige konkrete Beispiele neuer Doppelkomplex-Salze, -Kombinationen, -Dotierunqen |
|---|
| Verbindung |
| $[Pd(bpy)(en)][Pd(CN)_4]$ |
| $[Pt(phen)(en)][Pd(CN)_4]$ |
| $[Pd(phen)(en)][Pt(CN)_4]$ |
| $[Pd(phen)(en)][Pd(CN)_4]$ |
| $[Pt(CNCH_3)_4][Pd(CN)_4]$ |
| $[Pd(CNCH_3)_4][Pt(CN)_4]$ |
| $[Pt(CNCH_3)_4][Pt(CN)_4]$ |
| $[Pd(CNCH_3)_4][Pd(CN)_4]$ |
| $[Pt(CNC_2H_5)_4][Pd(CN)_4]$ |
| $[Pd(CNC_2H_5)_4][Pt(CN)_4]$ |
| $[Pt(CNC_2H_5)_4][Pt(CN)_4]$ |
| $[Pd(CNC_2H_5)_4][Pd(CN)_4]$ |
| $[Pt(CN\text{-}t\text{-}C_4H_9)_4][Pd(CN)_4]$ |
| $[Pd(CN\text{-}t\text{-}C_4H_9)_4][Pt(CN)_4]$ |
| $[Pt(CN\text{-}t\text{-}C_4H_9)_4][Pt(CN)_4]$ |
| $[Pd(CN\text{-}t\text{-}C_4H_9)_4][Pd(CN)_4]$ |
| $[Pt(CN\text{-}cyclododecyl)_4][Pd(CN)_4]$ |
| $[Pd(CN\text{-}cyclododecyl)_4][Pt(CN)_4]$ |
| $[Pt(CN\text{-}cyclododecyl)_4][Pt(CN)_4]$ |
| $[Pd(CN\text{-}cyclododecyl)_4][Pd(CN)_4]$ |
| $[Pt(phen)(CN\text{-}cyclohexyl)_2][Pd(CN)_4]$ |
| $[Pd(phen)(CN\text{-}cyclohexyl)]_2][Pt(CN)_4]$ |
| $[Pt(phen)(CN\text{-}cycloheyl)_2][Pt(CN)_4]$ |
| $[Pd(phen)(CN\text{-}cycloheyl)_2][Pd(CN)_4]$ |
| $[Pt(CN\text{-}n\text{-}tetradecyl)_4][Pd(CN)_4]$ |
| $[Pd(CN\text{-}n\text{-}tetradecyl)_4][Pt(CN)_4]$ |
| $[Pt(CN\text{-}n\text{-}tetradecyl)_4][Pt(CN)_4]$ |
| $[Pd(CN\text{-}n\text{-}tetradecyl)_4][Pd(CN)_4]$ |
| $\{[Pt(phen)(CN\text{-}cyclododecyl)Cl]_2[Pt(phen)(CN\text{-}cyclododecyl)_2]_2Pd(CN)_4]_3\}$ |
| $\{[Pd(phen)(CN\text{-}cyclododecyl)Cl]_2[Pd(phen)(CN\text{-}cyclododecyl)_2]_2[Pt(CN)_4]_3\}$ |
| $\{[Pt(phen)(CN\text{-}cyclododecyl)Cl]_2[Pd(phen)(CN\text{-}cyclododecyl)_2]_2[Pt(CN)_4]_3\}$ |
| $\{[Pd(phen)(CN\text{-}cyclododecyl)Cl]_2[Pt(phen)(CN\text{-}cyclododecyl)_2]_2[Pt(CN)_4]_3\}$ |
| $\{[Pt(phen)(CN\text{-}cyclododecyl)Cl]_2[Pd(phen)(CN\text{-}cyclododecyl)_2]_2[Pd(CN)_4]_3\}$ |
| $\{[Pd(phen)(CN\text{-}cyclododecyl)Cl]_2[Pt(phen)(CN\text{-}cyclododecyl)_2]_2[Pd(CN)_4]_3\}$ |
| $\{[Pt(phen)(CN\text{-}cyclododecyl)Cl]_2[Pt(phen)(CN\text{-}cyclododecyl)_2]_2[Pt(CN)_4]_3\}$ |
| $\{[Pd(phen)(CN\text{-}cyclododecyl)Cl]_2[Pd(phen)(CN\text{-}cyclododecyl)_2]_2[Pd(CN)_4]_3\}$ |
| $[Pt(p\text{-}CN\text{-}C_6H_4\text{-}C_{10}H_{21})_4][Pd(CN)_4]$ |

(fortgesetzt)

| Einige konkrete Beispiele neuer Doppelkomplex-Salze, -Kombinationen, -Dotierunqen |
|---|
| Verbindung |
| [Pd(*p*-CN-$C_6H_4$-$C_{10}H_{21}$)$_4$][Pt(CN)$_4$] |
| [Pt(*p*-CN-$C_6H_4$-$C_{10}H_{21}$)$_4$][Pt(CN)$_4$] |
| [Pd(*p*-CN-$C_6H_4$-$C_{10}H_{21}$)$_4$][Pd(CN)$_4$] |
| [Pt(*p*-CN-$C_6H_4$-$CH_3$)$_4$][Pd(CN)$_4$] |
| [Pd(*p*-CN-$C_6H_4$-$CH_3$)$_4$][Pt(CN)$_4$] |
| [Pt(*p*-CN-$C_6H_4$-$CH_3$)$_4$][Pt(CN)$_4$] |
| [Pd(*p*-CN-$C_6H_4$-$CH_3$)$_4$][Pd(CN)$_4$] |
| [Pt(*p*-CN-$C_6H_4$-$C_6H_{13}$)$_4$][Pd(CN)$_4$] |
| [Pd(*p*-CN-$C_6H_4$-$C_6H_{13}$)$_4$][Pt(CN)$_4$] |
| [Pt(*p*-CN-$C_6H_4$-$C_6H_{13}$)$_4$][Pt(CN)$_4$] |
| [Pd(*p*-CN-$C_6H_4$-$C_6H_{13}$)$_4$][Pd(CN)$_4$] |
| [Pt(*p*-CN-$C_6H_4$-$C_{10}H_{21}$)$_4$][Pd(CN)$_4$] |
| [Pd(*p*-CN-$C_6H_4$-$C_{10}H_{21}$)$_4$][Pt(CN)$_4$] |
| [Pt(*p*-CN-$C_6H_4$-$C_{10}H_{21}$)$_4$][Pt(CN)$_4$] |
| [Pd(*p*-CN-$C_6H_4$-$C_{10}H_{21}$)$_4$][Pd(CN)$_4$] |
| [Pt(*p*-CN-$C_6H_4$-$C_{12}H_{25}$)$_4$][Pd(CN)$_4$] |
| [Pd(*p*-CN-$C_6H_4$-$C_{12}H_{25}$)$_4$][Pt(CN)$_4$] |
| [Pt(*p*-CN-$C_6H_4$-$C_{12}H_{25}$)$_4$][Pt(CN)$_4$] |
| [Pd(*p*-CN-$C_6H_4$-$C_{12}H_{25}$)$_4$][Pd(CN)$_4$] |
| [Pt(*p*-CN-$C_6H_4$-$C_{14}H_{29}$)$_4$][Pd(CN)$_4$] |
| [Pd(*p*-CN-$C_6H_4$-$C_{14}H_{29}$)$_4$][Pt(CN)$_4$] |
| [Pt(*p*-CN-$C_6H_4$-$C_{14}H_{29}$)$_4$][Pt(CN)$_4$] |
| [Pd(*p*-CN-$C_6H_4$-$C_{14}H_{29}$)$_4$][Pd(CN)$_4$] |
| CNR bezeichnet gängige Isonitril-Liganden. |

Die hierin beschriebenen Oligomere eignen sich hervorragend zur Verwendung in opto-elektronischen Bauelementen, insbesondere von OLEDs. Bei der Fertigung von OLEDs können alle hierin beschriebenen Oligomere bzw. Kolumnarstrukturen verwendet werden. Durch geeignete Wahl der Oligomere kann die jeweils gewünschte Emissionsfarbe erzielt werden. Zur Erreichung einer blauen Emission werden bevorzugt dotierte Oligomere eingesetzt.

Wegen der entgegengesetzten Ladungen des erfindungsgemäß eingesetzten Metallkomplexes führt die elektrostatische Wechselwirkung (Ionenbindung) zu einer ausgeprägten Stabilisierung der M-M-Bindung, worauf u.a. die sehr schlechte Löslichkeit derartiger Verbindungen zurückzuführen ist. Diese Tatsache vereinfacht zwar die Synthese wesentlich, da bei der Vereinigung der jeweils löslichen Komponenten die Doppelkomplex-Salze meist augenblicklich ausfallen. Dadurch werden aber eine eingehendere Analytik sowie verschiedene Anwendungen erschwert. Da üblicherweise für Salze wegen ihrer geringen Flüchtigkeit eine Vakuumsublimation nicht in Frage kommt, bleiben zur Erzeugung dünner Schichten, wie sie für OLEDs erforderlich sind, nass-chemische Verfahren (z.B. Spin-Coating, Drucken). Diese erfordern ihrerseits aber eine gewisse Löslichkeit der Verbindungen. Das gilt allerdings nicht, falls die Doppelkomplex-Salze als Dispersionen eingesetzt werden oder falls das Verfahren der Eindiffusion gewählt wird. (Siehe die Ausführungen unter "Verarbeitung der Doppelkomplexsalze in OLEDs".)

Lumineszierende Platin-Doppelkomplex-Salze der allgemeinen Form $[L1L2L3L4Pt]^{2+}[Pt(AL1)_4]^{2-}$ sind im allgemeinen unlöslich. In diesem Beispiel sind die Liganden L1-L4 neutral, L1-L4 können auch miteinander verbunden sein, d.h. mehrzähnige Liganden bilden. Dabei bilden sie Komplexe, die z. B. entweder a) einen zweizähnigen und zwei

einzähnige Liganden, b) zwei zweizähnige Liganden, c) einen dreizähnigen und einen einzähningen Liganden oder d) einen vierzähnigen Liganden enthalten. Zum Beispiel kann es sich bei den neutralen Liganden um $\alpha$-Diimine, wie 2,2'-Bipyridin oder 1,10-Phenanthrolin, und bei AL1 um ein Cyanid-, Chlorid-, Bromid- oder Iodid-Ion handeln. Wegen ihrer herausragenden photophysikalischen Eigenschaften sind gemäß dieser Erfindung diese Doppelkomplex-Salze gute Kandidaten für optoelektronische Anwendungen (OLEDs).

Solubilisierung als Verarbeitungstechnik

Überraschenderweise lassen sich nun Doppelkomplex-Salze so modifizieren, dass sie entweder als Oligomere oder in polaren Lösungsmitteln auch als Ionen in Lösung gehen. Der Gegenstand dieser Erfindung macht sich dabei zu Nutze, dass die Bindungen innerhalb der Komplexstapel aufgrund der M-M-Wechselwirkungen zwar stark sind, zwischen diesen Stapeln aber im Wesentlichen nur schwache van-der-Waals Wechselwirkungen vorliegen. Durch eine Substitution an der Peripherie der Liganden durch große organische Reste R werden die M-M-Wechselwirkungen überraschenderweise nicht behindert, aber die Anordnung der verschiedenen Kolumnen so gestört, so dass sie sich nicht mehr problemlos als Kristallgitter ordnen. Dabei kann die Substitution an den positiv geladenen Komplexen oder auch an den negativ geladenen Bausteinen durchgeführt werden. Auch eine Substitution an beiden ist möglich. Damit ist eine Löslichkeit erreichbar. Die hierin angegebenen Beispiele sollen die für die Anwendung in opto-elektronischen Anordnungen zu schützenden Bauprinzipien verdeutlichen, ohne die Allgemeingültigkeit des Konzepts einzuschränken.

Die Oligomere gemäß der vorliegenden Erfindung können auch in Kombination mit einem Matrixmaterial eingesetzt werden. Als Matrixmaterial kommen verschiedene Materialien in Frage, wie sie gemäß dem Stand der Technik als Matrixmaterialien für phosphoreszierende Verbindungen verwendet werden. Geeignete Matrixmaterialien sind aromatische Ketone, aromatische Phosphinoxide oder aromatische Sulfoxide oder Sulfone, z. B. gemäß WO 04/013080, WO 04/093207, WO 06/005627 oder der nicht offen gelegten Anmeldung DE 102008033943.1, Triarylamine, Carbazolderivate, z. B. CBP (N,N-Biscarbazolylbiphenyl) oder die in WO 05/039246, US 2005/0069729, JP 2004/288381, EP 1205527 oder WO 08/086851 offenbarten Carbazolderivate, Indolocarbazolderivate, z. B. gemäß WO 07/063754 oder WO 08/056746, Azacarbazolderivate, z. B. gemäß EP 1617710, EP 1617711, EP 1731584, JP 2005/347160, bipolare Matrixmaterialien, z. B. gemäß WO 07/137725, Silane, z. B. gemäß WO 05/111172, Azaborole oder Boronester, z. B. gemäß WO 06/117052, Triazinderivate, z. B. gemäß der nicht offen gelegten Anmeldung DE 102008036982.9, WO 07/063754 oder WO 08/056746, Zinkkomplexe, z. B. gemäß EP 652273 oder WO 09/062578, Diazasilol- bzw. Tetraazasilol-Derivate, z. B. gemäß der nicht offen gelegten Anmeldung DE 102008056688.8, Diazaphosphol-Derivate, z. B. gemäß der nicht offen gelegten Anmeldung DE 102009022858.6, oder Indenocarbazolderivate, z. B. gemäß den nicht offen gelegten Anmeldungen DE 102009023155.2 und DE 102009031021.5.

Zum Beispiel lassen sich in einem typischen OLED-Schichtaufbau, bestehend aus einer ITO-Anode, einem Lochleiter (z. B. aus PEDOT/ PSS), der erfindungsgemäßen Emitterschicht, gegebenenfalls einer Lochblockierschicht, einer Elektronenleiterschicht, einer dünnen LiF- oder CsF-Zwischenschicht zur Verbesserung der Elektroneninjektion sowie einer Metallelektrode (Kathode) gute Leistungseffizienzen erzielen. Diese verschiedenen Schichten mit einer Gesamtdicke von einigen 100 nm lassen sich z. B. auf einem Glassubstrat oder einem sonstigen Trägermaterial aufbringen. Ein entsprechendes Muster-Device ist in Abbildung 3 dargestellt.

**1.** Als Trägermaterial kann Glas oder jedes andere geeignete feste oder flexible durchsichtige Material verwendet werden.

2. ITO = Indium-Zinn-Oxid

3. PEDOT/PSS = Poly-ethylendioxythiophen/Polystyrolsulfonsäure Hierbei handelt es sich um ein Lochleitermaterial (HTL = *hole transport layer*), das wasserlöslich ist.

4. Emitterschicht, häufig mit EML abgekürzt, mit erfindungsgemäßen Emittersubstanzen. Die Verbindungen können z.B. in organischen Lösungsmitteln gelöst werden, und zwar durch Verwendung der durch geeignete chemische Solubilisierung löslich gemachten Komplex-Bausteine (Verfahren **A**) oder durch Einmischen/ Einschwemmen der Doppelkomplex-Salz-Dispersion (Verfahren **B**) oder durch die Technik der Eindiffusion (Verfahren C). Durch die Wahl geeigneter organischer Lösungsmittel kann ein Auflösen der darunter liegenden PEDOT/PSS-Schicht vermieden werden. Besonders bevorzugt betragen die hierin aufgeführten Oligomere/ Kolumnarstrukturen je nach Anwendung 5 Gew.-% bis 100 Gew.-% in dieser Schicht. Die erfindungsgemäßen nicht-solubilisierbaren Oligomere/Kolumnar-Strukturen können auch als Dispersionen in einem Emitter-Matrixmaterial (z.B. PVK = Polyvinylcarbazol oder CBP = 4,4'-Bis(9-carbazolyl)biphenyl) eingebracht werden. Sie können aber auch als 100 % Schicht in Form einer Dispersion aufgetragen werden. Diese fertigungstechnische Variante kann eingesetzt werden, wenn die Oligomere/Kolumnarstrukturen nicht ausreichend löslich oder sogar unlöslich sind.

5. ETL = Elektronentransportmaterial (ETL = *electron transport layer*). Beispielsweise kann das aufdampfbare $Alq_3$ verwendet werden. Dicke z.B. 40 nm.

6. Die sehr dünne Zwischenschicht aus z.B. CsF oder LiF verringert die Elektroneninjektionsbarriere und schützt

die ETL-Schicht. Diese Schicht wird in der Regel aufgedampft. Für einen weiter vereinfachten OLED-Aufbau können gegebenenfalls die ETL- und die CsF-Schicht entfallen.

7. Die leitende Kathodenschicht wird aufgedampft. Al repräsentiert ein Beispiel. Es können auch Mg:Ag (10:1) oder andere Metalle verwendet werden.

Die am Device anliegende Spannung beträgt z. B. 3 bis 15 V.

Ein weiterer Aspekt der Erfindung ist eine opto-elektronische Vorrichtung, insbesondere eine lichtemittierende Vorrichtung umfassend (i) eine Anode, (ii) eine Kathode und (iii) eine Emitterschicht, angeordnet zwischen und in direktem oder indirektem Kontakt mit der Anode oder Kathode, umfassend wenigstens ein Oligomer wie hierin definiert.

Die erfindungsgemäßen opto-elektronischen Vorrichtungen werden nasschemisch gefertigt.

**Verarbeitung der Doppelkomplex-Salze in OLEDs**

Die Verarbeitung/Verwendung der Doppelkomplex-Salze in den optischrelevanten Schichten, d.h. der Emissionsschicht im OLED, ist nicht offensichtlich (einfach) da die Doppelkomplex-Salze sehr schwer bzw. gar nicht löslich sind. Überraschenderweise gelingt es nun, in drei verschiedenen Vorgehensweisen die Materialien in opto-elektronischen Bauelementen zu verarbeiten:

Solubilisierung:

Durch eine Solubilisierung der Baukomponenten werden die Salze gut löslich, behalten aber dennoch die günstigen optischen Eigenschaften. Das gelingt, indem mindestens für eine der organischen Gruppen an den Liganden eine spezielle Ausführungsform gewählt wird. Insbesondere können, um die Löslichkeit zu gewährleisten, bevorzugt langkettige - auch verzweigte - Alkylketten ($C_1$-$C_{30}$) und kurzkettige Polyether [z.B. Polymere $(-OCH_2CH_2O-)_n$, n < 500]. verwendet werden. Die Alkylketten können auch mit polaren Gruppen modifiziert werden, z.B. mit Alkoholen, Aldehylden, Aminen, Carbonsäuren, Ethern, Phosphorsäureestern, Phosphonsäuren, die eine weitere Erhöhung der Löslichkeit ermöglichen.

Dispersionen:

Für den erfindungsgemäßen Einsatz der Doppelkomplex-Salze, die schlecht oder unlöslich sind, kann das Auftragen in Form von Dispersionen - bevorzugt Nano-Dispersionen - vorgenommen werden. Dabei können kolloidale Nano-Dispersionen der Doppelkomplex-Salze in eine PolymerLösung eingemischt bzw. eingeschwemmt aufgetragen werden. Die Konzentration der Doppelkomplex-Salze im Polymer beträgt 2 bis 10 Gew.-% oder 10 bis 90 Gew.-%. Es besteht jedoch auch die Möglichkeit, die reinen Doppelkomplex-Salze (d. h. ohne Polymer) als Nano- Dispersionen - dispergiert in einen geeigneten Medium - aufzutragen und somit nach Abdampfen des Mediums 100 % Emitterschichten zu realisieren. Falls erforderlich, können die Doppelkomplex-Salze vor der Einbringung in das/die Polymer/e unter Ultraschallbearbeitung nach dem Fachmann geläufigen Methoden in flüssiger Phase dispergiert werden werden. Daneben können die Doppelkomplex-Salze unter Einwirkung von Ultraschall, durch Einbringung der ersten Komponente und Hinzugabe der zweiten, dritten, ... Komponente, erzeugt werden. Gegebenenfalls kann eine Oberflächenmodifikation der Nanopartikel durch Zusatz von dem Fachmann bekannten Dispergatoren erfolgen. Je nach Wahl des oder der Dispergatoren kann die Stabilisierung der Nano-Dipersion sterischer, elektrischer oder elektro-sterischer Natur sein. Besonders geeignete Dispergatoren sind aliphatische, aromatische oder heteroaromatische Amine, Phosphine, Sulfide, Sulfoxide, Sulfonsäuren, Carbonsäuren, Aminocarbonsäuren und Thiocarbonsäuren. In einer besonderen Ausführungsform können zu den erfindungsgemäßen Doppelkomplex-Salzen Komplexsalze die lösungsvermittelnde Gruppen tragen, wie die oben genannte Verbindung $[Pt(4,4'\text{-Dinonyl-}2,2'\text{-dipyridyl})_2][BF_4]_2$ als Dispergatoren eingesetzt werden. Die nanodispersen Doppelkomplexsalze werden dann bevorzugt nach einer Filterung durch Mikro-/Nanofilter in das Polymer eingebracht, um verbliebene gröbere Partikel zu entfernen. Dies gilt auch für die Auftragung als 100 % Emitterschicht.

C Diffusionsverfahren

Für den erfindungsgemäßen Einsatz der nicht oder schlecht löslichen Oligomere/Kolumnarstrukturen eignet sich das neue, hier erstmals vorgeschlagene Diffusionsverfahren, bei der Erstellung der Emissionsschichten. Zunächst wird eine der im allgemeinen löslichen Komponenten der Doppelkomplex-Salze in die optisch-relevante Polymer-Schicht eingebracht. Die zweite Komponente wird dann auf diese Schicht aufgebracht. Durch Diffusion durch die Polymer-Schicht wandert die zweite Komponente zur ersten Komponente und bildet dort das unlösliche Oligomer. Durch Abwaschen der zweiten Komplex-Salz-Komponente wird das Verfahren abgestoppt, wenn die gewünschte Doppelkomplex-SalzKonzentration erreicht ist.

**Vorteile der Erfindung für OLEDs durch Verwendung von kolumnarstruktur-bildenden Doppelkomplex-Salzen:**

Oben wurden die Probleme, die bei der Realisierung effizienter OLEDs auftreten, bereits aufgeführt. Nun ist es gelungen, durch die Verwendung der oben ausführlich besprochenen Metallkomplexe eine gezielte Veränderung der Emissionseigenschaften zu erreichen, wodurch viele dieser Nachteile nicht mehr auftreten. Verglichen mit den in herkömmlichen OLEDs verwendeten Emittermaterialien ergeben sich bei der Verwendung der erfindungsgemäßen Oligomere/Kolumnarstrukturen folgende Vorteile:

i) Durch die Möglichkeit der Variation der M-M-Abstände in den Oligomeren/Kolumnarstrukturen sowie durch die Möglichkeit der Variation der durchschnittlichen Kettenlänge dieser Oligomere/ Kolumnarstrukturen lassen sich die Emissionswellenlängen nahezu beliebig steuern, und zwar vom blauen bis in den roten Spektralbereich.
ii) Man kann auf einfache Art und Weise eine blaue Emission erzielen, wenn man sich des oben bereits erläuterten Konzepts der Dotierung von Kolumnarstrukturen bedient (z. B. Pt-Komplexe in geringer Konzentration in Oligomere/Kolumnarstrukturen die aus Pd-Komplexen aufgebaut sind).
iii) Darüber hinaus ist die Emissionslebensdauer der Doppelkomplex-salz-Stapel kurz, was eine sehr wichtige Anforderung an OLEDs darstellt.
iv) Bei der Verwendung der hier aufgeführten Oligomere/Kolumnarstrukturen ist es möglich, hohe Stromdichten zu verwenden.
v) Die hier zum Einsatz kommenden Oligomere/Kolumnarstrukturen weisen besonders hohe Emissionsquantenausbeuten auf.
vi) Die erfindungsgemäßen Oligomere/Kolumnarstrukturen können als eindimensionale Halbleiter betrachtet werden. Dementsprechend zeigen derartige Strukturen sehr hohe Exzitonenbeweglichkeiten.
vii) Eine weitere wesentliche Eigenschaft ist dadurch gegeben, dass die erfindungsgemäß in opto-elektronischen Devices einzusetzenden Oligomer/Kolumnarstruktur-Doppelkomplex-Salze sehr gute Ladungsträgermobilitäten aufweisen. Durch die M-M-Wechselwirkungen werden das HOMO energetisch angehoben und LUMO energetisch abgesenkt. Ferner werden beide Molekülorbitale elektronisch über viele Moleküle (Bausteine der Oligomere/Kolumnarstrukturen) delokalisiert. Das führt auch zu einer bedeutenden Verbesserung der Loch- und Elektronenbeweglichkeit. Als Folge davon benötigt die Emissionsschicht (Emitter-Layer, EML) keine zusätzlichen Komponenten zur Verbesserung der Mobilität, d.h. die zum Teil einschränkenden Anforderungen an die Matrix bezüglich einer guten Ladungsträger-Mobilität können bei der Verwendung dieser Doppelkomplex-Salze bei vielen Anwendungen entfallen. Dadurch ist es möglich eine große Effizienzsteigerung und eine preiswertere Fertigung bei OLEDs zu erzielen.
viii) Eine weitere wesentliche Eigenschaft ist dadurch gegeben, dass die Doppelkomplex-Salze chemisch und photochemisch besonders stabil sind und damit für den Einsatz als OLED- Emitter besonders geeignet sind.

Die Erfindung wird durch die nachfolgenden Beispiele genauer beschrieben, ohne sie dadurch einschränken zu wollen. Der Fachmann kann, ohne erfinderisch tätig zu werden, die Erfindung im gesamten offenbarten Bereich ausführen und so weitere erfindungsgemäße organische Elektrolumineszenzvorrichtungen herstellen.

**Beispiele:**

**Beispiel einer Synthese eines löslichen Pt-Doppelkomplex-Salzes: $[Pt(4,4'\text{-Dinonyl-2,2'-dipyridyl})_2][Pt(CN)_4]$**

Am Beispiel des unlöslichen Doppelkomplex-Salzes $[Pt(bpy)_2][Pt(CN)_4]$ soll das Konzept der Solubilisierung von Metall-Metall-Doppelkomplex-Salzen verdeutlicht werden. Durch gezielte Verwendung von in 4,4'-Position mit jeweils einer $CH_3(CH_2)_8$-Alkylgruppe substituierten Bipyridinen ist es möglich, die unsubstituierte, unlösliche Verbindung löslich zu machen.

**Synthesevorschrift für $[Pt(4,4'\text{-Dinonyl-2,2'-dipyridyl})_2][BF_4]_2$**

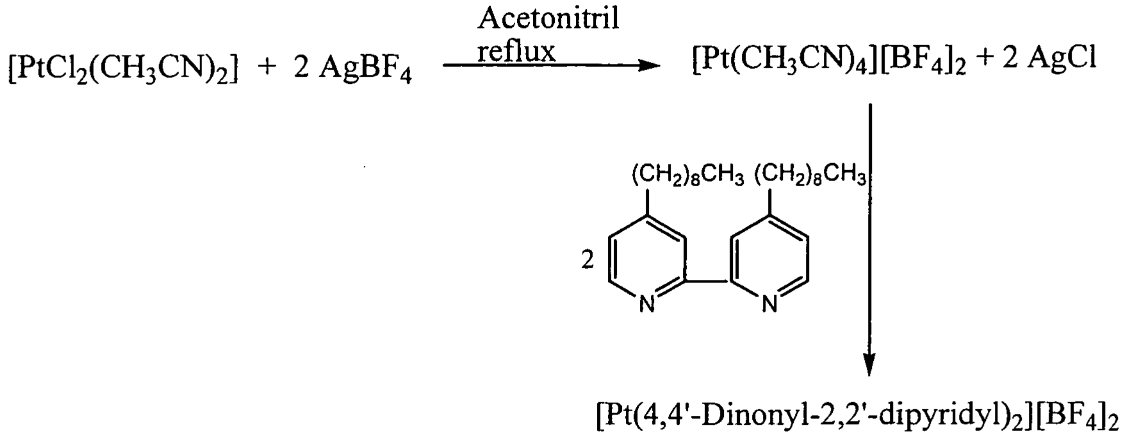


Die Synthese wird nach einer modifizierten Literaturvorschrift durchgeführt (vgl. A. Boixasse, J. Pons, X. Solans, M. Fontbardia, J. Ros, Inorg. Chim. Acta 2004, 357, 827.)

$[PtCl_2(CH_3CN)_2]$ (0.300 g, 0.862 mmol) wird in 50 mL trockenem Acetonitril unter $N_2$ suspendiert. $AgBF_4$ (0.336 g, 1.724 mmol) wird hinzugeben, und die Reaktionsmischung 20 h refluxiert. Ausgefallenes AgCl wird abfiltriert und zur klaren, farblosen Lösung wird 4,4'-Dinonyl-2,2'-dipyridyl (0.705 g, 1.724 mmol) geben. Danach wird weitere 20 h refluxiert. Der ausgefallene Feststoff (Reste an AgCl) wird abfiltriert und die klare, hellgelbe Reaktionslösung am Rotationsverdampfer eingeengt. Die Lösung wird über Nacht in die Gefriertruhe gestellt, wobei ein beiger Feststoff ausfällt. Der Niederschlag wird abgesaugt und mit Ethanol und Ether gewaschen, und anschließend getrocknet. Der Feststoff wird in Dichlormethan gelöst und mit Ether gefällt. Der feine, blassgrüne Niederschlag wird abfiltriert und im Exsikkator getrocknet.

| | |
|---|---|
| Summenformel: | $PtC_{56}H_{88}N_4B_2F_8$ (1185.67 g/mol) |
| Elementaranalyse: | $PtC_{56}H_{88}N_4B_2F_8$ (1185.67 g/mol) |
| | berechnet: C 56.68, H 7.48, N 4.72 |
| | gefunden: C 56.68, H 7.16, N 4.56 |
| Massenspektrometrie: | ES-MS, m/z = 506.0 $M^{2+}$, 100 % |

**Synthesevorschrift für $[Pt(4,4'\text{-Dinonyl-2,2'-dipyridyl})_2][Pt(CN)_4]$**

$[Pt(4,4'\text{-Dinonyl-2,2'-dipyridyl})_2][BF_4]_2$ + $[n\text{-}Bu_4N]_2[Pt(CN)_4]$

Dichlor-
methan

$[Pt(4,4'\text{-Dinonyl-2,2'-dipyridyl})_2][Pt(CN)_4]$ + 2 $[n\text{-}Bu_4N][BF_4]$

$[Pt(4,4'\text{-Dinonyl-2,2'-dipyridyl})_2][BF_4]_2$ (0.0209 g, 0.0176 mmol) und $[n\text{-}Bu_4N]_2[Pt(CN)_4]$ (0.0138 g, 0.0176 mmol) werden getrennt in jeweils 4 mL Dichlormethan gelöst. Anschließend werden die beiden Lösungen vereinigt. Über Nacht lässt man das Lösungsmittel langsam abdampfen und man erhält einen gelben Feststoff. Dieser wird mit Acetonitril (3 mL) gewaschen und im Exsikkator getrocknet.

| | |
|---|---|
| Summenformel: | $Pt_2C_{60}H_{88}N_8 \cdot CH_2Cl_2$ (1396.48 g/mol) |
| Elementaranalyse: | $Pt_2C_{60}H_{88}N_8 \cdot CH_2Cl_2$ (1396.48 g/mol) |
| | berechnet: C 54.95, H 6.76, N 8.54 |

(fortgesetzt)

gefunden: C 52.46, H 6.50, N 8.02

Die Abb. 2 zeigt das optische Anregungsspektrum und das Emissionsspektrum dieser neuen Substanz.

**Lösung von $[Pt(4,4'\text{-Dinonyl-}2,2'\text{-dipyridyl})_2][Pt(CN)_4]$ in Toluol**

Zur Darstellung von OLEDs wird z. B. eine 2 Gew.-%ige Lösung durch Lösen von 200 mg $[Pt(4,4'\text{-Dinonyl-}2,2'\text{-dipyridyl})_2][Pt(CN)_4]$ in 9.8 g Anisol hergestellt.

**Beispiel 2: Darstellung von $[Pd(bpy)_2]_{0.9}[Pt(bpy)_2]_{0.1}[Pt(CN)_4]$**

Ein Gemisch von $[Pd(2,2'\text{-dipyridyl})_2][BF_4]_2$ (533.1 mg, 0.9 mmol) und $[Pt(2,2'\text{-dipyridyl})_2][BF_4]_2$ (68.1 mg, 0.1 mmol) wird in 50 ml Dichlormethan gelöst. Zu dieser Lösung gibt man unter gutem Rühen eine Lösung von $[n\text{-}Bu_4N]_2[Pt(CN)_4]$ (689.0 mg, 1.0 mmol) in 30 mL Dichlormethan und rührt 2 h bei Raumtemperatur nach. Man entfernt das Lösungsmittel im Vakuum, nimmt den gelben Feststoff in 50 ml Acetonitril auf, rührt die Suspension 12 h bei Raumtemperatur, saugt ab, und wiederholt den Prozess noch dreimal. Nach letztem Absaugen wäscht man fünfmal mit 20 ml Acetonitril und trocknet anschließend im Vakuum. Ausbeute: 95 %.

**Dispersion von $[Pd(bpy)_2]_{0.9}[Pt(bpy)_2]_{0.1}[Pt(CN)_4]$ in Toluol**

Eine Suspension von 200 mg $[Pd(bpy)_2]_{0.9}[Pt(bpy)_2]_{0.1}[Pt(CN)_4]$ in 9.8 g Toluol wird 15 h mit Ultraschall behandelt. Die so erhaltene Dispersion wird anschließend filtriert.

Analog wird die u. g. Verbindungen durch Verwendung der geeigneten Stöchiometrie der Edukte erhalten:

| Bsp.-Nr. | Verbindung | Ausbeute |
|---|---|---|
| 3 | $[Pd(bpy)_2]_{0.99}[Pt(bpy)_2]_{0.01}[Pt(CN)_4]$ | 95 % |

**Dispersion von $[Pd(bpy)_2]_{0.99}[Pt(bpy)_2]_{0.01}[Pt(CN)_4]$ in Toluol**

Eine Suspension von 200 mg $[Pd(bpy)_2]_{0.9}[Pt(bpy)_2]_{0.1}[Pt(CN)_4]$ in 9.8 g Toluol wird 15 h mit Ultraschall behandelt. Die so erhaltene Dispersion wird anschließend filtriert.

Die folgenden Verbindungen wurden nach Literaturmethoden dargestellt und als 2 Gew.-%ige Dispersion in einem Gemisch aus Toluol und DMF (1:1, v:v) eingesetzt.

| Bsp.-Nr. | Verbindung | CAS-Nr. |
|---|---|---|
| 4 | $[Pt(bpy)_2][Pt(CN)_4]$ | 54806-40-5 |
| 5 | $[Pt(4,4'\text{-Di(Me)bpy})_2][Pt(CN)_4]$ | 138736-38-6 |
| 6 | $[Pt(phen)_2][Pt(CN)_4]$ | 59981-69-0 |
| 7 | $[Pt(phen)_2][Pt(Ox)_4]$ | 59981-70-3 |
| 8 | $[Pt(bpy)_2][PtCl_4]$ | 54822-44-5 |
| 9 | $[Pt(phen)(en)][Pt(CN)_4]$ | 136503-94-1 |

**Beispiel 10: Herstellung und Charakterisierung von organischen Elektrolumineszenzvorrichtungen aus Lösung**

Die Herstellung von LEDs erfolgt nach dem im Folgenden skizzierten allgemeinen Verfahren. Dieses muss natürlich im Einzelfall auf die jeweiligen Gegebenheiten (z. B. Schichtdickenvariation, um optimale Effizienz bzw. Farbe zu erreichen) angepasst werden.

**Allgemeines Verfahren zur Herstellung der OLEDs:**

Die Herstellung solcher Bauteile lehnt sich an die Herstellung polymerer Leuchtdioden (PLEDs) an, die in der

Literatur bereits vielfach beschrieben ist (z. B. in der WO 2004/037887 A2).

Im vorliegenden Fall werden die u. g. Matrixmaterialien bzw. Matrixmaterialkombinationen in einem organischen Lösemittel wie z. B. Toluol, Chlorbenzol, Anisol oder DMF gelöst. Der typische Feststoffgehalt solcher Lösungen liegt zwischen 10 und 25 g/L, wenn, wie hier, die für eine Device typische Schichtdicke von 80 nm mittels Spincoating erzielt werden soll.

Verwendete Matrixmaterialien:

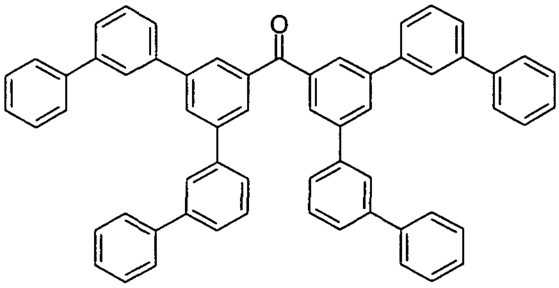

M1
DE 102008033943.1

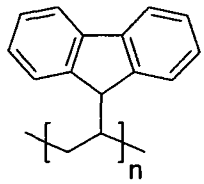

M2
Poly(N-Vinylcarbazol)
Mw ca. 1.100.000 g / mol

Zu diesen Lösungen wird dann eine Lösung (s. Bsp. 1) bzw. eine Nano-Dispersion (s. Bsp. 2-9) des entsprechenden Doppelkomplex-Salzes zugegeben, wobei das auf die Feststoffe bezogene Verhältnis von Matrixmaterial bzw. Matrixmaterialkombination zu Doppelkomplex-Salz 5 Gew.-% beträgt.

Analog dem o. g. allgemeinen Verfahren werden OLEDs mit folgendem Aufbau erzeugt:

PEDOT 20 nm (aus Wasser aufgeschleudert; PEDOT bezogen von BAYER AG; Poly-[3,4-ethylendioxy-2,5-thiophen]
Matrix + Emitter 80 nm, 5 Gew.-% Emitter + 95 % Matrixmaterial bzw. Matrixmaterialkombination, aus Toluol, Chlorbenzol oder DMF aufgeschleudert,
Ba / Ag 10 nm Ba /150 nm Ag als Kathode.

Strukturierte ITO-Substrate und das Material für die so genannte Pufferschicht (PEDOT, eigentlich PEDOT:PSS) sind käuflich erhältlich (ITO von Technoprint und anderen, PEDOT:PPS als wässrige Dispersion Clevios Baytron P von H.C. Starck). Die Emissionsschicht wird in einer Inertgasatmosphäre, im vorliegenden Fall Argon, aufgeschleudert und 10 min bei 170 °C ausgeheizt. Zuletzt wird eine Kathode aus Barium und Aluminium im Vakuum aufgedampft. Die lösungsprozessierten Devices werden standardmäßig charakterisiert, die genannten OLED-Beispiele wurden noch nicht optimiert.

In Tabelle 2 sind die Effizienz und die Spannung bei 100 cd / $m^2$ sowie die Farbe aufgeführt.

Tabelle 2: Device-Eraebnisse

| Bsp. | Matrices, M Emitter, E | EQE bei 100 cd/$m^2$, [%] | Spannung bei 100 cd/$m^2$, [V] | CIE x / y |
|---|---|---|---|---|
| 11 | M1, 30 Gew.-%<br>M2, 65 Gew.-%<br>E1, 5 Gew.-% | 14,3 | 6,2 | 0,55 / 0,38 |
| 12 | M2, 95 Gew.-%<br>E1, 5 Gew.-% | 16,3 | 5,9 | 0,53 / 0,39 |
| 13 | M1, 30 Gew.-%<br>M2, 65 Gew.-%<br>E2, 5 Gew.-% | 9,3 | 7,8 | 0,25 / 0,37 |
| 14 | M1, 30 Gew.-%<br>M2, 65 Gew.-% | 8,7 | 7,5 | 0,21 / 0.29 |

(fortgesetzt)

| Bsp. | Matrices, M Emitter, E | EQE bei 100 cd/m$^2$, [%] | Spannung bei 100 cd/m$^2$, [V] | CIE x / y |
|---|---|---|---|---|
| | E3, 5 Gew.-% | | | |
| 15 | M1, 50 Gew.-%<br>M2, 45 Gew.-%<br>E6, 5 Gew.-% | 1,3 | 6,3 | 0,70 / 0,29 |
| 16 | M1, 50 Gew.-%<br>M2, 45 Gew.-%<br>E9, 5 Gew.-% | 17,3 | 5,6 | 0,36 / 0,59 |

**Patentansprüche**

**1.** OLED enthaltend Oligomere aufgebaut aus unterschiedlich geladenen Metallkomplexen, umfassend wenigstens einen positiv geladenen Metallkomplex und wenigstens einen negativ geladenen Metallkomplex, wobei die Metallkomplexe die

$$\text{Formel (I) } K_1 = [L1L2L3L4M1]^{n+}$$

und

$$\text{Formel (II) } K_2 = [L5L6L7L8M2]^{n-}$$

aufweisen, wobei M1 und M2 ein Metallzentrum darstellen, und wobei es sich bei dem Oligomer um ein Doppelkomplex-Salz handelt, wobei

$K_1$= [L1L2L3L4Pt(II)]$^+$ und $K_2$ = [L5L6L7L8Pt(II)]$^-$; oder
$K_1$= [L1L2L3L4Pd(II)]$^+$ und $K_2$ = [L5L6L7L8Pd(II)]$^-$; oder
$K_1$= [L1L2L3L4Pt(II)]$^{2+}$ und $K_2$ = [L5L6L7L8Pt(II)]$^{2-}$; oder
$K_1$= [L1L2L3L4Pd(II)]$^{2+}$ und $K_2$ = [L5L6L7L8Pd(II)]$^{2-}$;

wobei

$K_1$= [L1L2L3L4Pt(II)]$^+$ eine der folgenden Formeln aufweist:

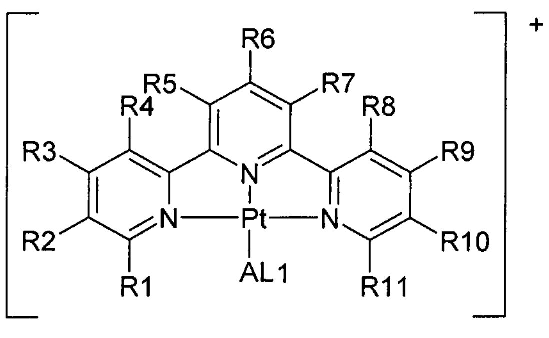

**7**

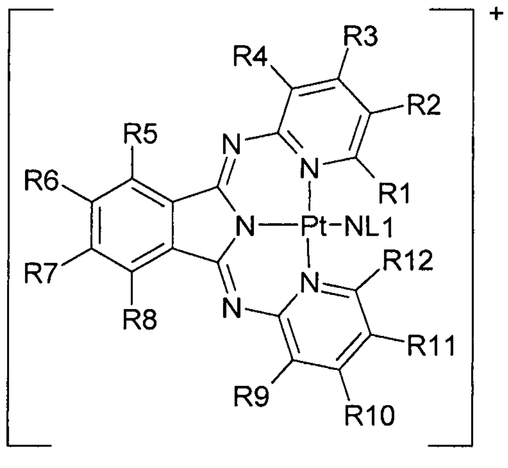

**8**

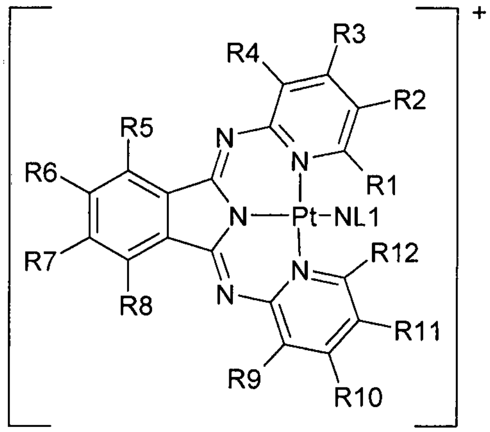

**9**

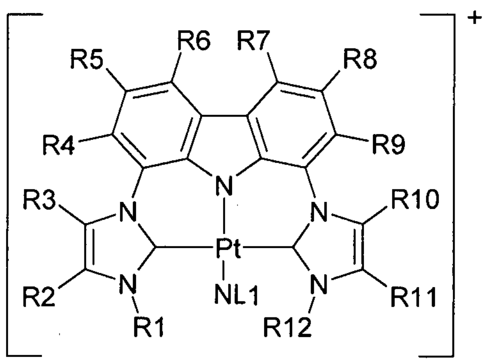

**10**

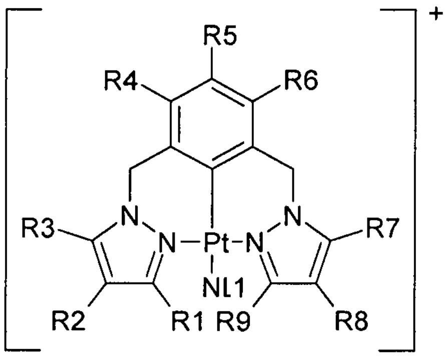

**11**

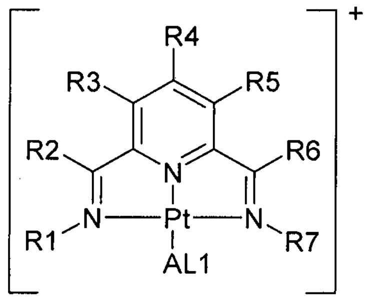

**12**

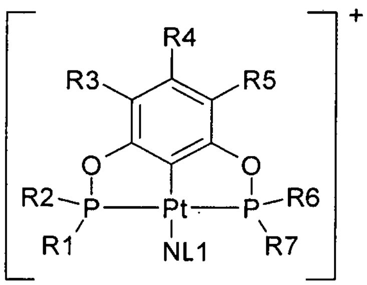

**18**

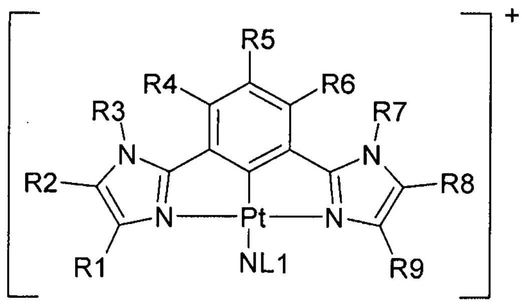

**22**

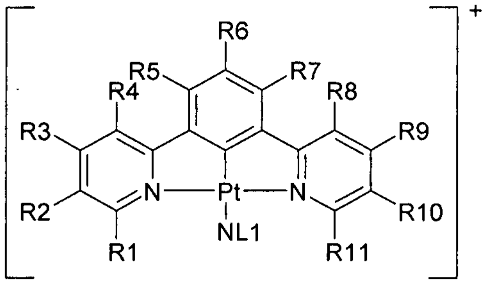

**23**

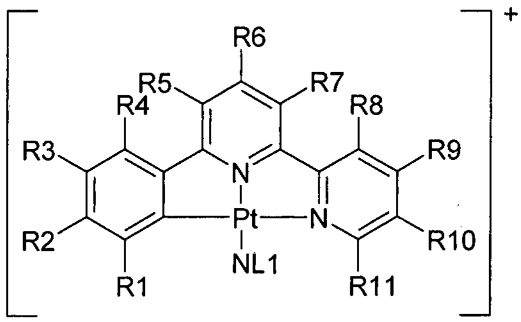

**24**

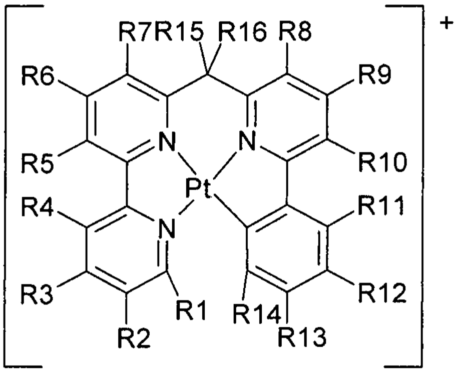

26

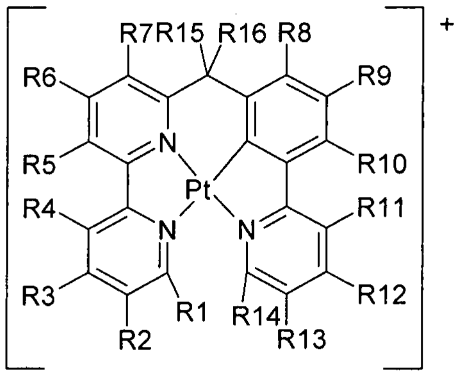

27

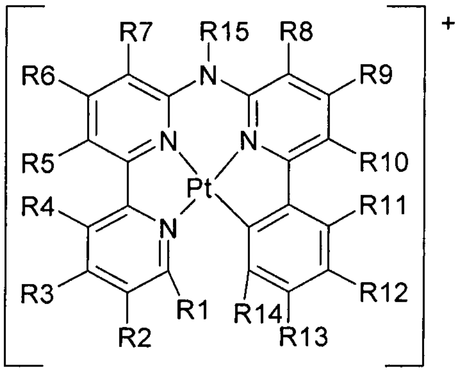

28

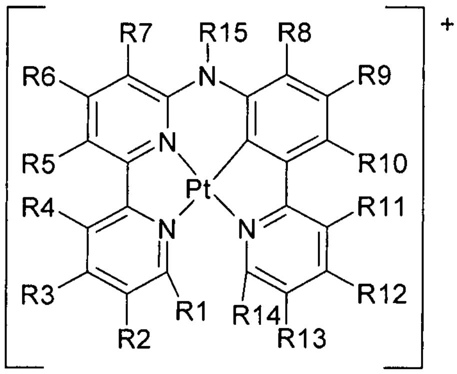

29

$K_1$= [L1L2L3L4Pd(II)]$^+$ eine der folgenden Formeln aufweist:

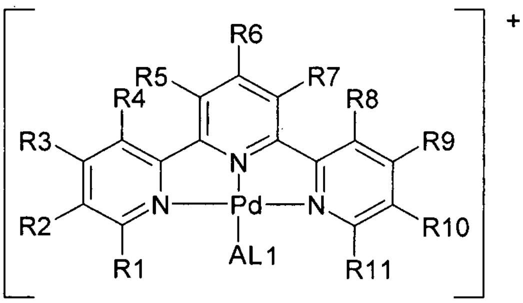

50

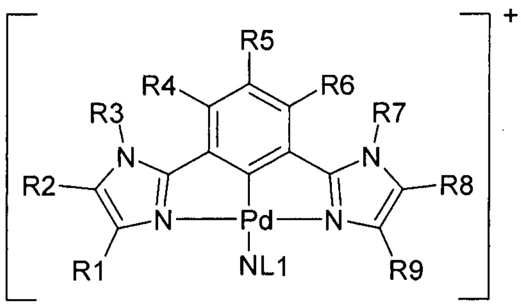

51

$K_1$= [L1L2L3L4Pt(II)]$^{2+}$ eine der folgenden Formeln aufweist:

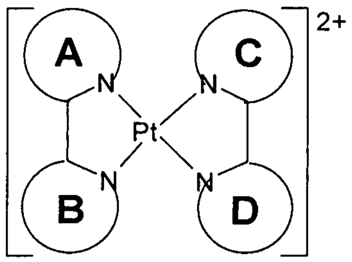

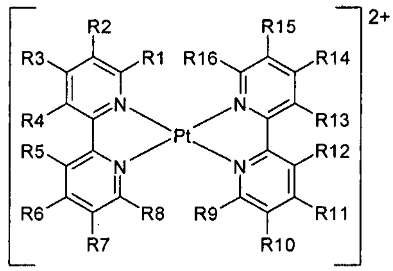

83

85

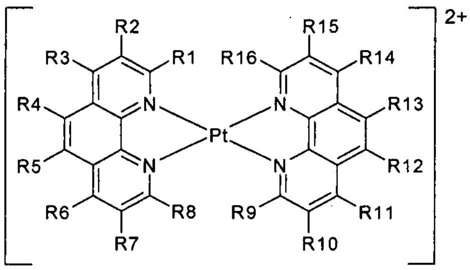

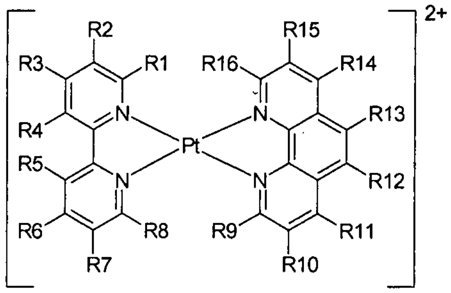

86

87

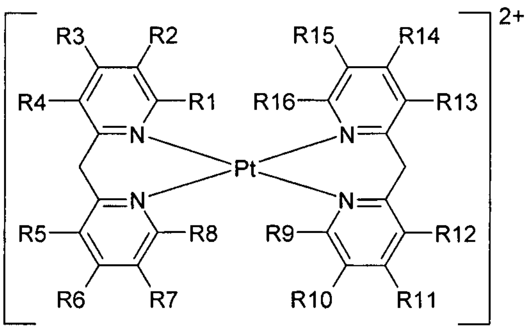

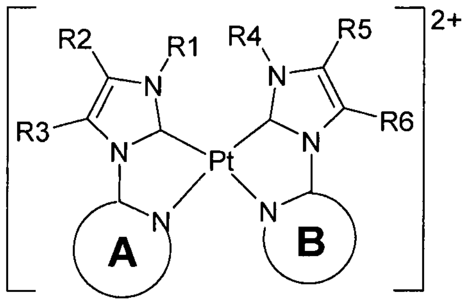

90

92

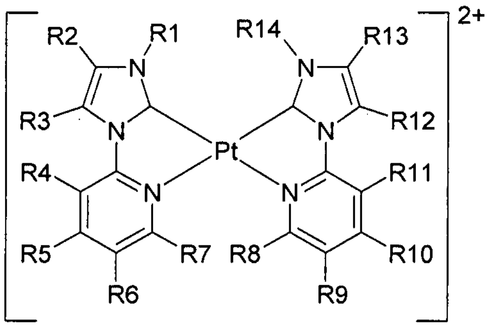

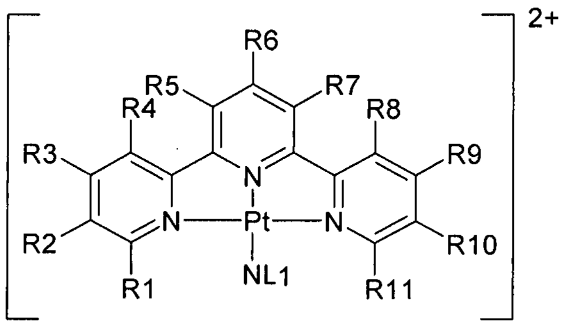

94

96

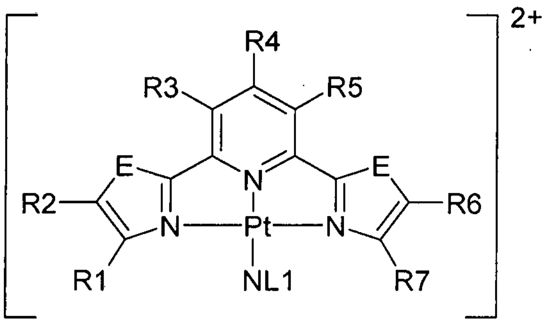

**97** (E = O, S, NR, wobei R wie R1 bis R20 definiert ist)

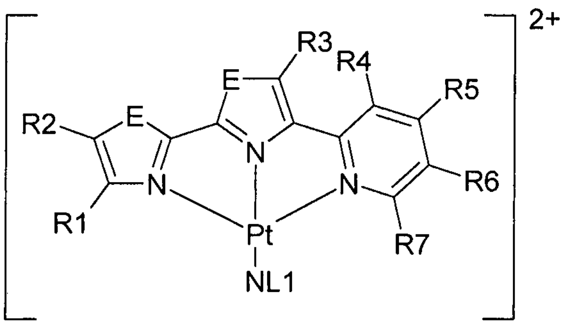

**98** (E = O, S, NR, wobei R wie R1 bis R20 definiert ist)

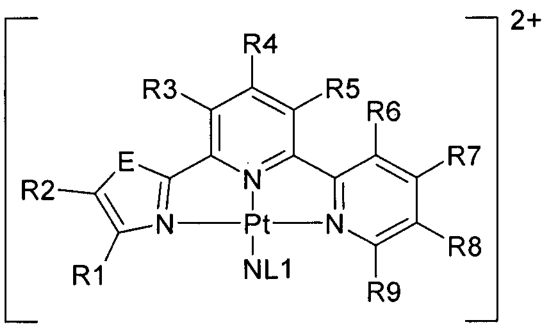

**99** (E = O, S, NR, wobei R wie R1 bis R20 definiert ist)

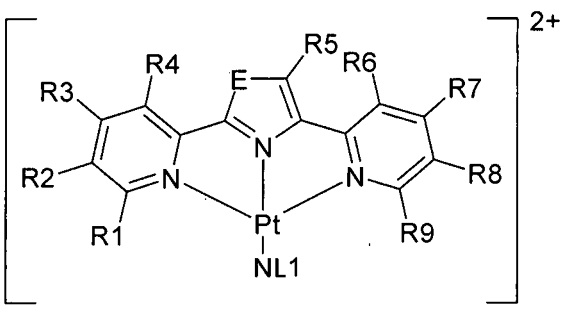

**100** (E = O, S, NR, wobei R wie R1 bis R20 definiert ist)

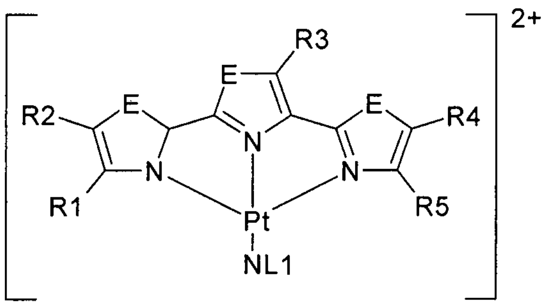

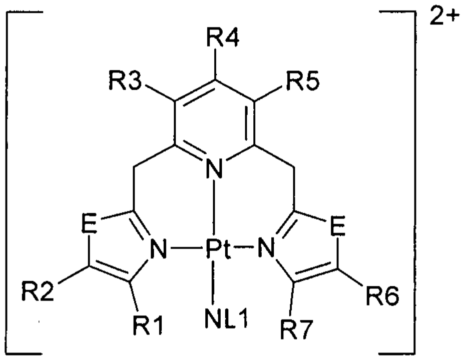

**101** **102**

(E = O, S, NR, wobei R wie R1 bis R20 definiert ist)

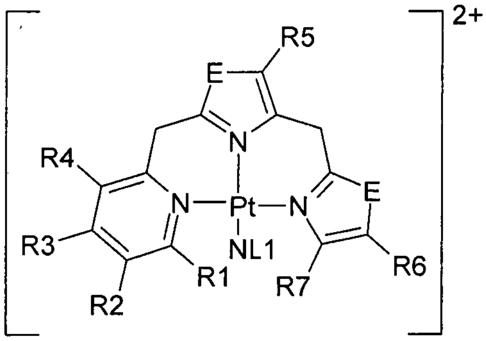

**103** (E = O, S, NR, wobei R wie R1 bis R20 definiert ist)

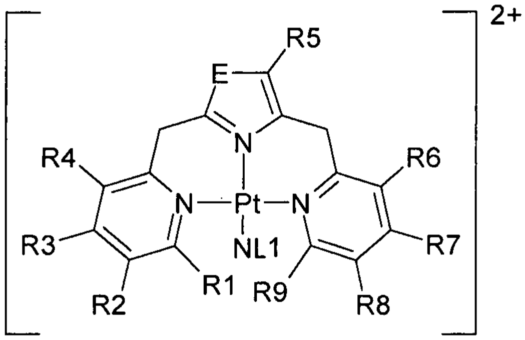

**104** (E = O, S, NR, wobei R wie R1 bis R20 definiert ist)

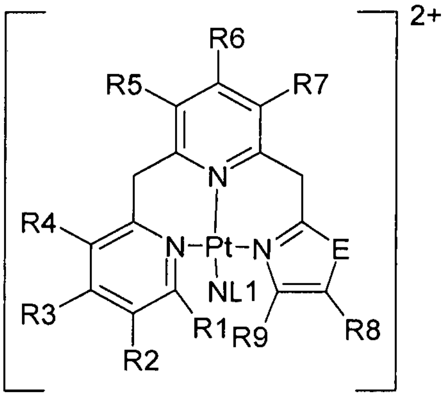

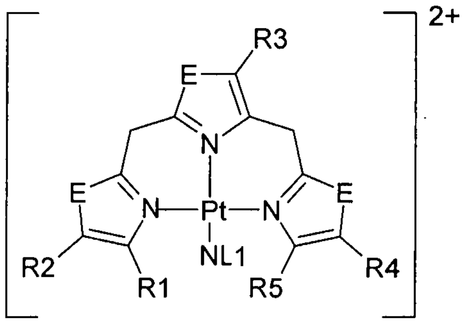

**105**

**106**

(E = O, S, NR, wobei R wie R1 bis R20 definiert ist)

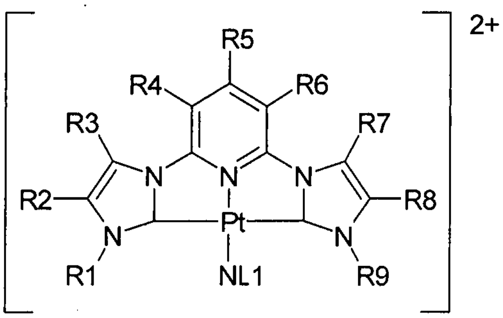

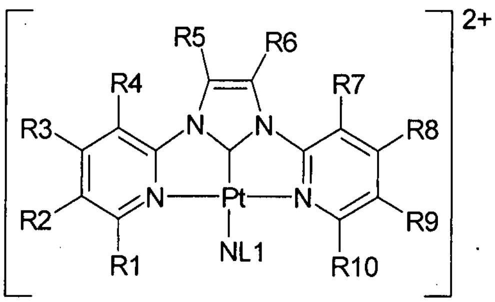

**107**

**108**

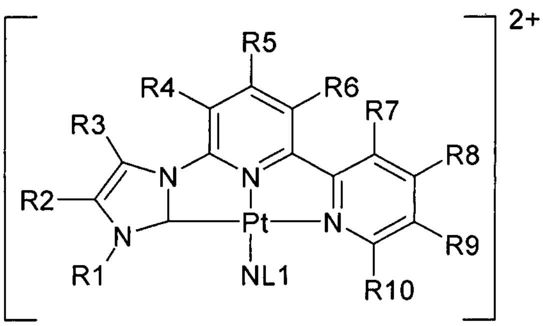

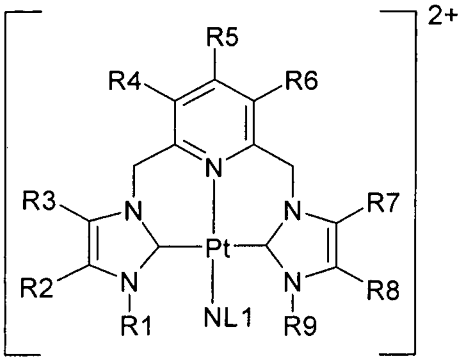

**109**

**110**

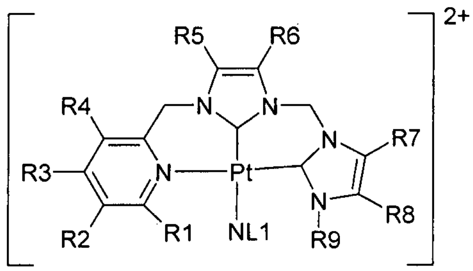

**111**

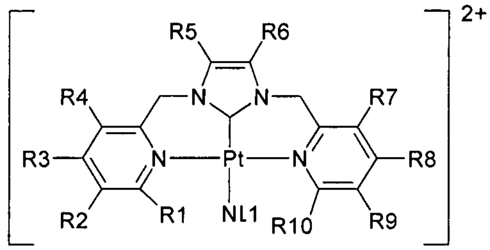

**112**

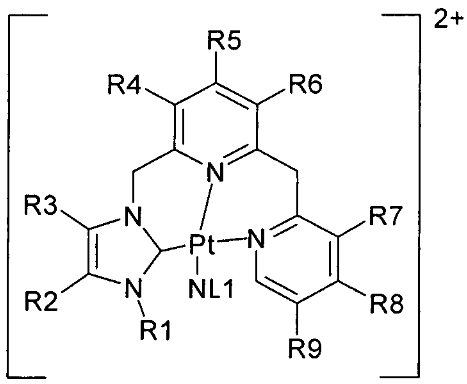

**113**

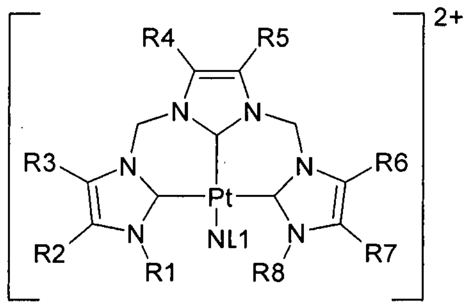

**114**

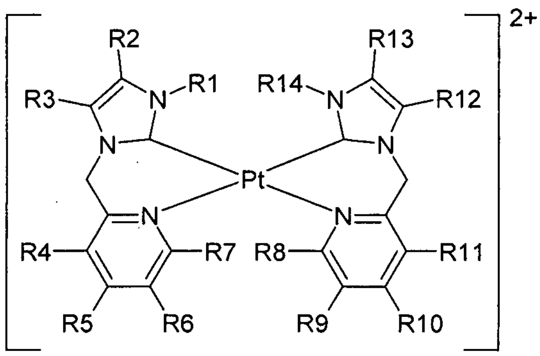

**122**

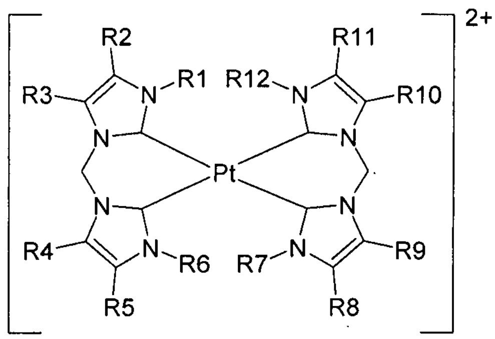

**124**

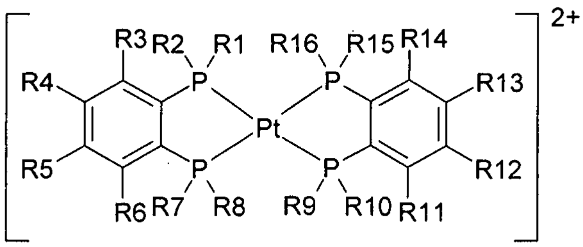

**126**

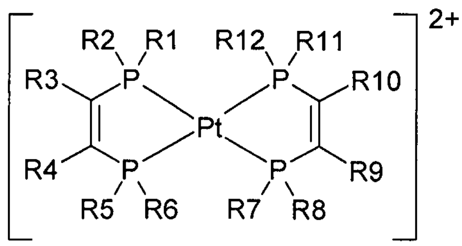

**128**

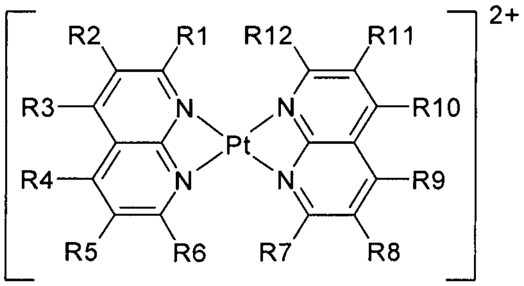

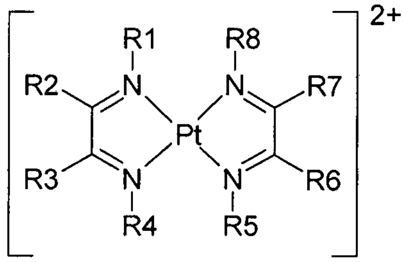

**130** **132**

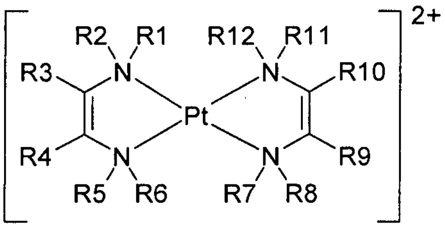

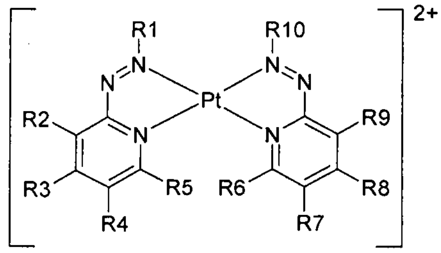

**134** **136**

und $K_1$= $[L1L2L3L4Pd(II)]^{2+}$ die gleiche Formeln wie die oben aufgeführten Formeln für $K_1$ = $[L1L2L3L4Pt(II)]^{2+}$ aufweist, jedoch muss Pt(II) durch Pd(II) ersetzt werden;
und
$K_2$ = $[L5L6L7L8Pt(II)]^-$ ausgewählt ist aus:

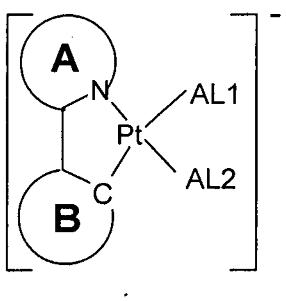

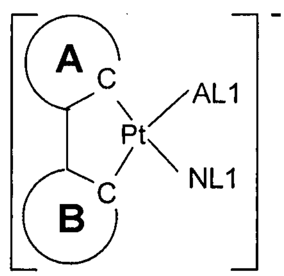

**30** **31**

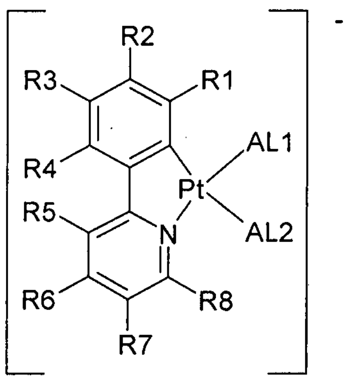

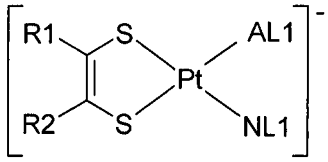

**32** **33**

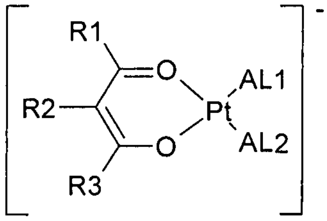

**34**

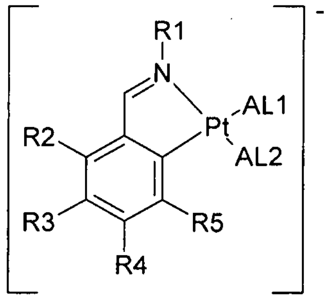

**35**

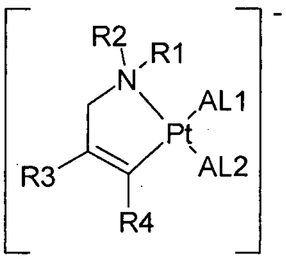

**36**

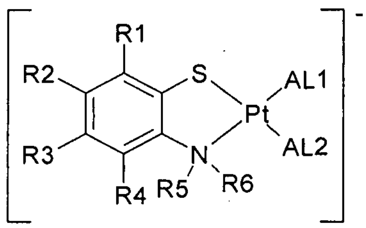

**37**

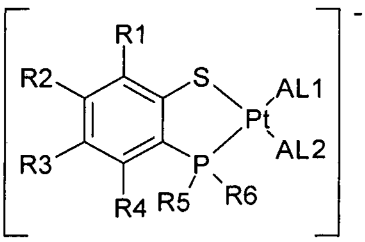

**38**

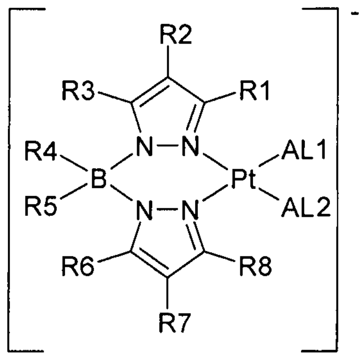

**39**

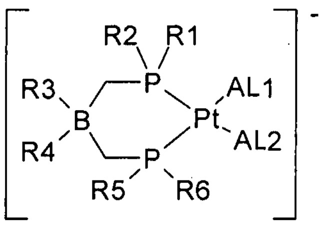

**40**

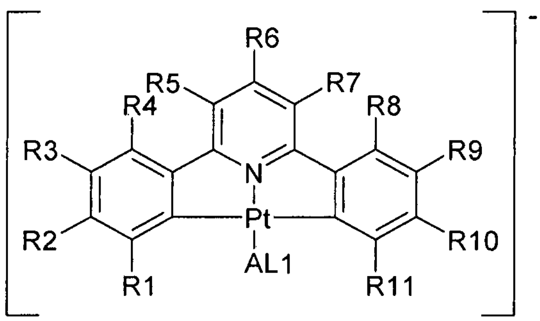

**41**

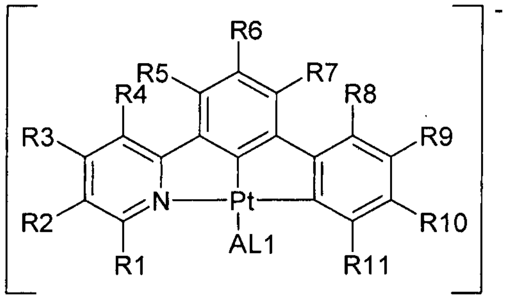

42

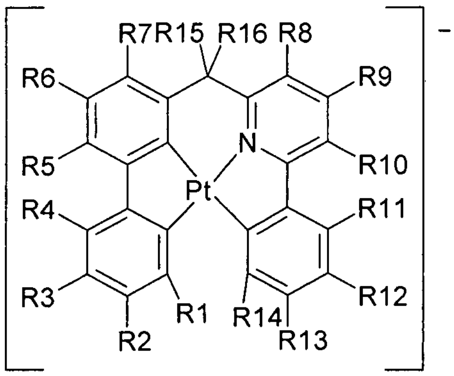

43

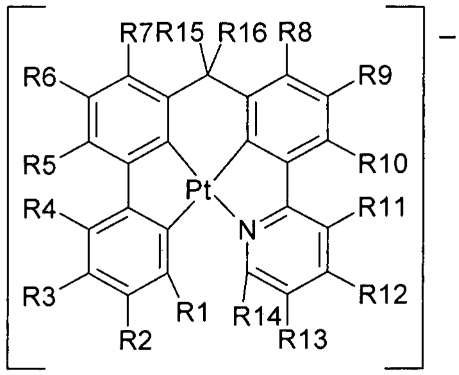

44

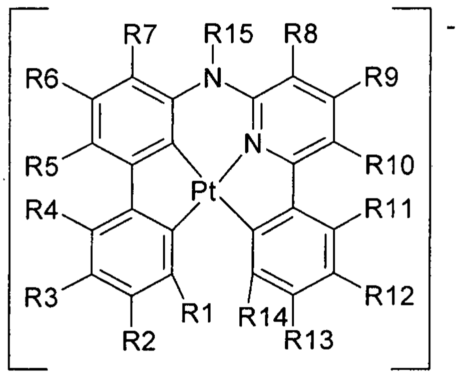

45

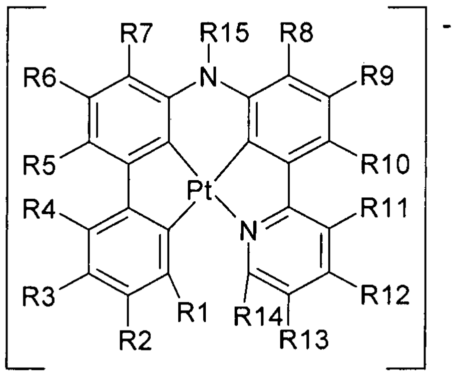

46

$K_2$ = [L5L6L7L8Pd(II)]$^-$ ausgewählt ist aus:

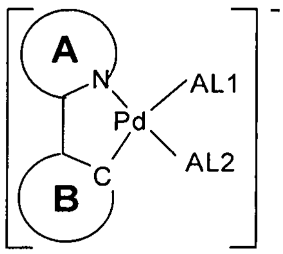

52

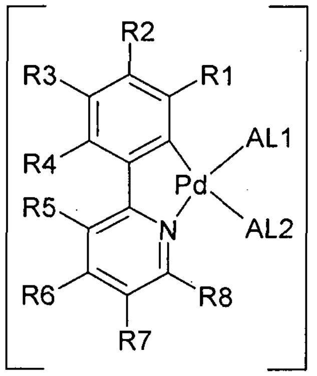

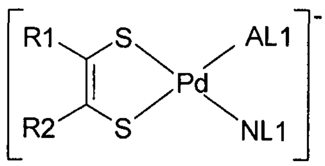

**53** **54**

$K_2 = [L5L6L7L8Pt(II)]^{2-}$ ausgewählt ist aus:

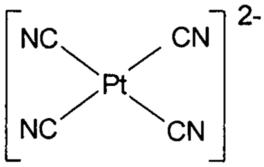

**138**

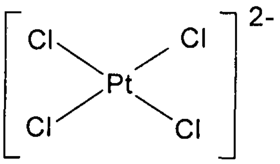

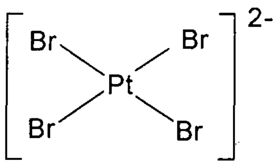

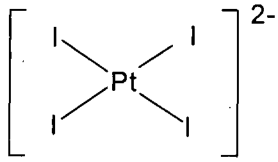

**139** **140** **141**

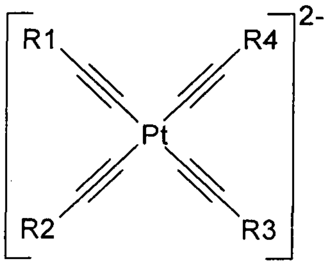

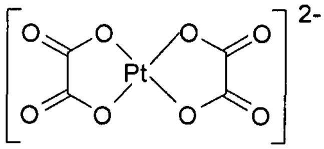

**142** **143**

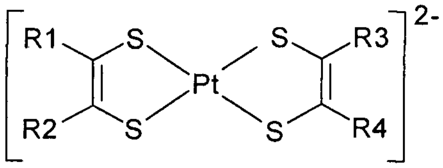

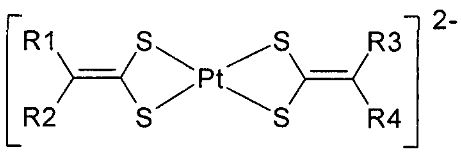

**144** **145**

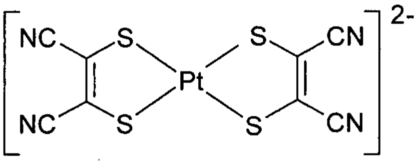

146

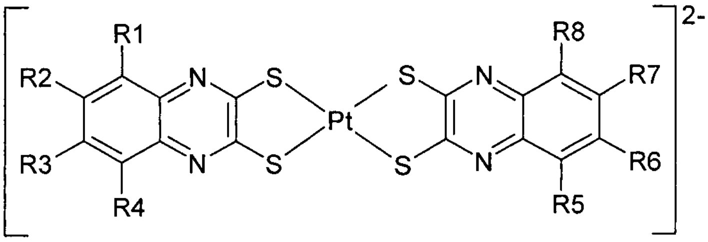

147

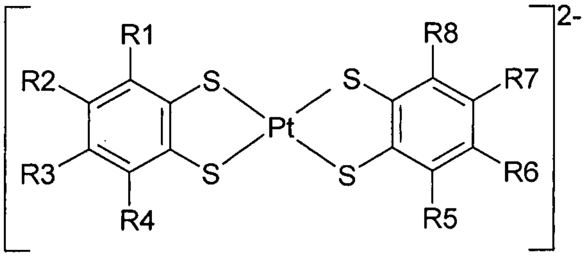

148

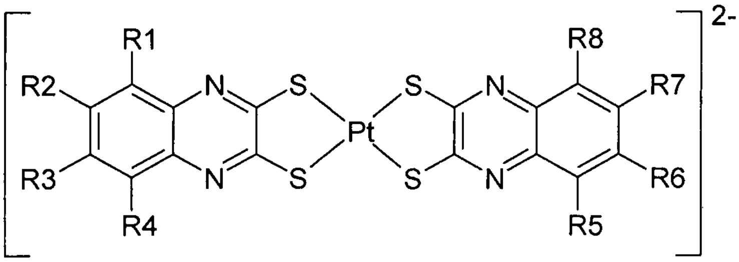

149

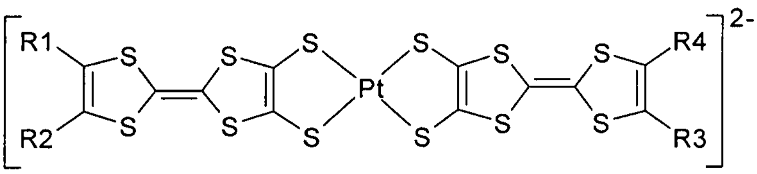

150

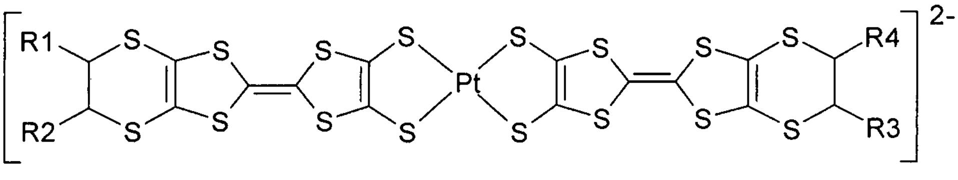

151

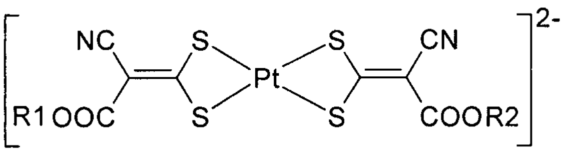

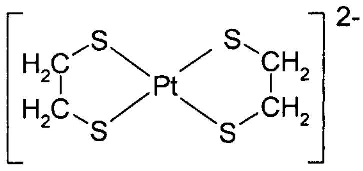

**152** **153**

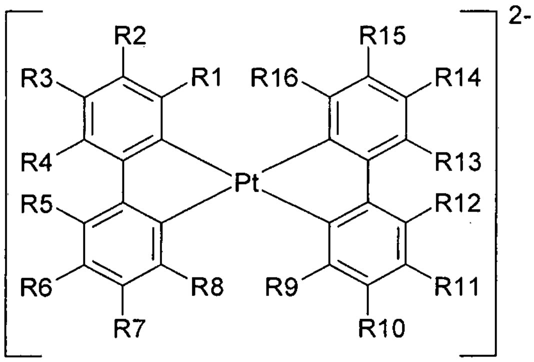

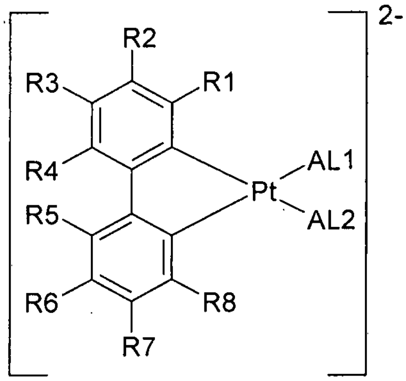

**154** **155**

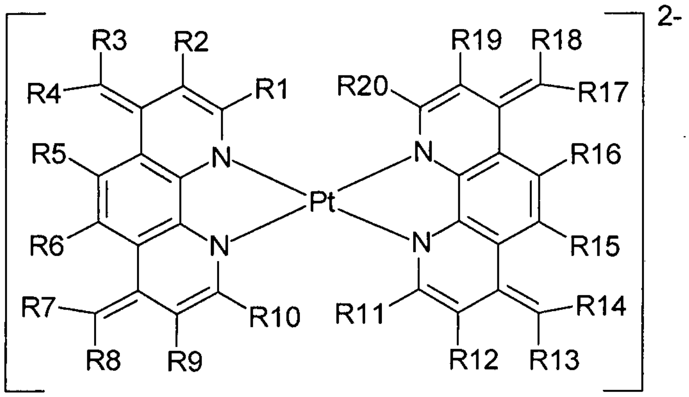

**156**

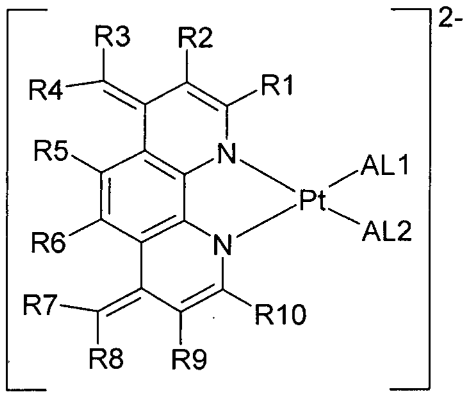

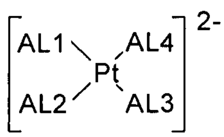

**157** **158**

und $K_2$ = $[L5L6L7L8Pd(II)]^{2-}$ ist aus der gleichen Formeln wie die oben aufgeführten Formeln für $K_1$ =

$[L1L2L3L4Pt(II)]^{2+}$ ausgewählt, jedoch muss Pt(II) durch Pd(II) ersetzt werden;

wobei gilt:

R1 bis R20 ist gleich oder verschieden bei jedem Auftreten eine der folgenden Gruppen: H, Deuterium, F, Cl, Br, I, $N(R^{21})_2$, CN, $NO_2$, $Si(R^{21})_3$, $B(OR^{21})_2$, $C(=O)R^{21}$, $P(=O)(R^{21})_2$, $S(=O)R^{21}$, $S(=O)_2R^{21}$, $OSO_2R^{21}$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^{21}$ substituiert sein kann, wobei eine oder mehrere nicht benachbarte $CH_2$-Gruppen durch $R^{21}C=CR^{21}$, C=C, $Si(R^{21})_2$, $Ge(R^{21})_2$, $Sn(R^{21})_2$, C=O, C=S, C=Se, $C=NR^{21}$, $P(=O)(R^{21})$, SO, $SO_2$, $NR^{21}$, O, S oder $CONR^{21}$ ersetzt sein können und wobei ein oder mehrere H-Atome durch F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^{21}$ substituiert sein kann, oder eine Aryloxy- oder Heteroaryloxygruppe mit 5 bis 60 aromatischen Ringatomen, die durch einen oder mehrere Reste $R^{21}$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^{21}$ substituiert sein kann, oder eine Kombination dieser Systeme; dabei können zwei oder mehrere dieser Substituenten auch miteinander ein mono- oder polycyclisches, aliphatisches, aromatisches und/oder benzoannelliertes Ringsystem bilden;

$R^{21}$ ist bei jedem Auftreten gleich oder verschieden H, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten $R^{21}$ auch miteinander ein mono- oder polycyclisches, aliphatisches oder aromatisches Ringsystem bilden;

NL1 ist ein neutraler Ligand, insbesondere ausgewählt aus Kohlenmonoxid, Isonitrilen, Aminen, Phosphinen, Phosphiten, Arsinen, Stibinen und stickstoffhaltigen Heterocyclen;

AL1, AL2, AL3, AL4 ist jeweils gleich oder verschieden bei jedem Auftreten ein anionischer Ligand, insbesondere ausgewählt aus Hydrid, Deuterid, den Halogeniden F, Cl, Br und I, Alkylacetyliden, Arylacetyliden, Arylgruppen, Alkylgruppen, Alkenygruppen, Boraten, Cyanid, Cyanat, Isocyanat, Thiocyanat, Isothiocyanat, aliphatischen oder aromatischen Alkoholaten, aliphatischen oder aromatischen Thioalkoholaten, Amiden, Carboxylaten und anionischen, stickstoffhaltigen Heterocyclen.

**2.** OLED nach Anspruch 1, **dadurch gekennzeichnet, dass** das Oligomer Kolumnarstrukturen $-K_1-K_2-K_1-K_2-$ aufweist, wobei $K_1$ für einen einfach positiv geladenen Komplex (Formel (I)) und $K_2$ für einen einfach negativ geladenen Komplex (Formel (II)) steht oder $K_1$ für einen zweifach positiv geladenen Komplex (Formel (I)) und $K_2$ für einen zweifach negativ geladenen Komplex (Formel (II)) steht;
oder dass das Oligomer die Kolumnarstruktur $-K_1-K_2-K_3-K_1-K_2-K_3-K_1-$aufweist, wobei

$K_1$ einen zweifach positiv geladenen Komplex nach Formel (I) und
$K_2$ und $K_3$ einen einfach negativ geladenen Komplex nach Formel (II) oder
$K_1$ einen zweifach negativ geladenen Komplex und
$K_2$ und $K_3$ einen einfach positiv geladenen Komplex oder
$K_1$ einen dreifach positiv geladenen Komplex und
$K_2$ einen zweifach negativ geladenen Komplex und
$K_3$ einen einfach negativ geladenen Komplex oder
$K_1$ einen dreifach positiv geladenen Komplex,
$K_2$ einen einfach negativ geladenen Komplex und
$K_3$ einen zweifach negativ geladenen Komplex darstellt.

**3.** OLED nach Anpruch 1 oder 2, **dadurch gekennzeichnet, dass** wenigstens einer der Liganden L1 bis L8 zur Erhöhung der Solubilisierbarkeit eine große organische Gruppe enthält, insbesondere eine oder mehrere Alkylgruppen C1-C40, bevorzugt C1-C30, oder eine oder mehrere Polysiloxangruppen (-OSiR2-)nOSiR'3 mit n = 1-200, insbesondere 5-30, oder eine oder mehrere Polyethergruppen, wobei R und R' diesselbe Bedeutung hat wie R1 bis R20 in Anspruch 1, es sich aber bevorzugt um Alkylgruppen C1-C6 handelt.

**4.** OLED enthaltend Oligomere aufgebaut aus
wenigstens einem positiv geladenen Metallkomplex und
wenigstens einem negativ geladenen Metallkomplex,
wobei die Metallkomplexe die

$$\text{Formel (I) } K_1 = [L1L2L3L4M1]^{n+}$$

und

$$\text{Formel (II) } K_2 = [L5L6L7L8M2]^{n-}$$

aufweisen, wobei

M1 und M2 ein Metallzentrum darstellen, ausgewählt aus Ir(I), Rh(I), Pt(II), Pd(II) und Au(III), wobei M1 und M2 unterschiedliche Metallzentren darstellen, und
L1 - L4 und L5 - L8 jeweils einen neutralen oder geladenen Liganden darstellen, wobei zwei oder mehr von L1 - L4 und L5 - L8 auch miteinander verknüpft sein können, und wobei
n = 1 oder 2 ist.

5. OLED nach Anspruch 4, **dadurch gekennzeichnet, dass** ein Metallzentrum, ausgewählt aus Ir, Rh, Pt, Pd und Au, in einem Anteil von 10 bis 90 % in der Verbindung vorliegt und wenigstens ein zum ersten Metall verschiedenes Metall, ausgewählt aus Ir, Rh, Pt, Pd und Au, in einem Anteil von 10 bis 90 % vorliegt.

6. OLED nach Anspruch 4 oder 5, **dadurch gekennzeichnet, dass** es mindestens drei unterschiedliche Metall-Zentralionen, ausgewählt aus Ir, Rh, Pt, Pd und Au aufweist.

7. Oligomer, aufgebaut aus wenigstens einem Doppelkomplex-Salz, wobei das Doppelkomplex-Salz die Formel (IV) aufweist:

$$[L1L2L3L4M1]^{n+}_{1-x}[L1L2L3L4M2]^{n+}_{x}[L5L6L7L8M1]^{n-}$$

Formel (IV)

worin

$0{,}00001 \leq x \leq 0{,}99999$ und
bevorzugt M1 = Pd(II) und M2 = Pt(II).

8. Verfahren zur Herstellung einer OLED nach einem oder mehreren der Ansprüche 1 bis 6, wobei Metallkomplex-Salze der in Anspruch 1 genannten Formel (I) und (II) in Form einer Dispersion aufgebracht werden oder wobei Komponenten der Formel (I) in Form einer Lösung und Komponenten der Formel (II) durch Diffusion eingebracht werden.

9. Verwendung von Oligomeren nach Anspruch 7 in einer OLED.

## Claims

1. OLED containing oligomers built up from differently charged metal complexes, comprising at least one positively charged metal complex and at least one negatively charged metal complex, where the metal complexes have the

$$\text{formula (I) } K_1 = [L1L2L3L4M1]^{n+}$$

and

$$\text{formula (II) } K_2 = [L5L6L7L8M2]^{n-},$$

where M1 and M2 represent a metal centre and where the oligomer is a double-complex salt, where

$K_1$ = [L1 L2L3L4Pt(II)]$^+$ and $K_2$ = [L5L6L7L8Pt(II)]$^-$; or
$K_1$ = [L1L2L3L4Pd(II)]$^+$ and $K_2$ = [L5L6L7L8Pd(II)]$^-$; or
$K_1$ = [L1L2L3L4Pt(II)]$^{2+}$ and $K_2$ = [L5L6L7L8Pt(II)]$^{2-}$; or
$K_1$ = [L1L2L3L4Pd(II)]$^{2+}$ and $K_2$ = [L5L6L7L8Pd(II)]$^{2-}$;

where

$K_1$ = [L1L2L3L4Pt(II)]$^+$ has one of the following formulae:

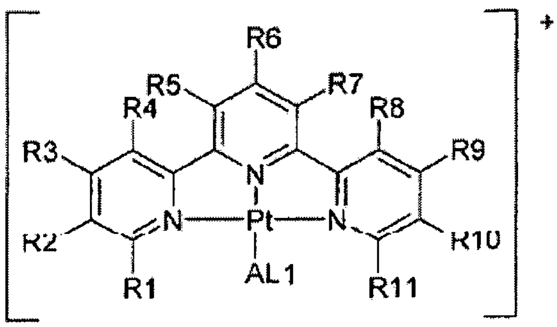

7

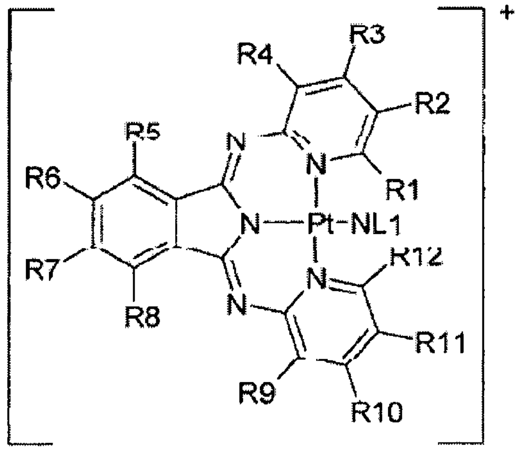

8

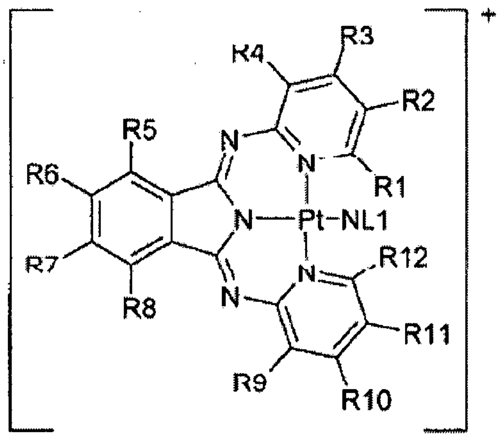

9

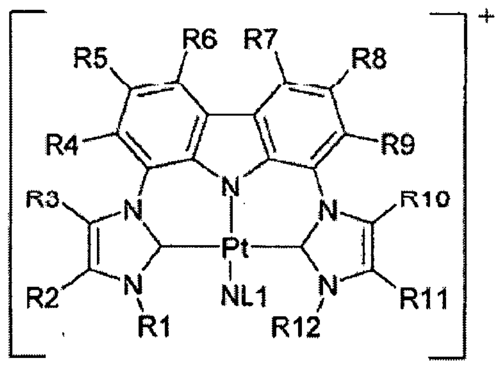

10

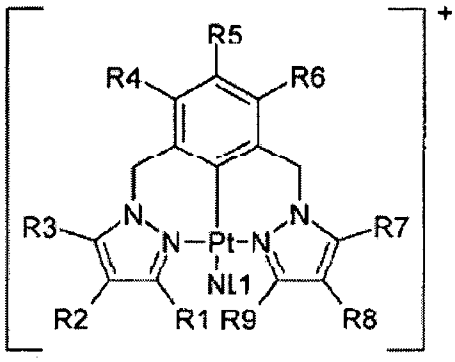

**11**

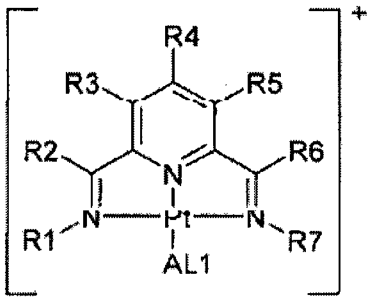

**12**

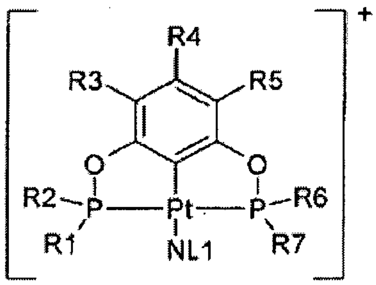

**18**

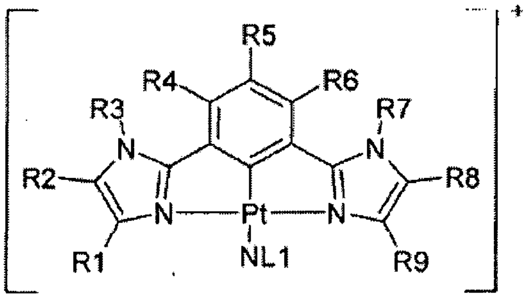

**22**

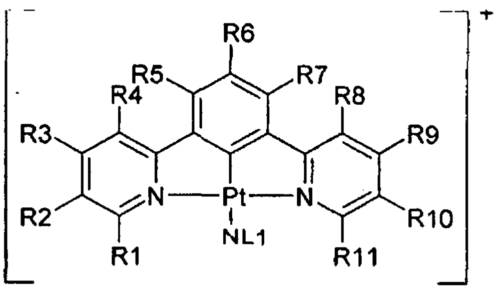

**23**

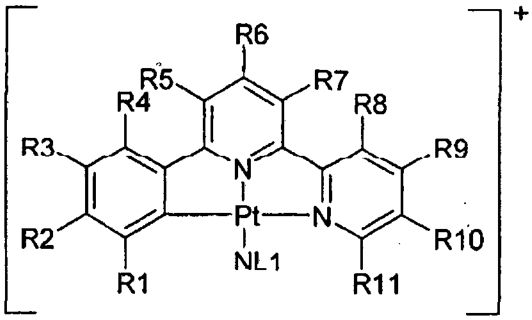

**24**

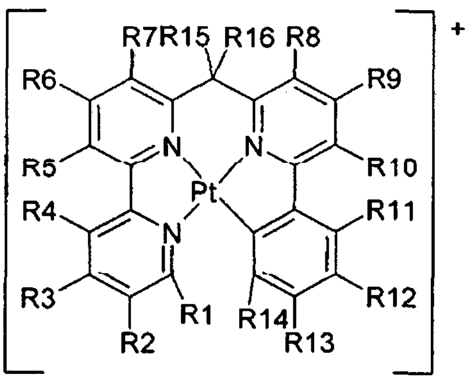

**26**

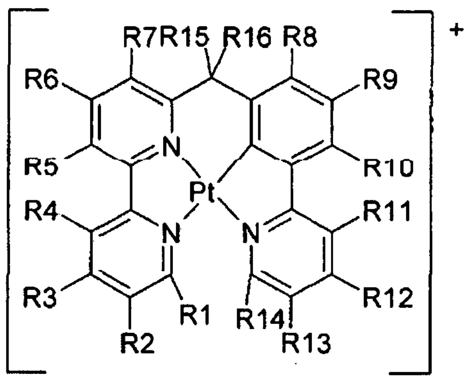

**27**

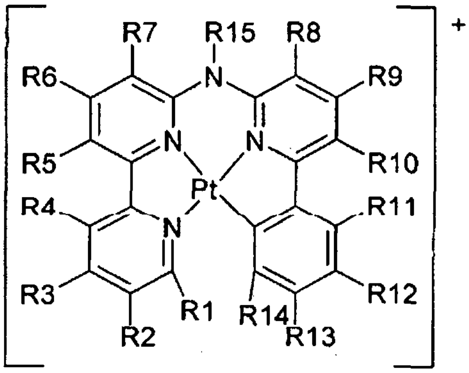

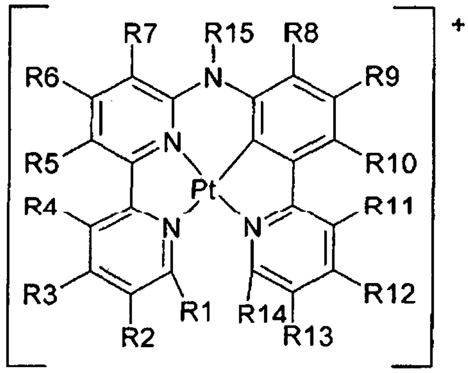

**28** **29**

$K_1$ = $[L1L2L3L4Pd(II)]^+$ has one of the following formulae:

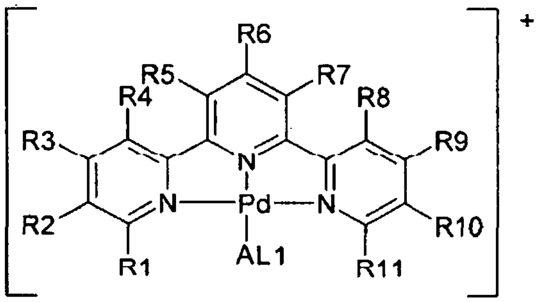

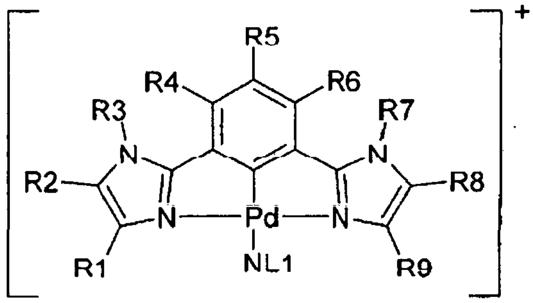

**50** **51**

$K_1$ = $[L1L2L3L4Pt(II)]^{2+}$ has one of the following formulae:

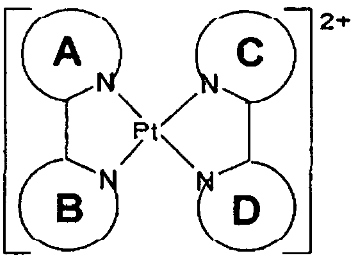

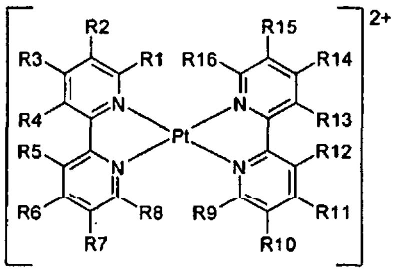

**83** **85**

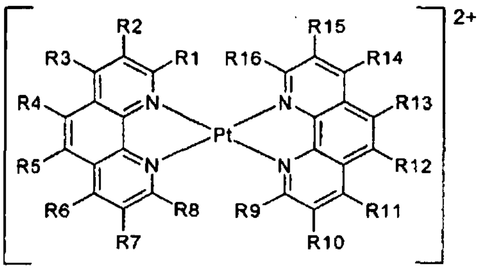

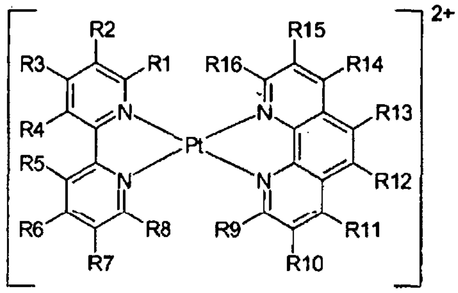

**86** **87**

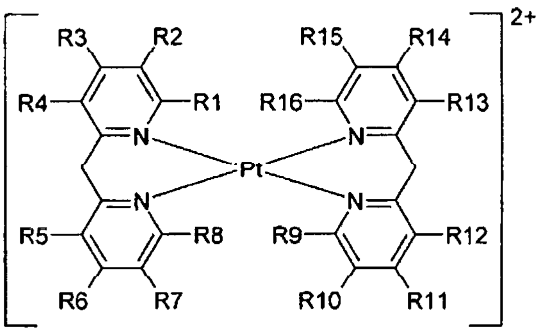
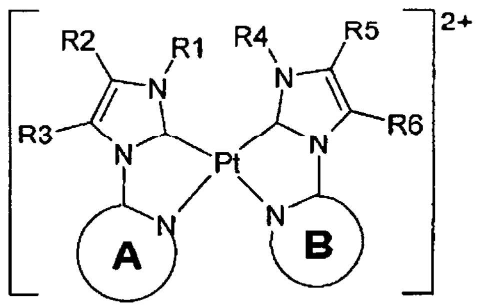

**90** **92**

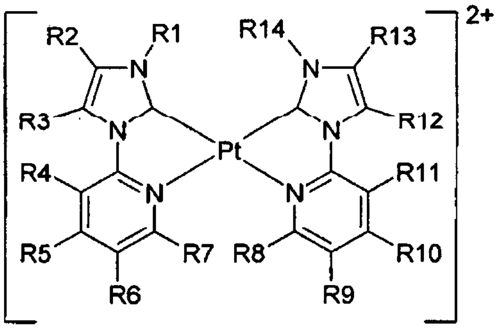
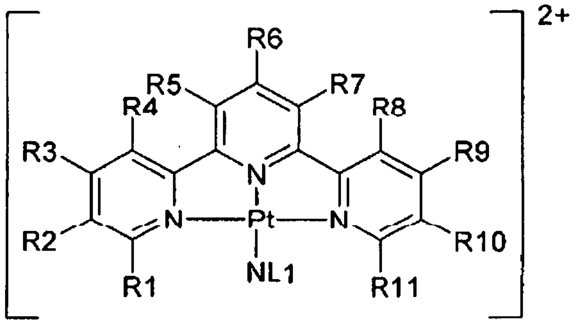

**94** **96**

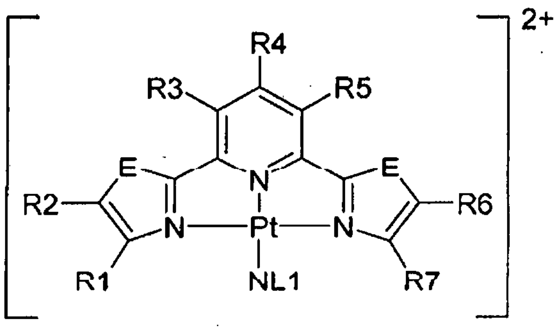

**97** (E = O, S, NR, where R is defined like R1 to R20)

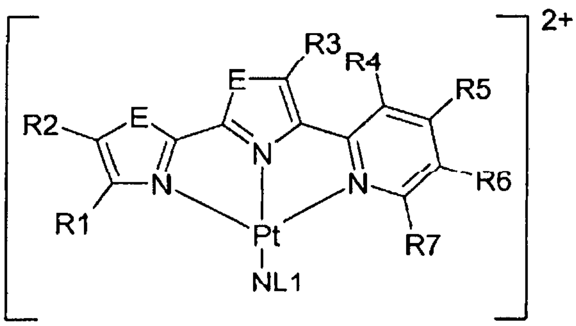

**98** (E = O, S, NR, where R is defined like R1 to R20)

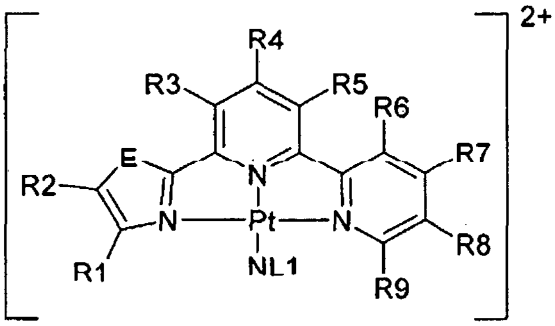

**99** (E = O, S, NR, where R is defined like R1 to R20)

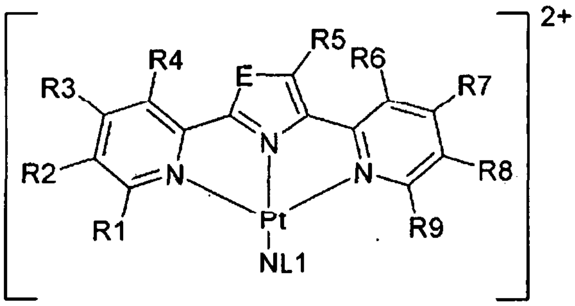

**100** (E = O, S, NR, where R is defined like R1 to R20)

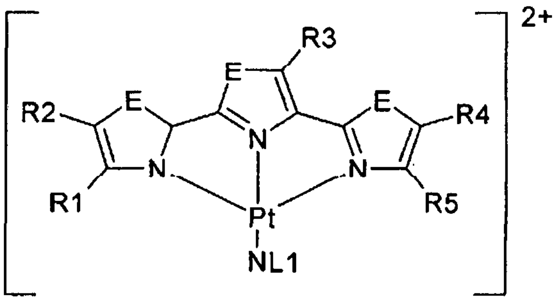

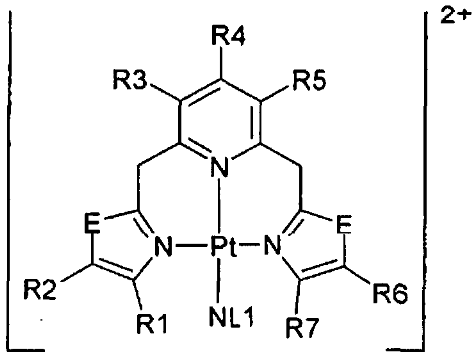

**101** **102**

(E = O, S, NR, where R is defined like R1 to R20)

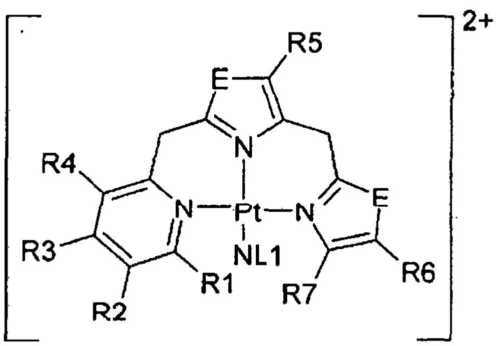

**103** (E = O, S, NR, where R is defined like R1 to R20)

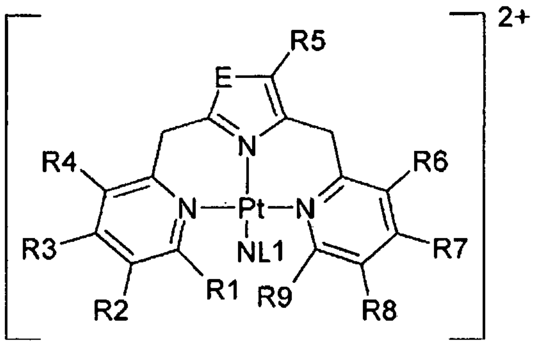

**104** (E = O, S, NR, where R is defined like R1 to R20)

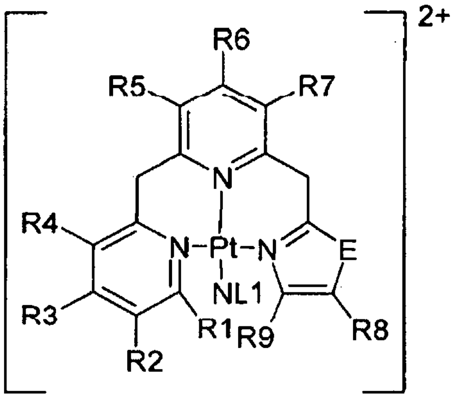

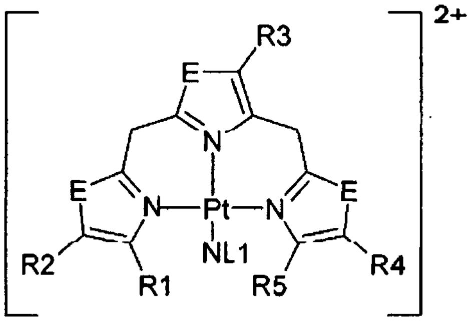

**105** **106**

(E = O, S, NR, where R is defined like R1 to R20)

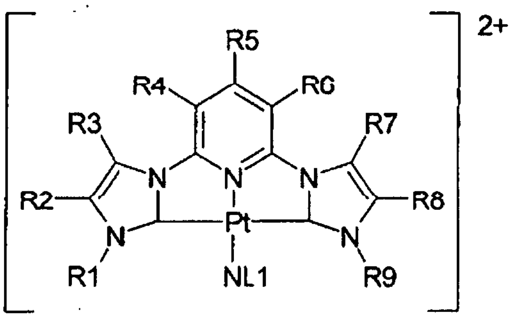

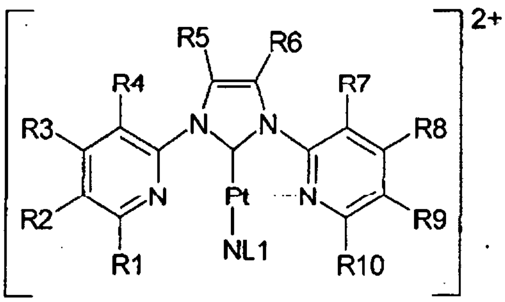

**107** **108**

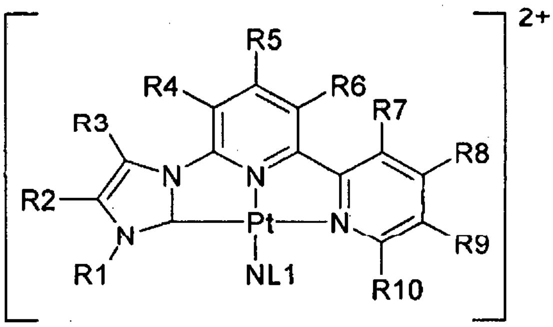

109

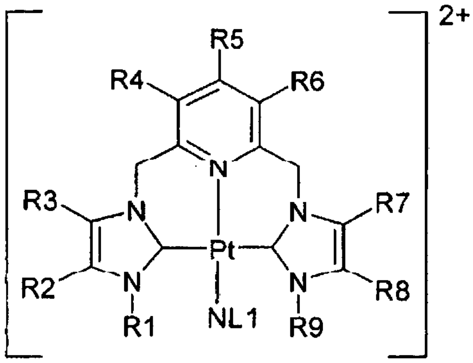

110

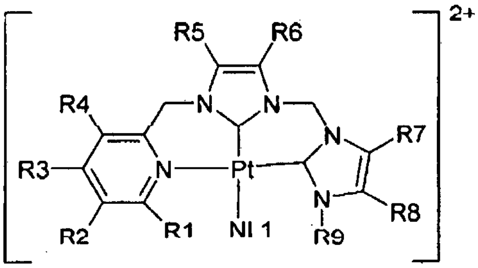

111

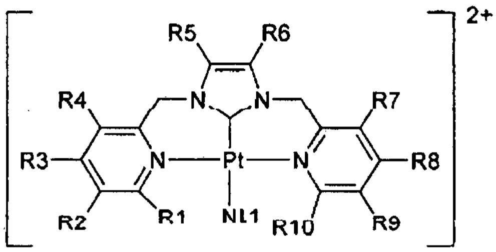

112

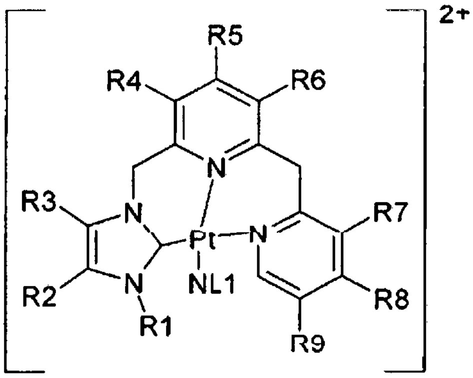

113

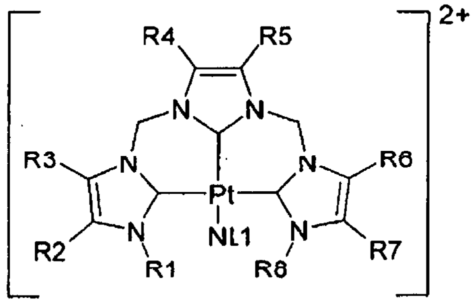

114

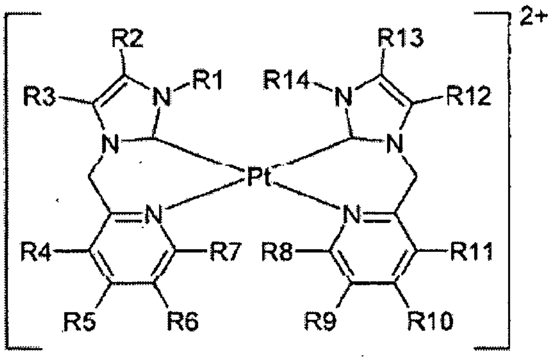

122

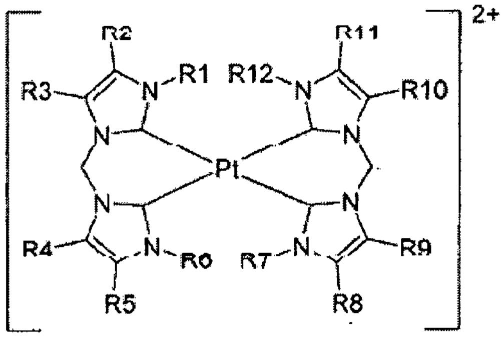

124

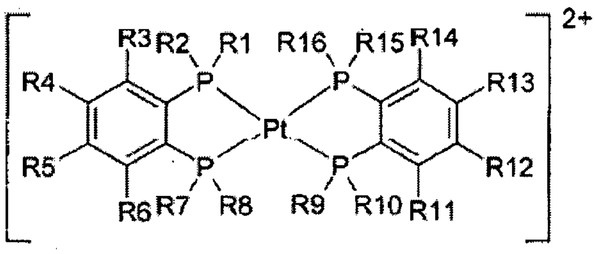

126

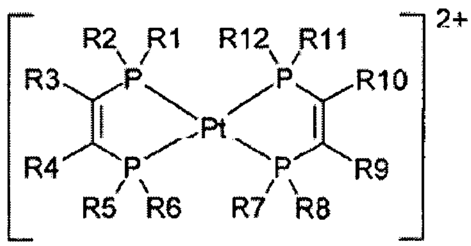

128

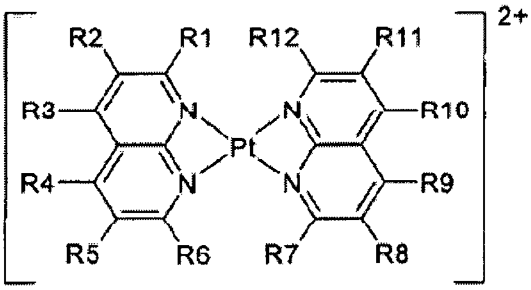

130

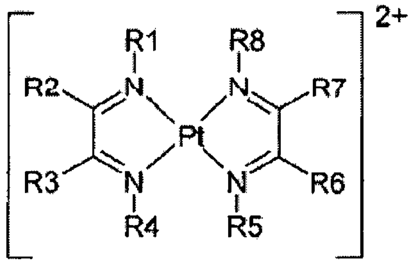

132

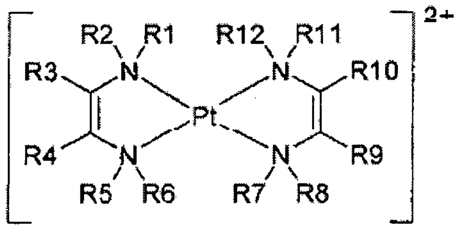

134

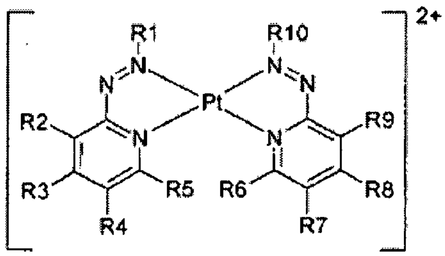

136

and $K_1 = [L1L2L3L4Pd(II)]^{2+}$ has the same formulae as the formulae indicated above for $K_1 = [L1L2L3L4Pt(II)]^{2+}$, but Pt(II) must be replaced by Pd(II);
and
$K_2 = [L5L6L7L8Pt(II)]^-$ is selected from:

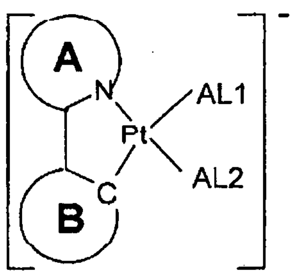

30

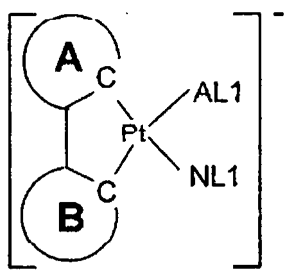

31

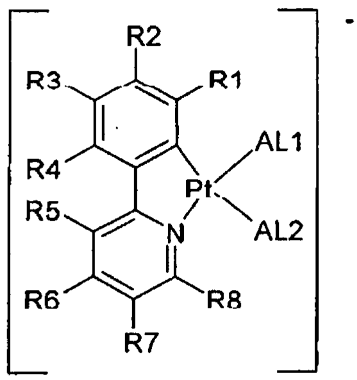

32

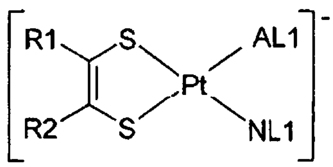

33

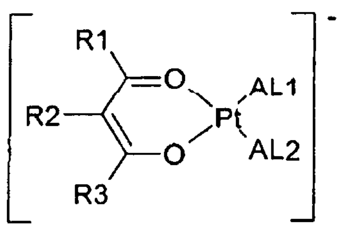

34

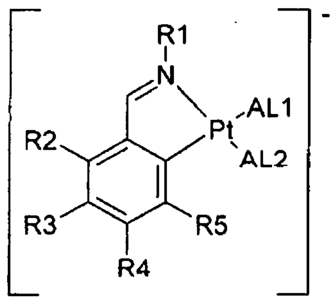

35

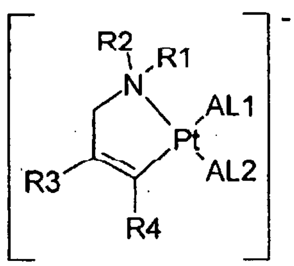

36

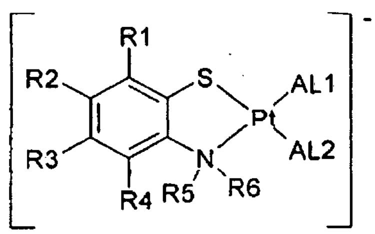

37

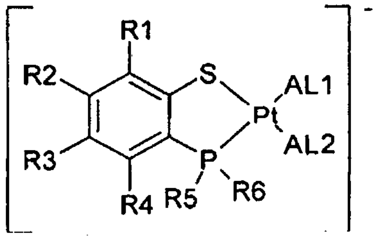

38

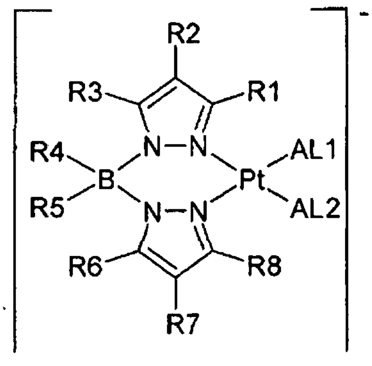

39

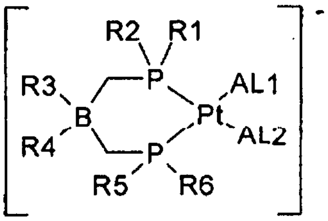

40

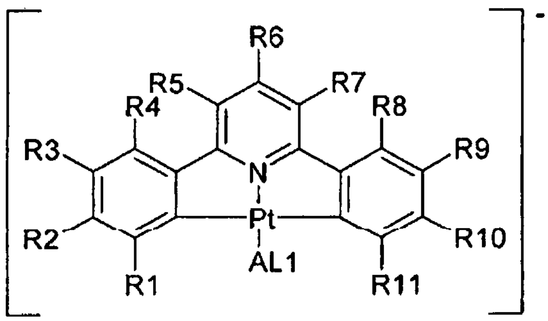

41

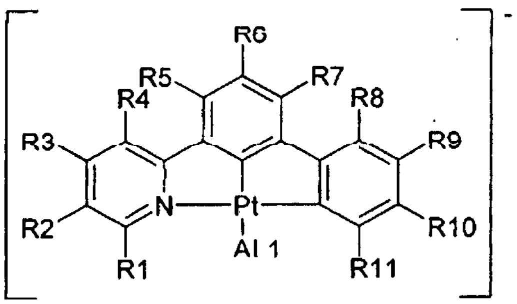

42

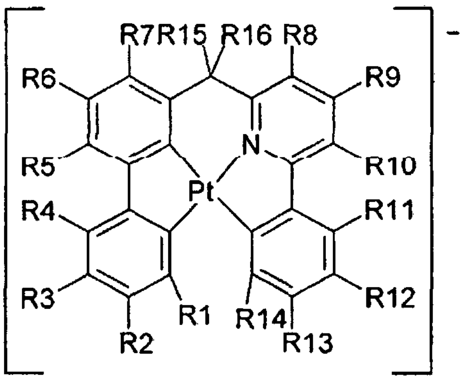

43

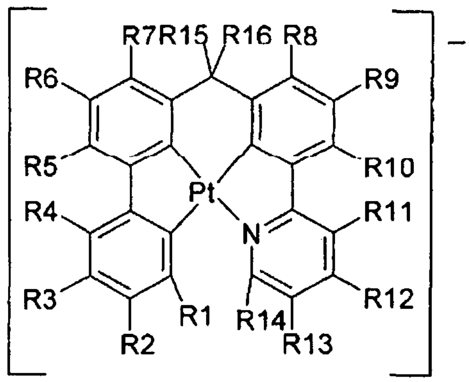

44

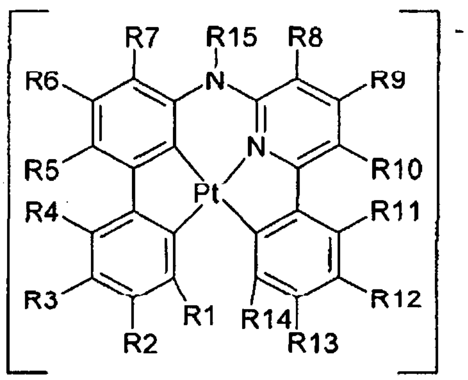

45

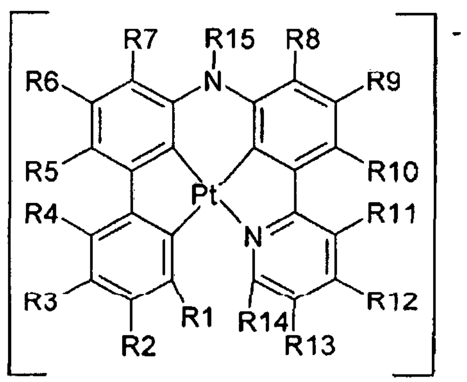

46

$K_2$ = [L5L6L7L8Pd(II)]$^-$ is selected from:

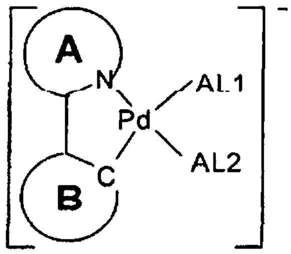

52

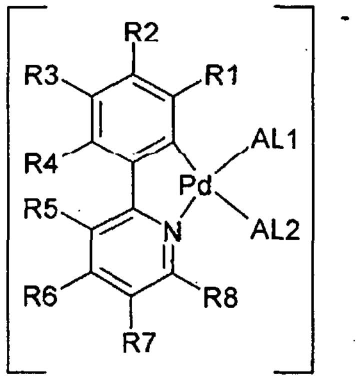

53

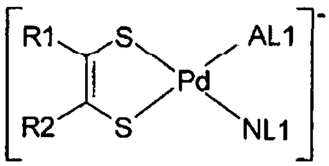

54

$K_2$ = [L5L6L7L8Pt(II)]$^{2-}$ is selected from:

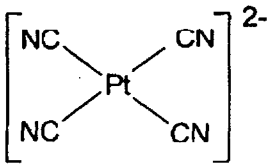

138

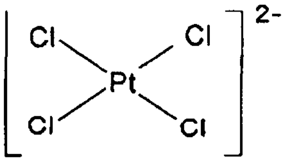

139

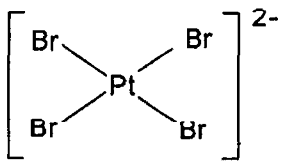

140

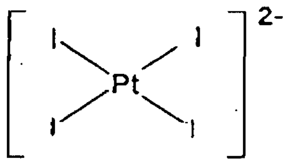

141

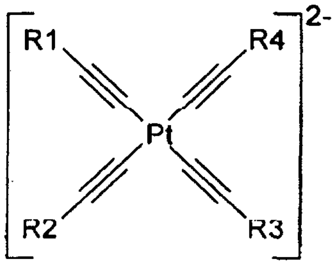

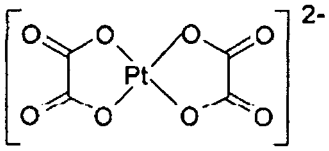

**142** **143**

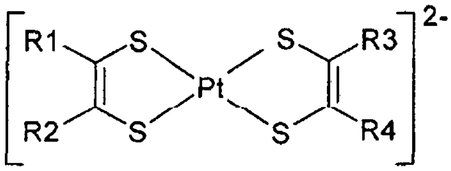

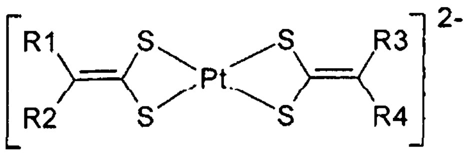

**144** **145**

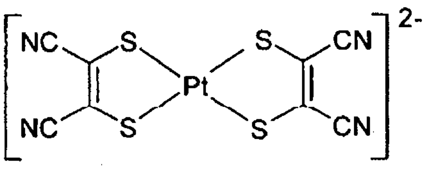

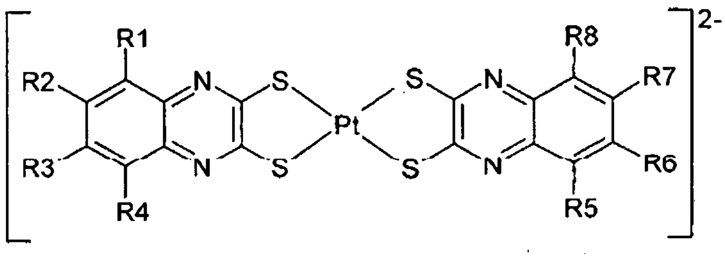

**146** **147**

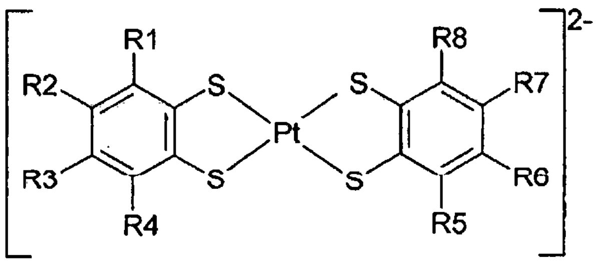

**148**

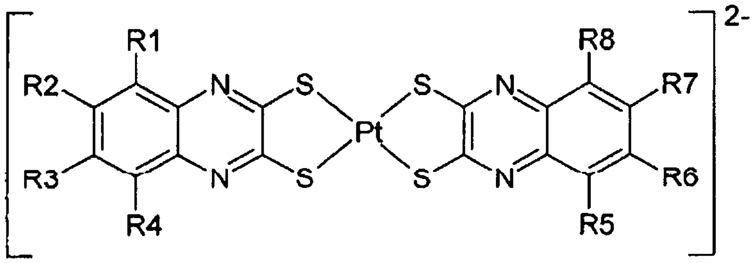

**149**

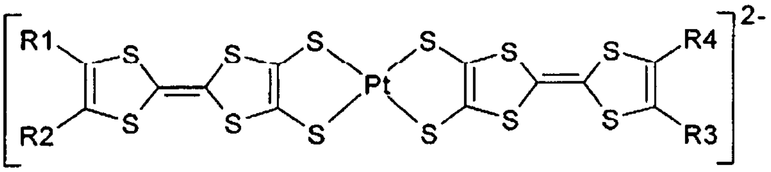

150

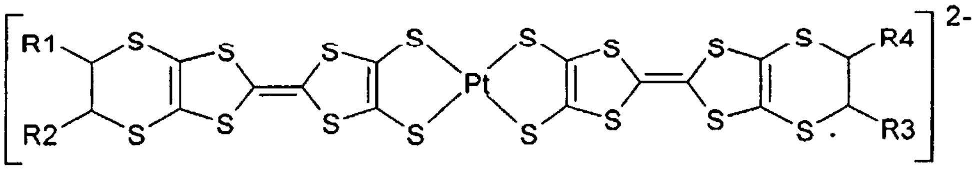

151

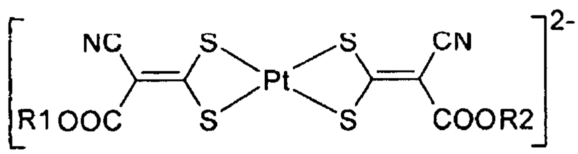

152

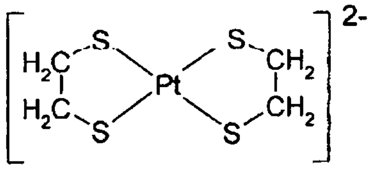

153

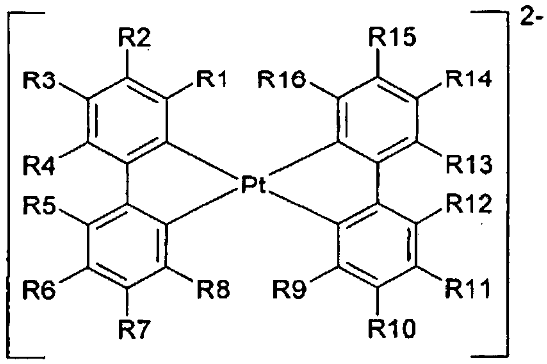

154

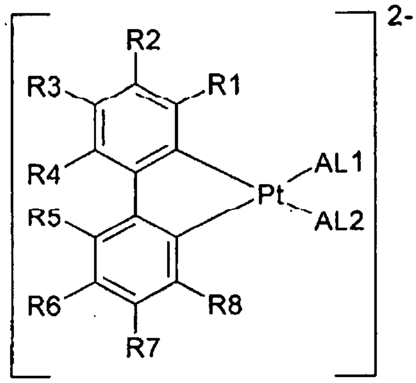

155

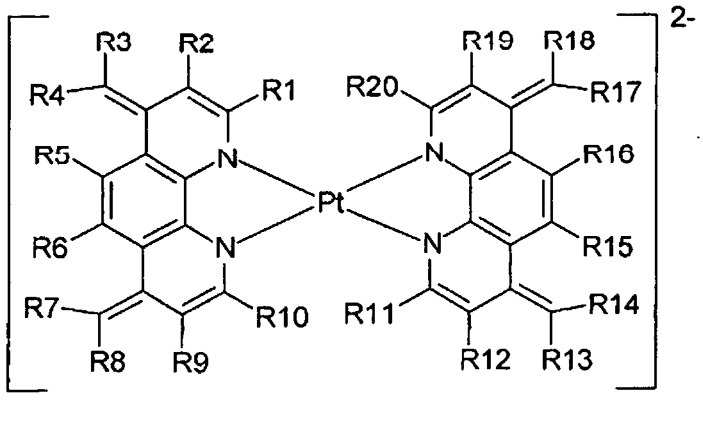

156

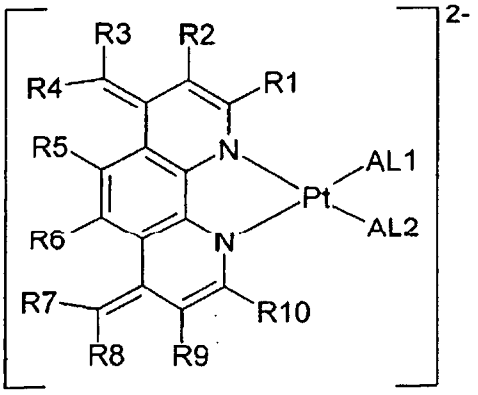

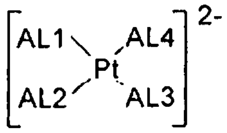

**157** **158**

and $K_2$ = $[L5L6L7L8Pd(II)]^{2-}$ is selected from the same formulae as the formulae indicated above for $K_1$ = $[L1L2L3L4Pt(II)]^{2-}$, but Pt(II) must be replaced by Pd(II);

where:

R1 to R20 are, identically or differently on each occurrence, one of the following groups: H, deuterium, F, Cl, Br, I, $N(R^{21})_2$, CN, $NO_2$, $Si(R^{21})_3$, $B(OR^{21})_2$, $C(=O)R^{21}$, $P(=O)(R^{21})_2$, $S(=O)R^{21}$, $S(=O)_2R^{21}$, $OSO_2R^{21}$, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, each of which may be substituted by one or more radicals $R^{21}$, where one or more non-adjacent $CH_2$ groups may be replaced by $R^{21}C=CR^{21}$, C=C, $Si(R^{21})_2$, $Ge(R^{21})_2$, $Sn(R^{21})_2$, C=O, C=S, C=Se, $C=NR^{21}$, $P(=O)(R^{21})$, SO, $SO_2$, $NR^{21}$, O, S or $CONR^{21}$ and where one or more H atoms may be replaced by F, Cl, Br, I, CN or $NO_2$, or an aromatic or heteroaromatic ring system having 5 to 60 aromatic ring atoms, which may in each case be substituted by one or more radicals $R^{21}$, or an aryloxy or heteroaryloxy group having 5 to 60 aromatic ring atoms, which may be substituted by one or more radicals $R^{21}$, or a diarylamino group, diheteroarylamino group or arylheteroarylamino group having 10 to 40 aromatic ring atoms, which may be substituted by one or more radicals $R^{21}$, or a combination of these systems; two or more of these substituents may also form a mono- or polycyclic, aliphatic, aromatic and/or benzo-fused ring system with one another;

$R^{21}$ is on each occurrence, identically or differently, H, F or an aliphatic, aromatic and/or heteroaromatic hydrocarbon radical having 1 to 20 C atoms, in which, in addition, one or more H atoms may be replaced by F; two or more substituents $R^{21}$ here may also form a mono- or polycyclic, aliphatic or aromatic ring system with one another;

NL1 is a neutral ligand, in particular selected from carbon monoxide, isonitriles, amines, phosphines, phosphites, arsines, stibines and nitrogen-containing heterocycles;

AL1, AL2, AL3, AL4 are each, identically or differently on each occurrence, an anionic ligand, in particular selected from hydride, deute-ride, the halides F, Cl, Br and I, alkylacetylides, arylacetylides, aryl groups, alkyl groups, alkenyl groups, borates, cyanide, cyanate, isocyanate, thiocyanate, isothiocyanate, aliphatic or aromatic alcoholates, aliphatic or aromatic thioalcoholates, amides, carboxylates and anionic, nitrogen-containing heterocycles.

**2.** OLED according to Claim 1, **characterised in that** the oligomer has columnar structures $-K_1-K_2-K_1-K_2-$, where

$K_1$ stands for a singly positively charged complex (formula (I)) and $K_2$ stands for a singly negatively charged complex (formula (II)) or $K_1$ stands for a doubly positively charged complex (formula (I)) and $K_2$ stands for a doubly negatively charged complex (formula (II)),

or **in that** the oligomer has the columnar structure $-K_1-K_2-K_3-K_1-K_2-K_3-K_1-$, where

$K_1$ represents a doubly positively charged complex of the formula (I) and
$K_2$ and $K_3$ represent a singly negatively charged complex of the formula (II) or
$K_1$ represents a doubly negatively charged complex and

$K_2$ and $K_3$ represent a singly positively charged complex or
$K_1$ represents a triply positively charged complex and
$K_2$ represents a doubly negatively charged complex and
$K_3$ represents a singly negatively charged complex or
$K_1$ represents a triply positively charged complex and
$K_2$ represents a singly negatively charged complex and
$K_3$ represents a doubly negatively charged complex.

**3.** OLED according to Claim 1 or 2, **characterised in that**, in order to increase the solubilisability, at least one of the ligands L1 to L8 contains a large organic group, in particular one or more C1-C40, preferably C1-C30, alkyl groups, or one or more polysiloxane groups $(-OSiR_2)_nOSiR'_3$, where n = 1-200, in particular 5-30, or one or more polyether groups, where R and R' have the same meaning as R1 to R20 in Claim 1, but preferably C1-C6 alkyl groups.

**4.** OLED containing oligomers built up from
at least one positively charged metal complex and
at least one negatively charged metal complex,
where the metal complexes have the

$$\text{formula (I) } K_1 = [L1L2L3L4M1]^{n+}$$

and

$$\text{formula (II) } K_2 = [L5L6L7L8M2]^{n-},$$

where

M1 and M2 represent a metal centre selected from Ir(I), Rh(I), Pt(II), Pd(II) and Au(III), where M1 and M2 represent different metal centres, and
L1 - L4 and L5 - L8 each represent a neutral or charged ligand, where two or more of L1 - L4 and L5 - L8 may also be linked to one another, and where
n = 1 or 2.

**5.** OLED according to Claim 4, **characterised in that** a metal centre selected from Ir, Rh, Pt, Pd and Au is present in the compound in a proportion of 10 to 90%, and at least one metal selected from Ir, Rh, Pt, Pd and Au, which is different from the first metal, is present in a proportion of 10 to 90%.

**6.** OLED according to Claim 4 or 5, **characterised in that** it has at least three different metal central ions selected from Ir, Rh, Pt, Pd and Au.

**7.** Oligomer built up from at least one double-complex salt, where the double-complex salt has the formula (IV):

$$[L1L2L3L4M1]^{n+}_{1-x}[L1L2L3L4M2]^{n+}_{x}[L5L6L7L8M1]^{n-}$$

formula (IV)

in which

$0.00001 \leq x \leq 0.99999$ and
preferably M1 = Pd(II) and M2 = Pt(II).

**8.** Process for the production of an OLED according to one or more of Claims 1 to 6, in which metal-complex salts of the formulae (I) and (II) given in Claim 1 are applied in the form of a dispersion or where components of the formula (I) are introduced in the form of a solution and components of the formula (II) are introduced by diffusion.

**9.** Use of oligomers according to Claim 7 in an OLED.

## Revendications

**1.** OLED contenant des oligomères construits à partir de complexes métalliques chargés différemment, comprenant au moins un complexe métallique chargé positivement et au moins un complexe métallique chargé négativement, dans laquelle les complexes métalliques présentent :

la formule (I) $K_1 = [L1L2L3L4M1]^{n+}$

et

la formule (II) $K_2 = [L5L6L7L8M2]^{n-}$,

dans lesquelles M1 et M2 représentent un centre métal et dans lesquelles l'oligomère est un sel à deux complexes, où :

$K_1 = [L_1L2L3L4Pt(II)]^+$ et $K_2 = [L5L6L7L8Pt(II)]^-$ ; ou
$K_1 = [L1L2L3L4Pd(II)]^+$ et $K_2 = [L5L6L7L8Pd(II)]^-$ ; ou
$K_1 = [L1L2L3L4Pt(II)]^{2+}$ et $K_2 = [L5L6L7L8Pt(II)]^{2-}$ ; ou
$K_1 = [L1\ L2L3L4Pd(II)]^{2+}$ et $K_2 = [L5L6L7L8Pd(II)]^{2-}$ ;

où :

$K_1 = [L1L2L3L4Pt(II)]^+$ présente l'une des formules qui suivent :

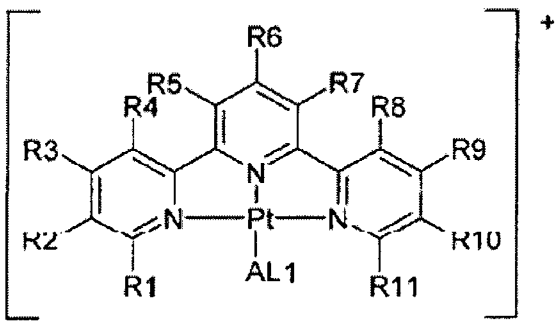

7

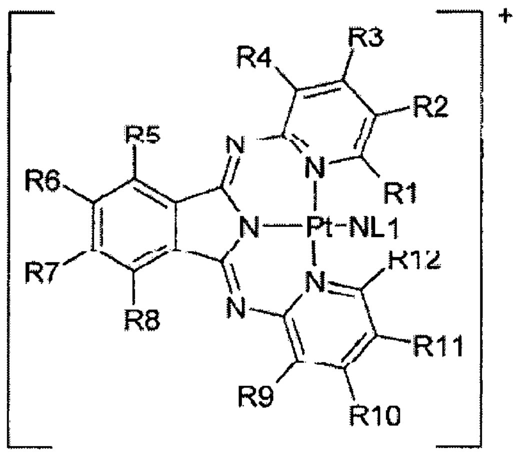

8

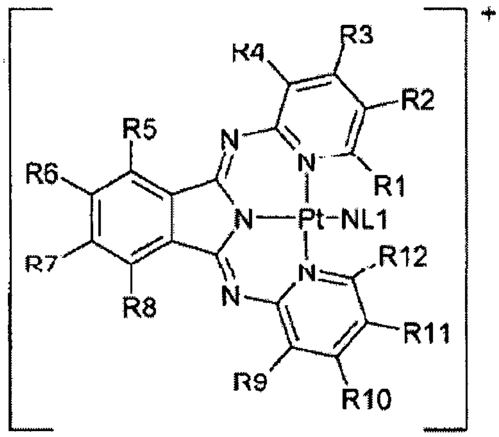
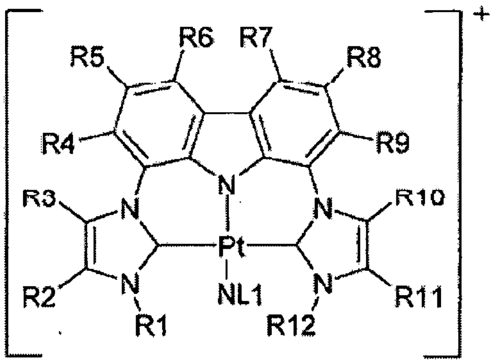

9 10

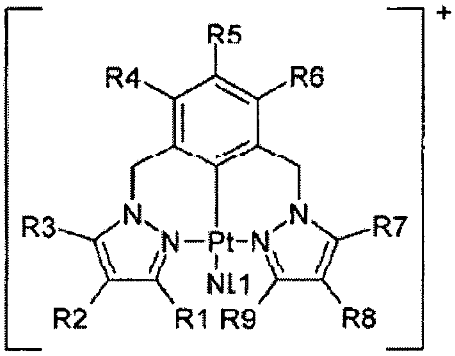
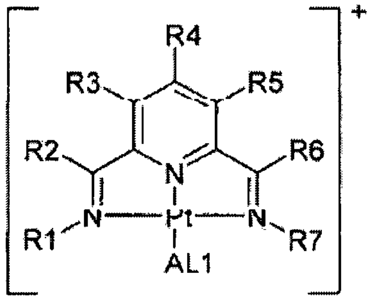

11 12

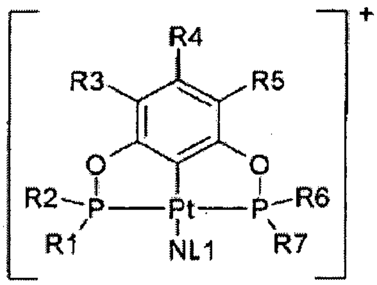
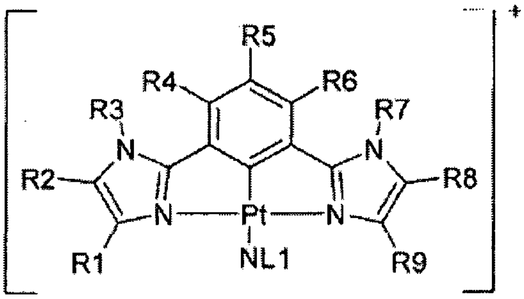

18 22

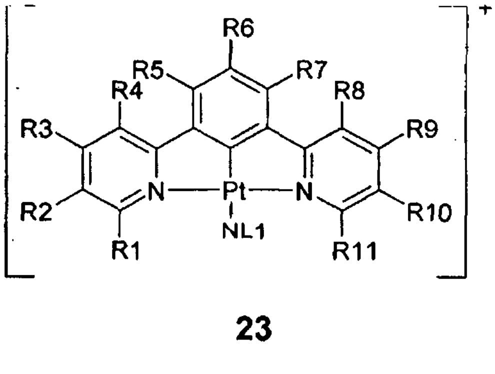
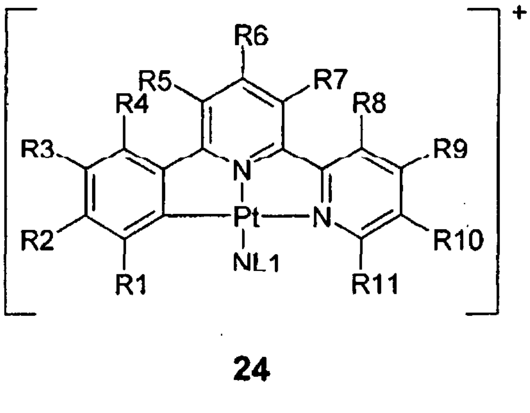

23 24

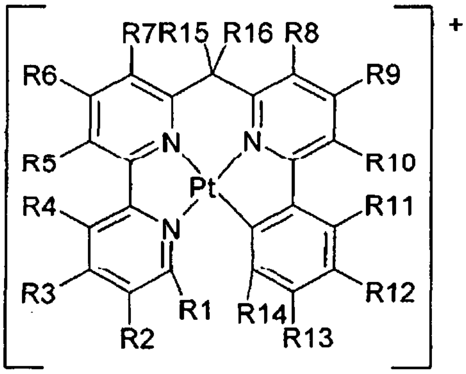

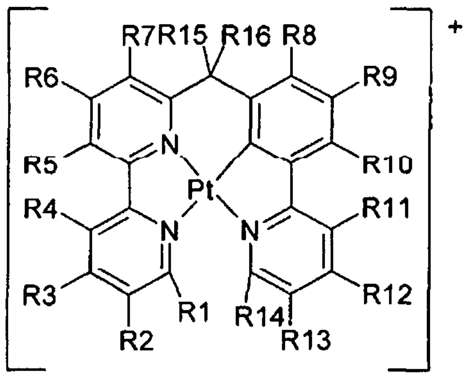

**26** **27**

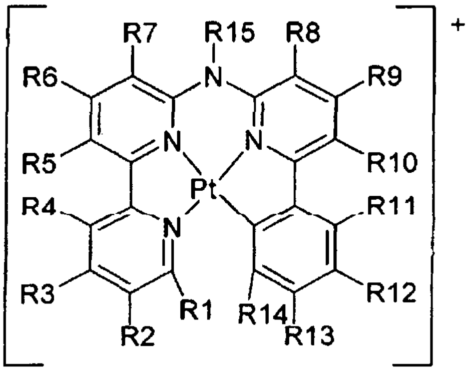

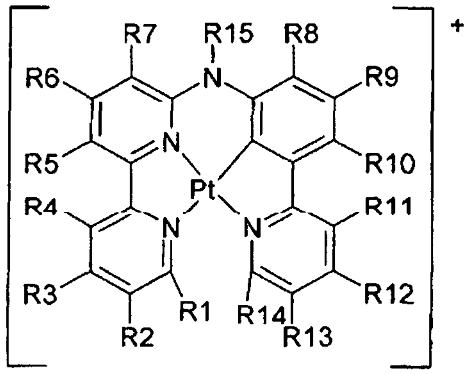

**28** **29**

$K_1$ = $[L1L2L3L4Pd(II)]^+$ présente l'une des formules qui suivent :

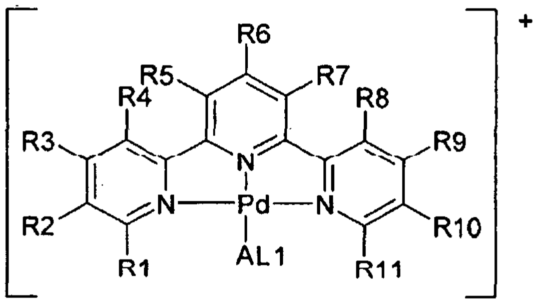

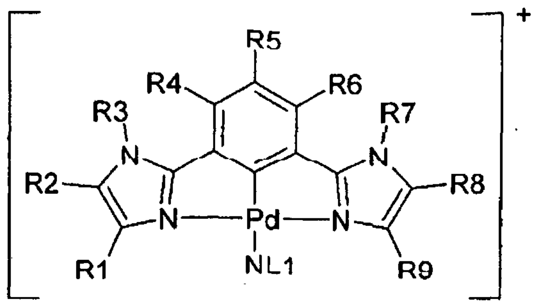

**50** **51**

$K_1$ = $[L1L2L3L4Pt(II)]^{2+}$ présente l'une des formules qui suivent :

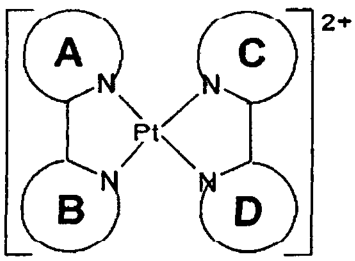

83

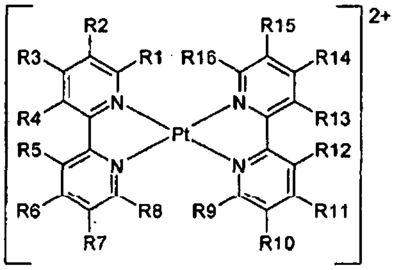

85

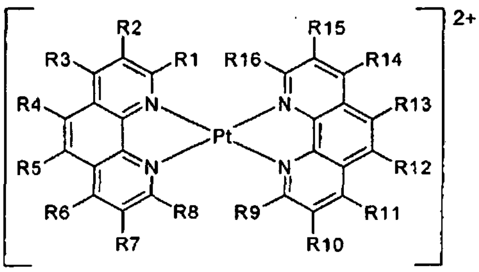

86

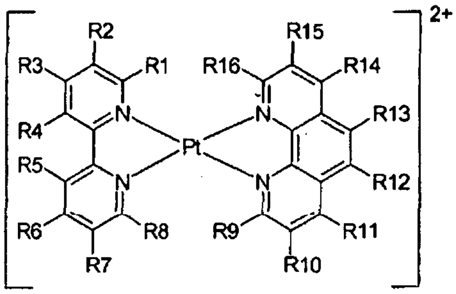

87

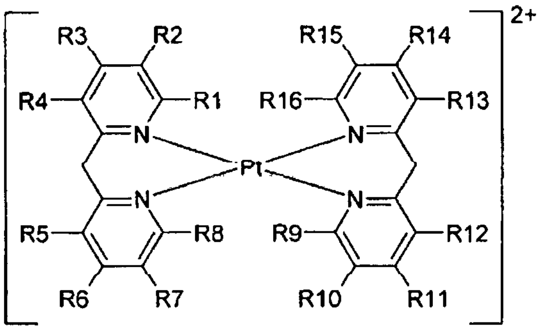

90

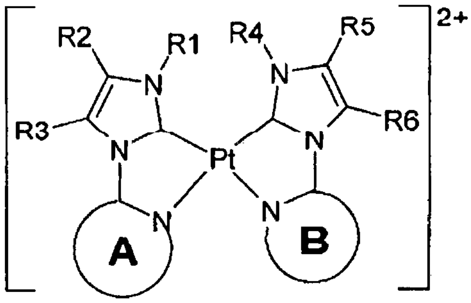

92

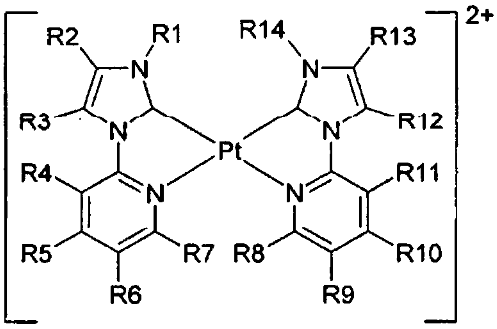

94

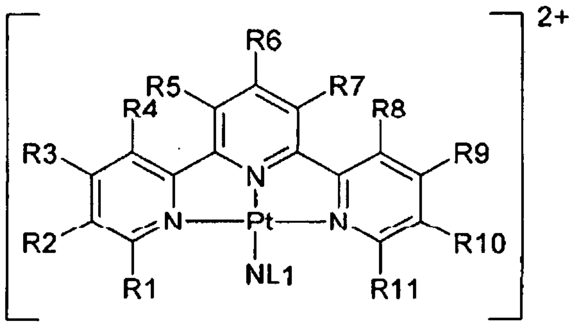

96

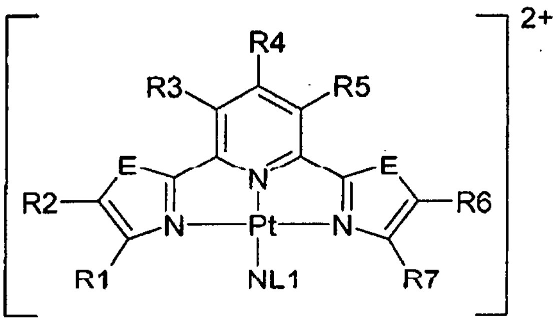

**97** (E = O, S, NR, où R est défini comme R1 à R20)

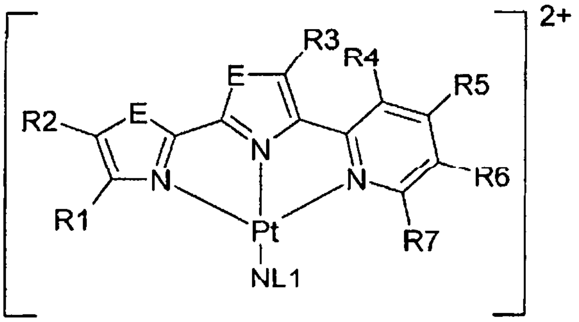

**98** (E = O, S, NR, où R est défini comme R1 à R20)

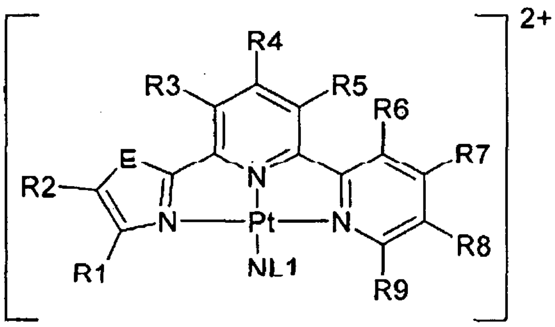

**99** (E = O, S, NR, où R est défini comme R1 à R20)

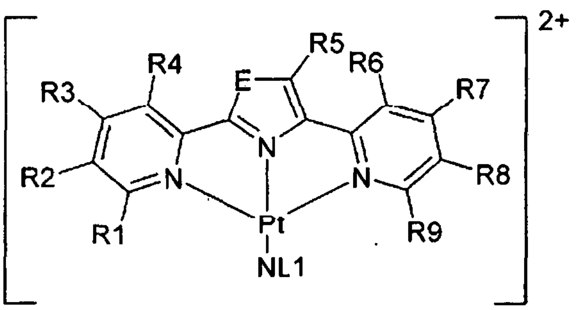

**100** (E = O, S, NR, où R est défini comme R1 à R20)

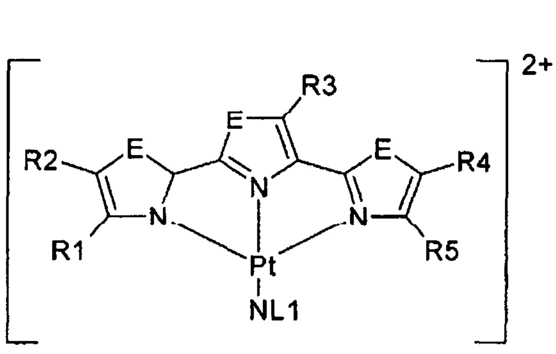

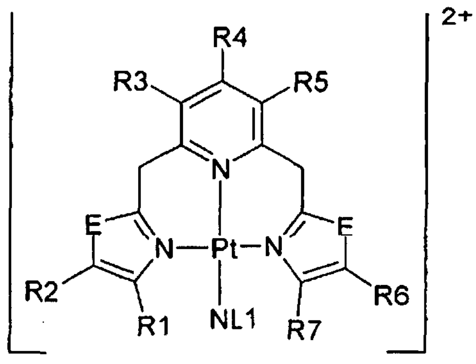

**101** **102**

(E = O, S, NR, où R est défini comme R1 à R20)

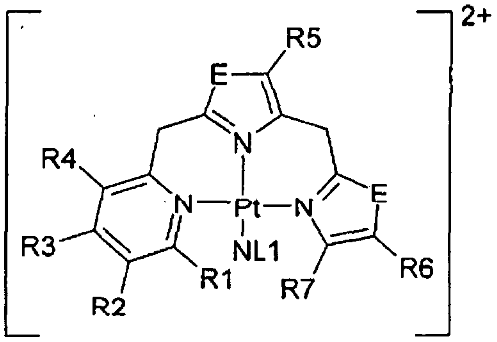

**103** (E = O, S, NR, où R est défini comme R1 à R20)

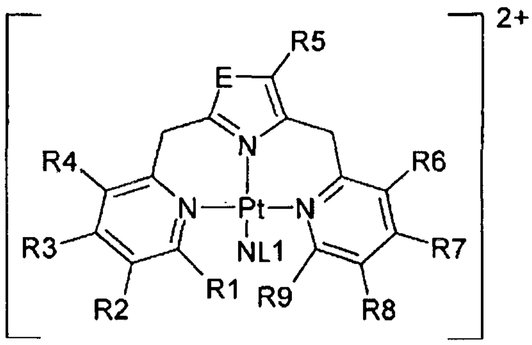

**104** (E = O, S, NR, où R est défini comme R1 à R20)

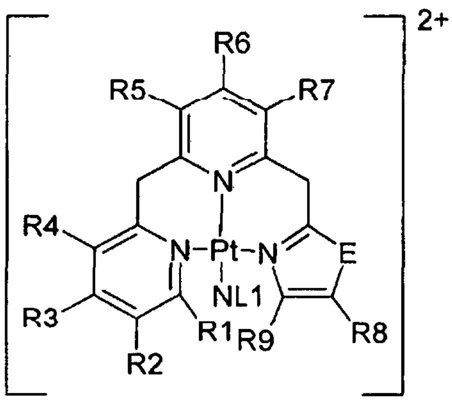

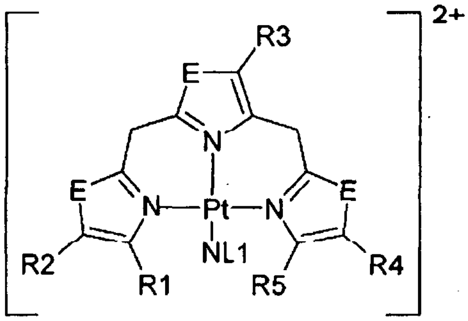

**105** **106**

(E = O, S, NR, où R est défini comme R1 à R20)

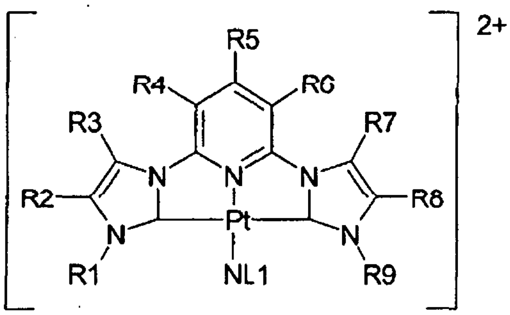

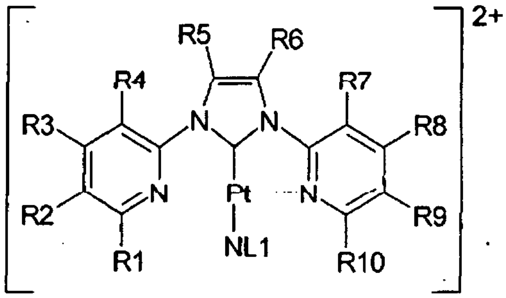

**107** **108**

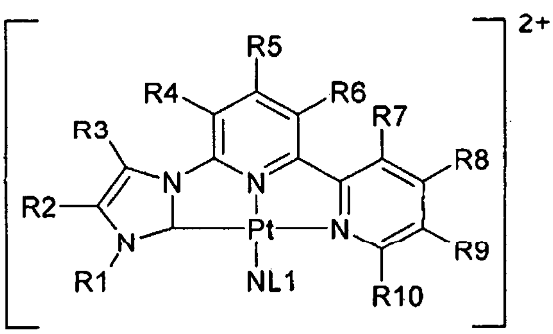

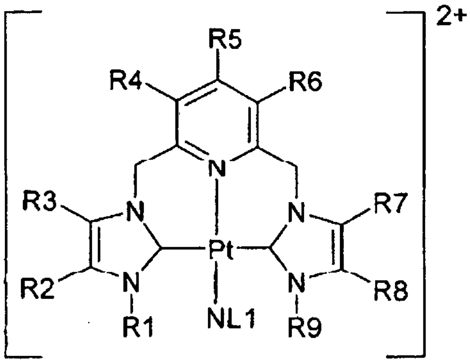

**109** **110**

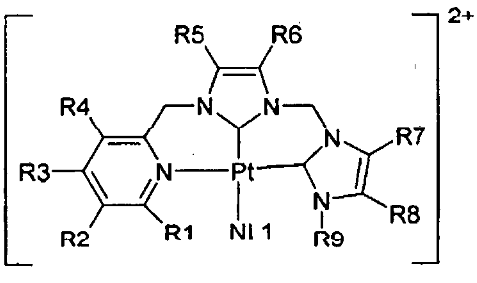

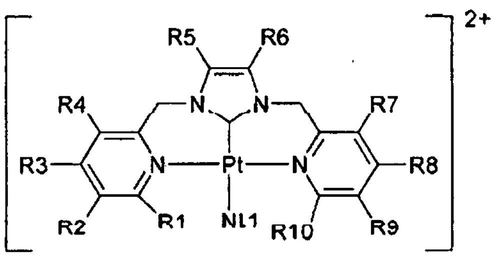

**111** **112**

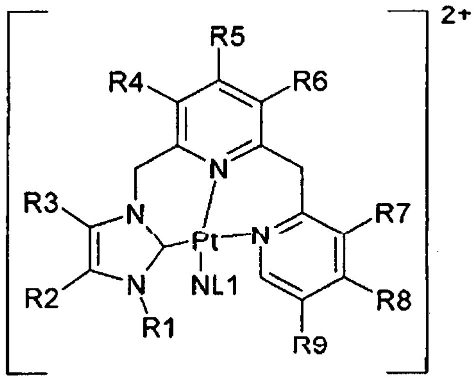

113

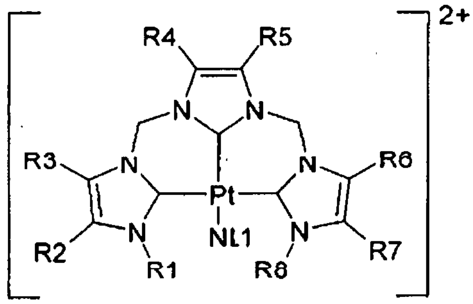

114

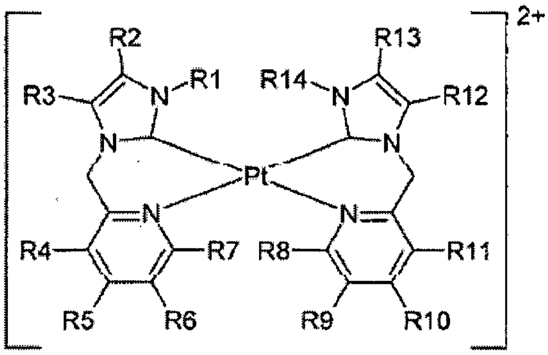

122

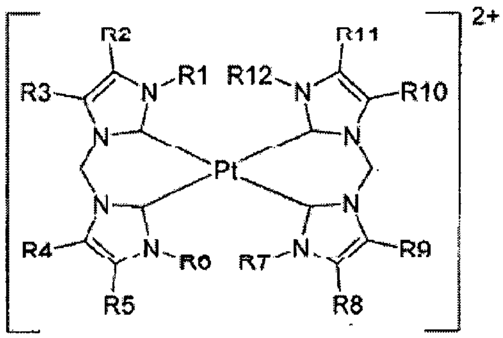

124

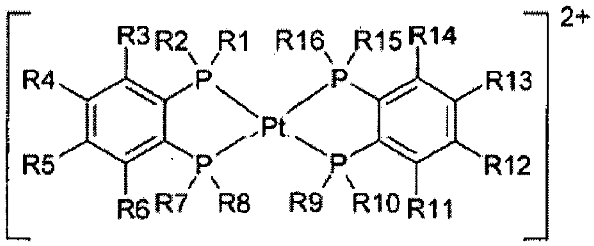

126

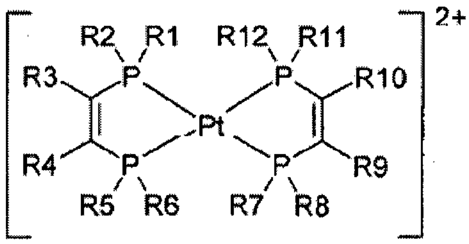

128

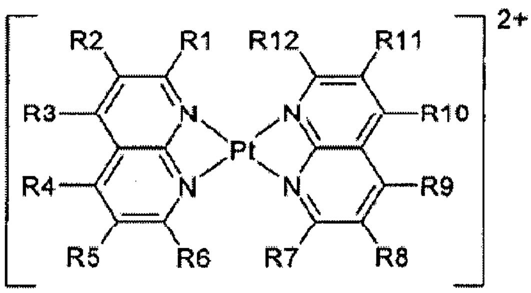

130

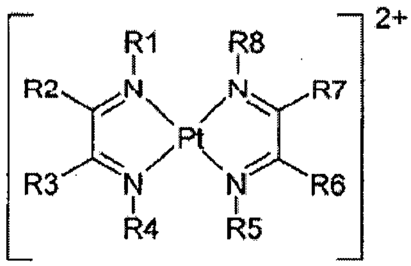

132

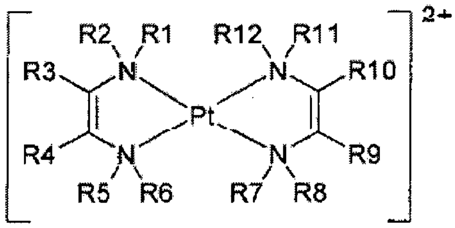

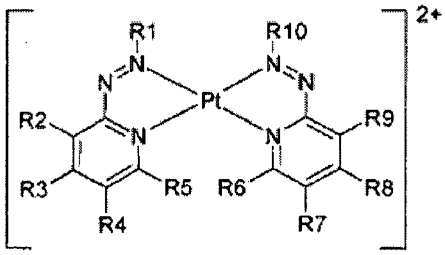

**134** **136**

et $K_1$ = $[L1L2L3L4Pd(II)]^{2+}$ présente les mêmes formules que les formules indiquées ci avant pour $K_1$ = $[L1L2L3L4Pt(II)]^{2+}$, mais Pt(II) doit être remplacé par Pd(II) ;
et
$K_2$ = $[L5L6L7L8Pt(II)]^-$ est choisi parmi :

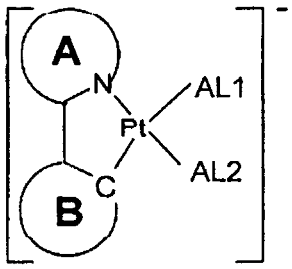

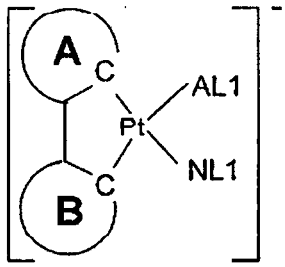

**30** **31**

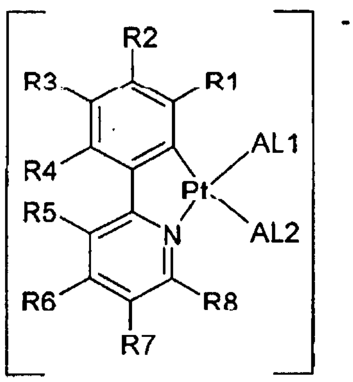

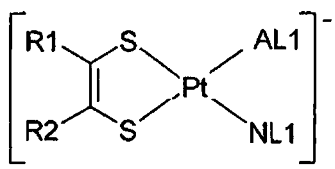

**32** **33**

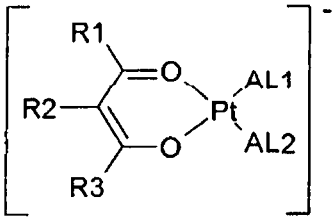

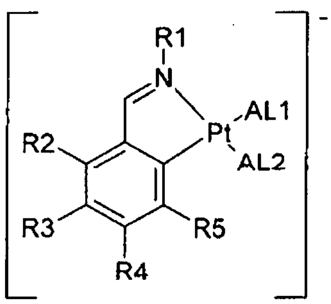

**34** **35**

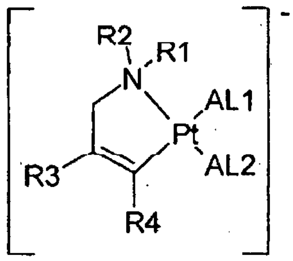

36

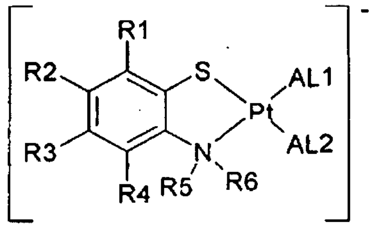

37

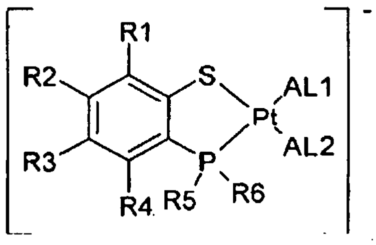

38

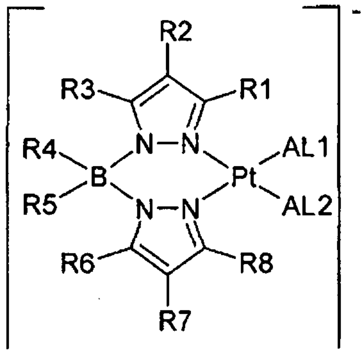

39

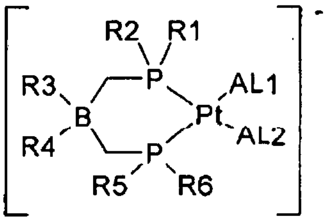

40

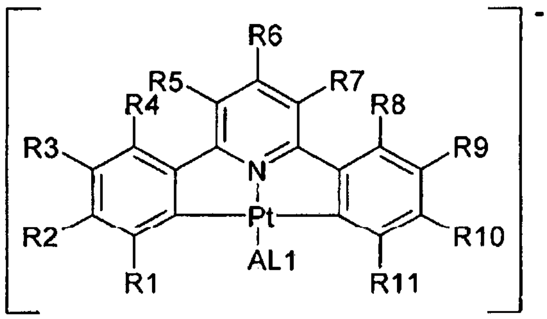

41

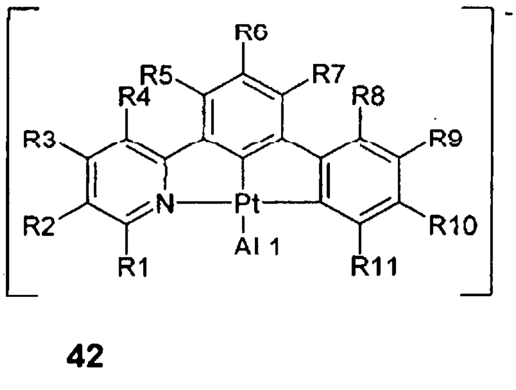

42

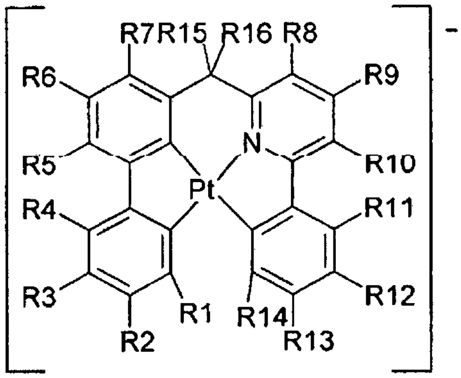

43

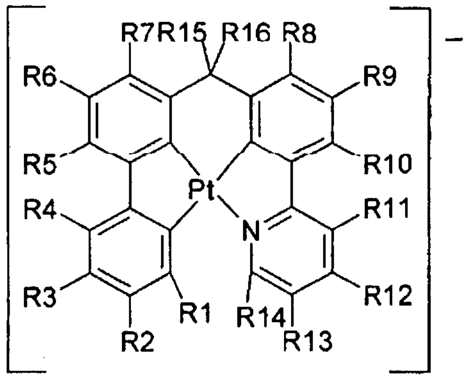

44

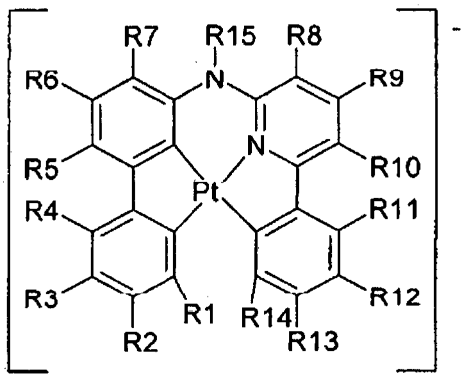

45

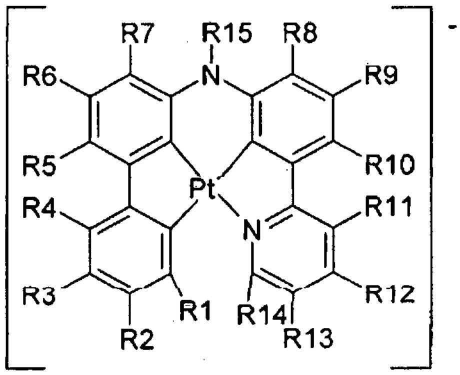

46

$K_2$ = [L5L6L7L8Pd(II)]$^-$ est choisi parmi :

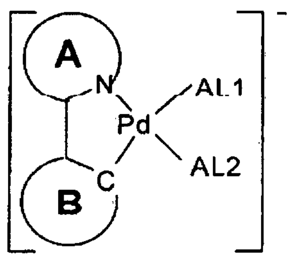

52

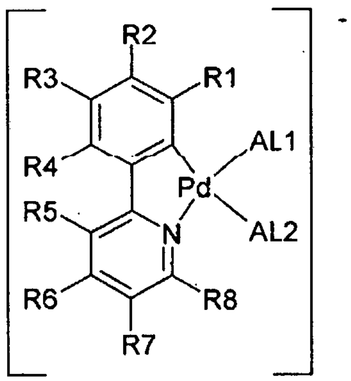

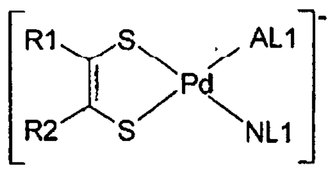

**53** **54**

$K_2$ = $[L5L6L7L8Pt(II)]^{2-}$ est choisi parmi :

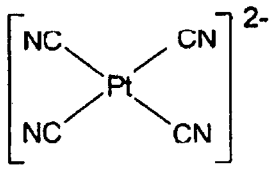

**138**

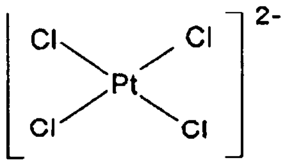

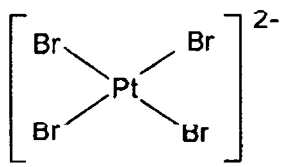

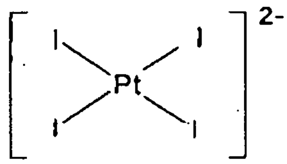

**139** **140** **141**

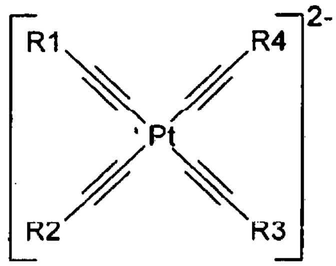

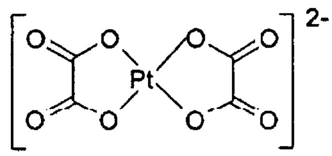

**142** **143**

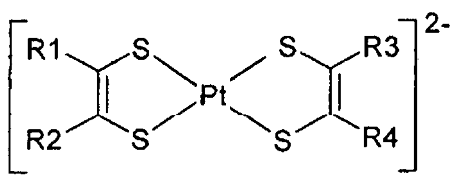

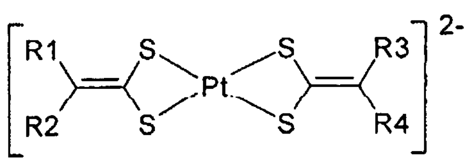

**144** **145**

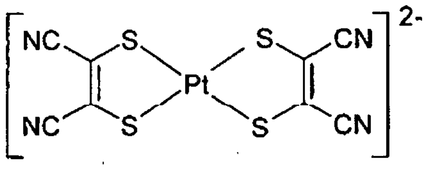

146

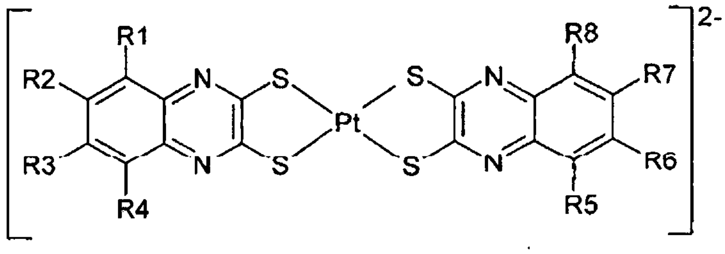

147

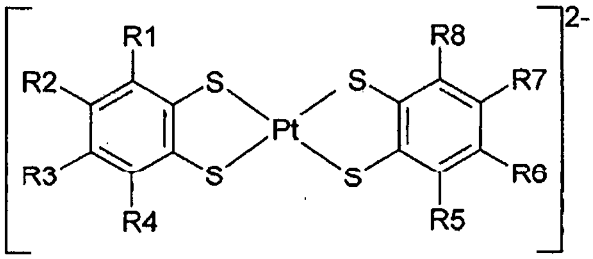

148

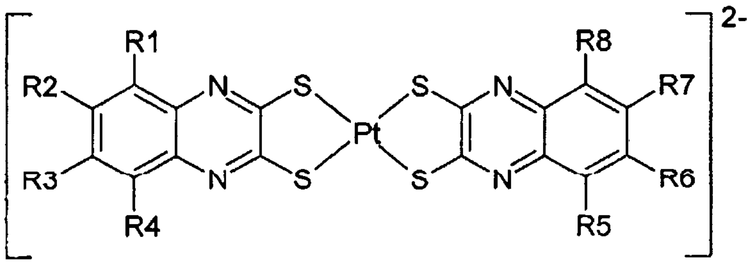

149

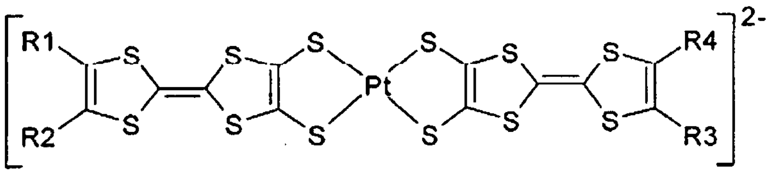

150

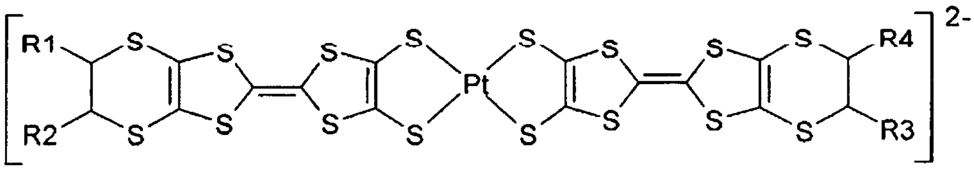

151

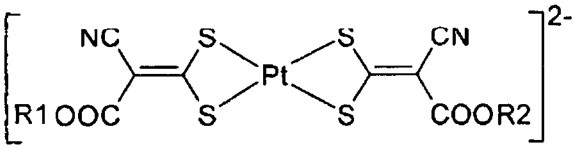

152

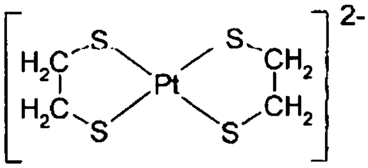

153

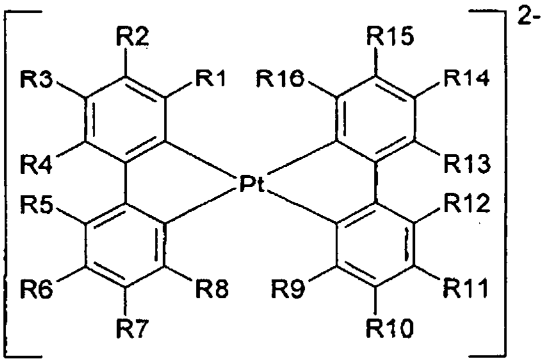

154

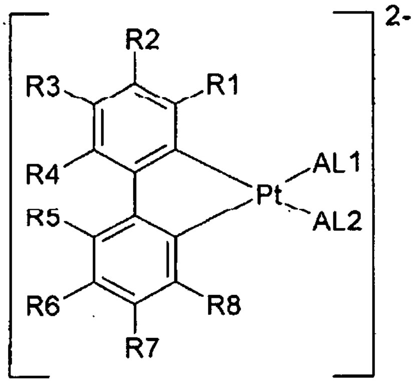

155

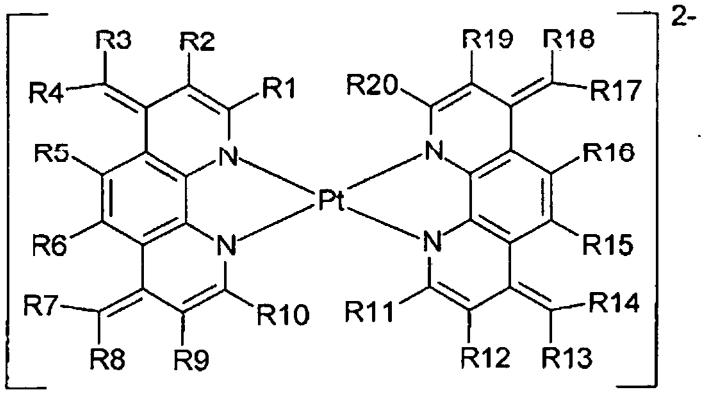

156

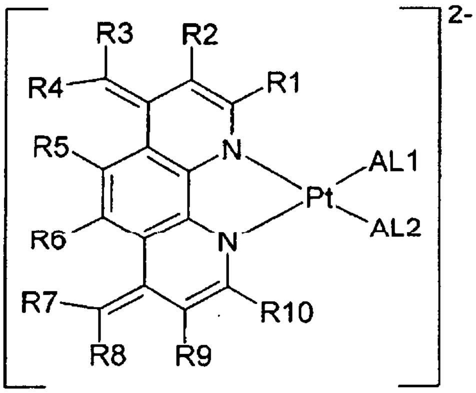

157

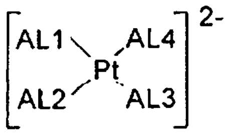

158

et $K_2$ = $[L5L6L7L8Pd(II)]^{2-}$ est choisi parmi les mêmes formules que les formules indiquées ci avant pour $K_1$ =

$[L1L2L3L4Pt(II)]^{2-}$, mais Pt(II) doit être remplacé par Pd(II) ;

où :

R1 à R20 sont, de manière identique ou différente pour chaque occurrence, l'un des groupes qui suivent : H, deutérium, F, Cl, Br, I, $N(R^{21})_2$, CN, $NO_2$, $Si(R^{21})_3$, $B(OR^{21})_2$, $C(=O)R^{21}$, $P(=O)(R^{21})_2$, $S(=O)R^{21}$, $S(=O)_2R^{21}$, $OSO_2R^{21}$, un groupe alkyle, alcoxy ou thio-alcoxy en chaîne droite comportant 1 à 40 atome(s) de C ou un groupe alkényle ou alkynyle en chaîne droite comportant 2 à 40 atomes de C ou un groupe alkyle, alkényle, alkynyle, alcoxy ou thio-alcoxy ramifié ou cyclique comportant 3 à 40 atomes de C, dont chacun peut être substitué par un radical ou plusieurs radicaux $R^{21}$, où un ou plusieurs groupe(s) $CH_2$ non adjacents peut/peuvent être remplacé(s) par $R^{21}C=CR^{21}$, C≡C, $Si(R^{21})_2$, $Ge(R^{21})_2$, $Sn(R^{21})_2$, C=O, C=S, C=Se, $C=NR^{21}$, $P(=O)(R^{21})$, SO, $SO_2$, $NR^{21}$, O, S ou $CONR^{21}$ et où un ou plusieurs atome(s) de H peut/peuvent être remplacé(s) par F, Cl, Br, I, CN ou $NO_2$, ou un système de cycle aromatique ou hétéroaromatique comportant 5 à 60 atomes de cycle aromatique, lequel peut dans chaque cas être substitué par un radical ou plusieurs radicaux $R^{21}$, ou un groupe aryloxy ou hétéroaryloxy comportant 5 à 60 atomes de cycle aromatique, lequel peut être substitué par un radical ou plusieurs radicaux $R^{21}$, ou un groupe diarylamino, un groupe dihétéroarylamino ou un groupe arylhétéroarylamino comportant 10 à 40 atomes de cycle aromatique, lequel peut être substitué par un radical ou plusieurs radicaux $R^{21}$, ou une combinaison de ces systèmes ; deux ou plus de ces substituants peuvent également former un système de cycle aliphatique, aromatique et/ou benzo-fusionné monocyclique ou polycyclique l'un avec l'autre ou les uns avec les autres ;

$R^{21}$ est, pour chaque occurrence, de manière identique ou différente, H, F ou un radical hydrocarbone aliphatique, aromatique et/ou hétéroaromatique comportant 1 à 20 atome(s) de C, où, en outre, un ou plusieurs atome(s) de H peut/peuvent être remplacé(s) par F ; deux substituants $R^{21}$ ou plus ici peuvent également former un système de cycle aliphatique ou aromatique monocyclique ou polycyclique l'un avec l'autre ou les uns avec les autres ;

NL1 est un ligand neutre, en particulier choisi parmi le monoxyde de carbone, les isonitriles, les amines, les phosphines, les phosphites, les arsines, les stibines et les hétérocycles contenant de l'azote ;

AL1, AL2, AL3, AL4 sont chacun, de manière identique ou différente pour chaque occurrence, un ligand anionique, en particulier choisi parmi hydrure, deutérure, les halogénures F, Cl, Br et I, les alkyl-acétylures, les arylacétylures, les groupes aryle, les groupes alkyle, les groupes alkényle, les borates, le cyanure, le cyanate, l'isocyanate, le thiocyanate, l'isothiocyanate, les alcoolates aliphatiques ou aromatiques, les thioalcoolates aliphatiques ou aromatiques, les amides, les carboxylates et les hétérocycles contenant de l'azote anioniques.

**2.** OLED selon la revendication 1, **caractérisée en ce que** l'oligomère présente des structures colonnaires $-K_1-K_2-K_1-K_2-$,
où :

$K_1$ représente un complexe chargé positivement simplement (formule (I)) et $K_2$ représente un complexe chargé négativement simplement (formule (II)) ou $K_1$ représente un complexe chargé positivement doublement (formule (I)) et $K_2$ représente un complexe chargé négativement doublement (formule (II)),

ou **en ce que** l'oligomère présente la structure colonnaire $-K_1-K_2-K_3-K_1-K_2-K_3-K_1-$, où :

$K_1$ représente un complexe chargé positivement doublement de la formule (I) et
$K_2$ et $K_3$ représentent un complexe chargé négativement simplement de la formule (II) ou
$K_1$ représente un complexe chargé négativement doublement et
$K_2$ et $K_3$ représentent un complexe chargé positivement simplement ou
$K_1$ représente un complexe chargé positivement triplement et
$K_2$ représente un complexe chargé négativement doublement et
$K_3$ représente un complexe chargé négativement simplement ou
$K_1$ représente un complexe chargé positivement triplement et
$K_2$ représente un complexe chargé négativement simplement et
$K_3$ représente un complexe chargé négativement doublement.

**3.** OLED selon la revendication 1 ou 2, **caractérisée en ce que**, afin d'augmenter la solubilisabilité, au moins l'un des ligands L1 à L8 contient un groupe organique grand, en particulier un ou plusieurs groupe(s) alkyle C1-C40, de façon préférable C1-C30, ou un ou plusieurs groupe(s) polysiloxane $(-OSiR_2)_nOSiR'_3$, où n = 1-200, en particulier 5-30, ou un ou plusieurs groupe(s) polyéther, où R et R' présentent la même signification que R1 à R20 selon la

revendication 1, mais de façon préférable, des groupes alkyle C1-C6.

**4.** OLED contenant des oligomères construits à partir
d'au moins un complexe métallique chargé positivement et
d'au moins un complexe métallique chargé négativement,
où les complexes métalliques présentent

$$\text{la formule (I) } K_1 = [L1L2L3L4M1]^{n+}$$

et

$$\text{la formule (II) } K_2 = [L5L6L7L8M2]^{n-},$$

dans lesquelles :

M1 et M2 représentent une centre métal choisi parmi Ir(I), Rh(I), Pt(II), Pd(II) et Au(III), où M1 et M2 représentent des centres métal différents, et
L1 - L4 et L5 - L8 représentent chacun un ligand neutre ou chargé, où deux de L1 - L4 et L5 - L8 ou plus peuvent également être liés l'un à l'autre ou les uns aux autres, et où
n = 1 ou 2.

**5.** OLED selon la revendication 4, **caractérisée en ce qu'**un centre métal choisi parmi Ir, Rh, Pt, Pd et Au est présent dans le composé selon une proportion de 10 à 90%, et au moins un métal choisi parmi Ir, Rh, Pt, Pd et Au, lequel est différent du premier métal, est présent selon une proportion de 10 à 90%.

**6.** OLED selon la revendication 4 ou 5, **caractérisée en ce qu'**elle comporte au moins trois ions de centre métal différents choisis parmi Ir, Rh, Pt, Pd et Au.

**7.** Oligomère construit à partir d'au moins un sel à deux complexes, dans lequel le sel à deux complexes présente la formule (IV) :

$$[L1L2L3L4M1]^{n+}_{1-x}[L1L2L3L4M2]^{n+}_{x}[L5L6L7L8M1]^{n-}$$

formule (IV)

dans laquelle :

$0{,}00001 \leq x \leq 0{,}99999$ et
de façon préférable M1 = Pd(II) et M2 = Pt(II).

**8.** Procédé pour la production d'une OLED selon une ou plusieurs des revendications 1 à 6, dans lequel des sels de complexes métalliques des formules (I) et (II) mentionnées dans la revendication 1 sont appliqués sous la forme d'une dispersion ou dans lequel des composants de la formule (I) sont introduits sous la forme d'une solution et des composants de la formule (II) sont introduits par diffusion.

**9.** Utilisation d'oligomères selon la revendication 7 dans une OLED.

**Abbildung 1**

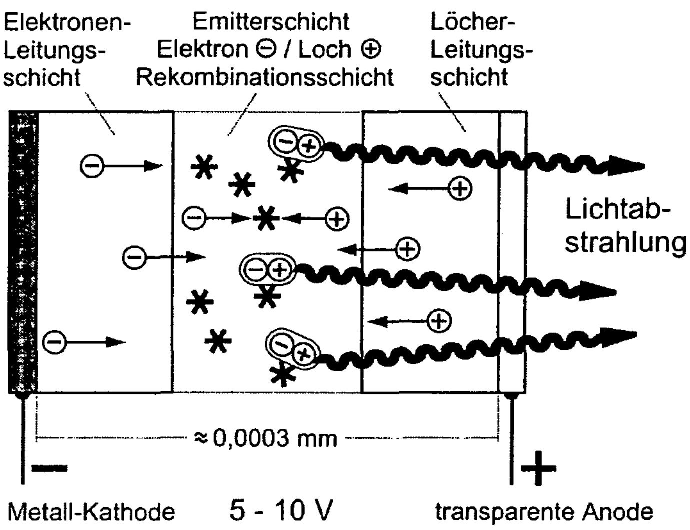


Schematische und vereinfachte Darstellung zur Funktionsweise einer OLED. Die aufgebrachten Schichten sind z. B. ca. 300 nm dick.

Abbildung 2

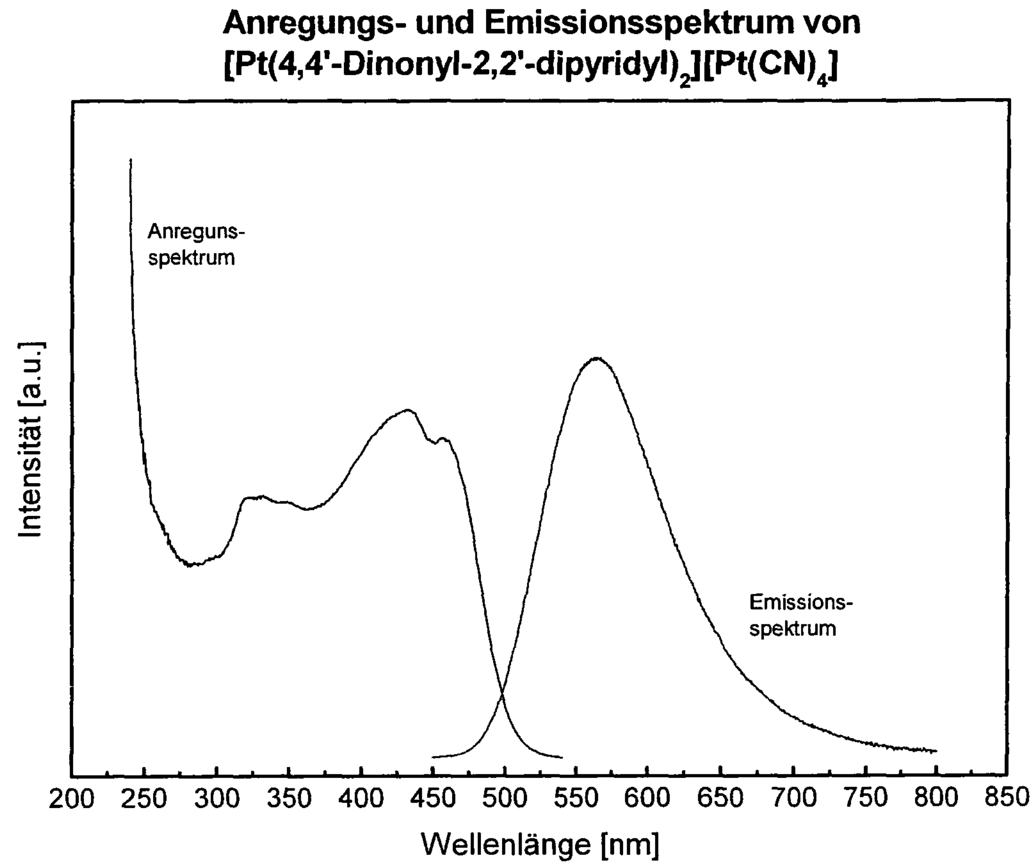


Anregungs- und Emissionsspektrum von [Pt(4,4'-Dinonyl-2,2'-dipyridyl)$_2$][Pt(CN)$_4$] (T = 300 K, $\lambda_{exc.}$ = 365nm, $\lambda_{det.}$ = 563nm).

## Abbildung 3

| | |
|---|---|
| 7 | Kathode, Al: 60 nm |
| 6 | Zwischenschicht CsF: 0,8 nm |
| 5 | ETL, $Alq_3$: 40 nm |
| 4 | Emitter Layer: 30 bis 100 nm |
| 3 | HTL, PEDOT: PSS: 50 nm |
| 2 | Anode, ITO: 40 nm |
| 1 | Trägermaterial, Glas |

Beispiel für ein OLED-Device, in der die erfindungsgemäße Emitterschicht nass-chemisch aufgetragen wird. Die Schichtdickenangaben gelten als Beispielwerte.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2004017043 A2, M. E. Thompson, P. I. Djurovich, J. Li
- WO 2004016711 A1, M. E. Thompson, P. I. Djurovich, R. Kwong
- WO 03095587 A1, A. Tsuboyama, S. Okada, T. Takiguchi, K. Ueno, S. Igawa, J. Kamatani, M. Furugori, H. Iwawaki
- US 20030205707 A1, C.-M. Che
- US 20020179885 A1, C.-M. Che, W. Lu, M. C.-W. Chan
- US 2003186080 A1, J. Kamatani, S. Okada, A. Tsuboyama, T. Takiguchi, S. Igawa
- DE 10350606 A1, P. Stößel, I. Bach, A. Büsing
- DE 10338550 A1, M. Bold, C. Lennartz, M. Egen, H.-W. Schmidt, M. Thelakkat, M. Bäte, C. Neuber, W. Kowalsky, C. Schildknecht
- DE 10358665 A1, C. Lennartz, A. Vogler, V. Pawlowski
- US 2006989273 B2, B. Hsieh, T. P. S. Thoms, J. P. Chen
- WO 2006003000 A1, N. Schulte, S. Heun, I. Bach, P. Stoessel, K. Treacher
- WO 2006032449 A1, A. Vogler, V. Pawlowski, H.-W. Schmidt, M. Thelakkat
- WO 2006028546 A1, T. K. Hatwar, J. P. Spindler, R. H. Young
- WO 05011013 A
- WO 04013080 A
- WO 04093207 A
- WO 06005627 A
- DE 102008033943
- WO 05039246 A
- US 20050069729 A
- JP 2004288381 A
- EP 1205527 A
- WO 08086851 A
- WO 07063754 A
- WO 08056746 A
- EP 1617710 A
- EP 1617711 A
- EP 1731584 A
- JP 2005347160 A
- WO 07137725 A
- WO 05111172 A
- WO 06117052 A
- DE 102008036982
- EP 652273 A
- WO 09062578 A
- DE 102008056688
- DE 102009022858
- DE 102009023155
- DE 102009031021
- WO 2004037887 A2


### In der Beschreibung aufgeführte Nicht-Patentliteratur


- **C. ADACHI ; M.A. BALDO ; S.R. FORREST ; S. LAMANSKY ; M.E. THOMPSON ; R.C. KWONG.** *Appl. Phys. Lett.,* 2001, vol. 78, 1622
- **X. YANG ; D.C. MÜLLER ; D. NEHER ; K. MEERHOLZ.** *Adv. Mater.,* 2006, vol. 18, 948
- Organic light-emitting devices - A survey. AIP Press, Springer, 2004
- **H. YERSIN.** Top. Curr. Chem. 2004, vol. 241, 1
- Highly Efficient OLEDs with Phosphorescent Materials. Wiley-VCH, 2008
- **Z. H. KAFAFI.** Organic Electroluminescence. Taylor & Francis, 2005
- **H. YERSIN.** *Top. Curr. Chem.,* 2004, vol. 241, 1
- **D. M. KOLLER et al.** *Nature Photonics,* 2008, 1-4
- **A. BOIXASSE ; J. PONS ; X. SOLANS ; M. FONT-BARDIA.** *J. Ros, Inorg. Chim. Acta,* 2004, vol. 357, 827